# EUROPÄISCHE PATENTSCHRIFT

(11) **EP 4 442 433 B1**
(45) Veröffentlichungstag und Bekanntmachung des Hinweises auf die Patenterteilung: **04.11.2026**
(21) Anmeldenummer: 24166971.2
(22) Anmeldetag: 27.03.2024
(51) Int. Cl.: B29C 63/00, B29C 63/02, B29C 63/22, B29C 65/14, B29C 65/48, B29C 65/52, B29C 65/78, B29L 31/00, B29L 31/34

(54) **VERFAHREN ZUR HERSTELLUNG EINES BAUTEILS, VORRICHTUNG ZUR HERSTELLUNG EINES BAUTEILS**
METHOD FOR PRODUCING A COMPONENT, DEVICE FOR PRODUCING A COMPONENT
PROCÉDÉ DE FABRICATION D'UN COMPOSANT, DISPOSITIF DE FABRICATION D'UN COMPOSANT

(30) Priorität: 06.04.2023 DE 102023108832
(43) Veröffentlichungstag der Anmeldung: 09.10.2024
(73) Patentinhaber: LEONHARD KURZ Stiftung & Co. KG, 90763 Fürth (DE); PolyIC GmbH & Co. KG, 90763 Fürth (DE)
(72) Erfinder: Clemens, Wolfgang, 90763 Fürth (DE); Süß, Christoph, 90763 Fürth (DE); Popp, Matthias, 90763 Fürth (DE); Hahn, Martin, 90763 Fürth (DE)
(74) Vertreter: Zinsinger, Norbert

(56) Entgegenhaltungen:
- EP-A1- 2 487 670
- EP-A2- 1 426 168
- US-A1- 2012 325 402
- US-A1- 2013 064 967

## Beschreibung

Die Erfindung betrifft ein Verfahren zur Herstellung eines Bauteils und eine Vorrichtung zur Herstellung eines Bauteils.

Es ist bekannt, zur Integration von Funktionslabeln wie Touchsensoren, in Bauteilen Labels mit Funktionsschichten, welche derartige Funktionen bereitstellen, mittels mechanischer Integration, beispielsweise Klemmen, an bzw. in einem Bauteil-Träger zu befestigen. Eine weitere Methode zur Integration solcher Funktionen ist ein Laminieren des Labels manuell oder teilautomatisiert über einen PSA (pressure sensitive adhesive) oder einen OCA (optical clear adhesive) auf den Bauteil-Träger. Es ist auch bekannt, solche Labels durch Einspritzen an oder in einer den Bauteil-Träger ausbildende Kunststoffspritzgussmasse zu integrieren. Eine weitere Methode besteht darin, das Label mit einem beheizten Stempel auf einen Bauteil-Träger aufzuprägen, wobei zur Verbindung von Label und Bauteil-Träger durch die Hitze des Stempels ein thermoplastischer Kleber aktiviert wird. Für flache und ebene Glasscheiben ist ferner das sogenannte Optical Bonding bekannt, wobei ein optischer Kleber (in diesen Fällen meist als Optical Clear Resin (OCR) bezeichnet) zwischen zwei flache Glasscheiben oder eine flache Glasscheibe und ein flaches Substrat gebracht wird, um diese zu verbinden.

Mittels Optical Bonding hergestellte Bauteile sind aufgrund der Bedingung, dass es sich um flache Glasscheiben bzw. Substrate handelt, jedoch in der Gestaltungsfreiheit stark eingeschränkt. Eine, wie eingangs beschriebene, mechanische Integration mittels Klemmen des Labels weist ebenfalls reduzierte Möglichkeiten für komplexe Bauweisen oder kompakte Bauweisen auf und eine automatisierte Fertigung ist dabei schwer umsetzbar. Bei mechanischen Verbindungen treten zudem häufig Schwachstellen aufgrund von Spalten zwischen den nicht stoffschlüssig verbundenen Teilen sowie aufgrund von entsprechenden Relativbewegungen und Lagetoleranzen auf. Auch bei einem manuellen oder teilautomatisierten Laminieren können hohe Lagetoleranzen auftreten und es ist, insbesondere bei komplexen Geometrien, ein höherer Automatisierungsgrad schwer zu erreichen. Bauteile mit Labels, die durch Einspritzen in bzw. an einer Kunststoffmasse oder durch Aufprägen mittels beheizter Stempel versehen sind, sind aufgrund von hierbei benötigten hohen Drücke und hohen Temperaturen, die die Bauteile belasten und beispielsweise mechanisches Verbiegen oder thermischen Verzug herbeiführen können, in ihrer Gestaltungsfreiheit eingeschränkt. In dem Label integrierte Funktionen, wie Sensoren, werden in solchen Herstellungsverfahren zudem häufig beschädigt. Zudem sind auch ggf. zusätzlich in dem Label vorgesehene Dekorschichten in der Gestaltungsfreiheit eingeschränkt und können durch die hohen Drücke und Temperaturen beschädigt werden. Ferner können bei erhöhten Temperaturen Ausgasungen aus den Kunststoffmaterialien auftreten und an Grenzflächen zu einer Blasenbildung führen. An der Grenzfläche von Label und Bauteilträger können außerdem aufgrund der verwendeten hochviskosen oder thermoplastischen Kleberschichten schon kleine Störpartikel zu relativ großen Hohlräumen führen, welche insbesondere die Stabilität und das optische Erscheinungsbild des Bauteils beeinträchtigen. In derartigen Herstellungsverfahren integrierte Label weisen daher oft Mängel, wie Falten, Blasen, Verquetschungen von Leiterbahnen oder Ähnliches auf.

Das Dokument EP2487670A1 bezieht sich auf eine Verbindungsvorrichtung zum Einfüllen eines flüssigen Materials in einen Spalt zwischen plattenförmigen Elementen zum Verbinden in situ. Insbesondere bezieht es sich auf eine Verbindungsvorrichtung zum Einfüllen eines photo-härtbaren flüssigen Harzmaterials in einen Spalt zwischen zwei plattenförmigen Elementen, wie beispielsweise einem Bildanzeigefeld und einem transparenten Schutzfeld, um eine plattenförmige Baugruppe herzustellen.

Das Dokument EP1426168A2 betrifft eine Vorrichtung zum Übertragen einer Beschichtung auf eine Oberfläche eines Linsenhalbzeugs, und offenbart die Aufbringung der Beschichtung auf die Oberfläche eines flexiblen Formteils, wobei Abstützelemente/ Trägerelemente dann relativ zueinander bewegt werden, so dass die Beschichtung mit Klebstoff auf der Oberfläche des Linsenhalbzeugs in Kontakt kommt und diesen verteilt.

Das Dokument US2013064967A1 betrifft die Herstellung von Leiterplatten und insbesondere die Steuerung einer Grenze von Flüssigklebstoff während einer Laminierung.

Das Dokument US2012325402A1 betrifft Verfahren zur Herstellung einer Display-Anordnung mit einem hitzeaktivierten optisch klaren Klebstoff zum Verbinden von Displaypanels.

Es ist somit Aufgabe der vorliegenden Erfindung ein verbessertes Verfahren sowie eine verbesserte Vorrichtung zur Herstellung eines Bauteils anzugeben, welche insbesondere ein automatisiertes Verfahren, vorzugsweise auch für komplexe Bauteilgeometrien bzw. Trägergeometrien, ermöglichen.

Die Aufgabe wird gelöst mittels eines Verfahrens nach Anspruch 1 sowie mittels einer Vorrichtung nach Anspruch 18.

Die Aufgabe wird gelöst mittels eines Verfahrens zur Herstellung eines Bauteils, insbesondere eines Verkleidungsbauteils und/oder eines Bedienelements und/oder eines Anzeigeelements, vorzugsweise für einen Fahrzeuginnenraum. Es ist auch möglich, dass das Bauteil in anderen Anwendungsgebieten verwendet wird. Beispielsweise ist es möglich, dass es sich um ein Bauteil, insbesondere Verkleidungsbauteil oder Bedienelement oder Anzeigeelement, vorzugsweise für ein Haushaltsgerät (weiße Ware), Consumer Elektronik-Gerät oder um ein Bauteil handelt, das Bedienelemente und/oder Dekorelemente eines der genannten oder eines sonstigen Geräts bereitstellt. Das Verfahren wird mittels einer Vorrichtung mit einem Label-Aufnehmer, einem Träger-Aufnehmer sowie einer Klebstoffausgabe-Einheit durchgeführt wird. Bei dem Verfahren werden zumindest folgende Schritte durchgeführt, vorzugsweise in der angegebenen Reihenfolge der Schritte oder vorzugsweise mit zwei oder mehreren der Schritte in der angegebenen Reihenfolge:
a1) Bereitstellen eines Labels mit einem flexiblen Schichtaufbau, wobei das Label zumindest eine Trägerschicht aufweist sowie eine weitere Schicht und/oder ein oder mehrere elektrische und/oder elektronische und/oder optische und/oder optoelektronische Bauelemente aufweist;
a2) Aufnahme des Labels mit dem Label-Aufnehmer;
b1) Bereitstellen eines Trägers;
b2) Aufnahme des Trägers mittels des Träger-Aufnehmers;
c) Aufbringen eines fließfähigen Klebstoffs mittels der Klebstoffausgabe-Einheit in ein oder mehreren ersten definierten Formen auf entweder das mittels des Label-Aufnehmers gehaltene Label oder den mittels des Träger-Aufnehmers gehaltenen Träger;
d) Aufeinanderlegen von Label und Träger mittels einer definierten Relativbewegung von Label-Aufnehmer und Träger-Aufnehmer, derart dass der Klebstoff zwischen Label und Träger angeordnet wird und zwischen Label und Träger ein oder mehrere Kleberschichten in ein oder mehreren zweiten definierten Formen erhalten werden;
e) zumindest teilweises Härten und/oder zumindest teilweises Vernetzen der ein oder mehreren Kleberschichten.

Die Aufgabe wird weiter gelöst durch eine Vorrichtung zur Durchführung des erfindungsgemäßen Verfahrens zur Herstellung eines Bauteils. Die Vorrichtung umfasst:
- einen Label-Aufnehmer zur Aufnahme eines Labels mit einem flexiblen Schichtaufbau, wobei das Label zumindest eine Trägerschicht aufweist und eine weitere Schicht aufweist und/oder ein oder mehrere elektrische und/oder elektronische und/oder optische und/oder optoelektronische Bauelemente aufweist;
- einen Träger-Aufnehmer zur Aufnahme eines Trägers;
- eine Klebstoffausgabe-Einheit zum Aufbringen eines fließfähigen Klebstoffs mittels der Klebstoffausgabe-Einheit in ein oder mehreren ersten definierten Formen auf entweder das Label oder auf den Träger.

Die Vorrichtung ist dabei derart konfiguriert, dass ein Aufeinanderlegen von Label und Träger mittels einer definierten Relativbewegung von Label-Aufnehmer und Träger-Aufnehmer mit einer Anordnung des Klebstoffs zwischen Label und Träger durchführbar ist und/oder durchgeführt wird und zwischen Label und Träger ein oder mehrere Kleberschichten in ein oder mehreren zweiten definierten Formen erhältlich sind.

Es ist möglich, dass das Bauteil, insbesondere Verkleidungsbauteil und/oder Bedienelement und/oder Anzeigeelement, hergestellt mittels des erfindungsgemäßen Verfahrens und/oder der erfindungsgemäßen Vorrichtung, umfasst:
ein Label mit zumindest einer Trägerschicht sowie mit einer weiteren Schicht und/oder ein oder mehreren elektrischen und/oder elektronischen und/oder optischen und/oder optoelektronischen Bauelementen;
einen Träger;
sowie ein oder mehrere Kleberschichten, welche zwischen dem Label und dem Träger angeordnet sind, insbesondere wobei die ein oder mehreren Kleberschichten als vorzugsweise fließfähiger Klebstoff aufgebracht und vorzugsweise mittels einer definierten Relativbewegung von Label und Träger verdrängt und anschließend bevorzugt ausgehärtet und vernetzt sind.

Das Verfahren ist insbesondere computerimplementiert und/oder die Vorrichtung zur Durchführung des computerimplementierten Verfahrens konfiguriert.

Hierdurch wird insbesondere erreicht, dass flexible Label auf Oberflächen von insbesondere komplexen Trägern, vorzugsweise von Kunststoff- oder Glasträgern, in einem bevorzugt automatisierten oder automatisierbaren Prozess so appliziert werden können, dass vorteilhafterweise Verbiegungen, Verzug und/oder optische Beeinflussungen aufgrund mechanischer Beanspruchungen, Druckbelastungen und Temperaturbelastungen vermieden werden. Vorteilhafterweise ist es möglich, ein automatisiertes Verfahren durchzuführen und/oder eine Vorrichtung zur Durchführung eines automatisierten Verfahrens einzusetzen, wobei insbesondere zumindest das Aufeinanderlegen von Label und Träger automatisiert durchführbar ist oder automatisiert durchgeführt wird. Mittels des möglichen hohen Automatisierungsgrads oder auch einem vollautomatisierten Verfahren können dabei insbesondere kurze Durchlaufzeiten zur Herstellung der Bauteile, eine höhere Prozesssicherheit mit wenig Ausschussware und Ressourcen-Einsparungen erreicht werden. Hierbei können, insbesondere bei komplexen Geometrien des Trägers, die ein oder mehreren ersten definierten Formen des Klebstoffs und die definierte Relativbewegung von Label und Träger gezielt aufeinander abgestimmt werden, so dass sich daraus die ein oder mehreren Kleberschichten ergeben. Vorzugsweise werden also alle Schritte des Verfahrens automatisiert durchgeführt und/oder sind automatisiert mittels der Vorrichtung durchführbar, wobei die ein oder mehreren definierten ersten Formen und die Relativbewegung von Label und Träger aufeinander abgestimmt sind. So kann mittels des flexiblen Labels beispielsweise eine komplexe Form, insbesondere ein gekrümmter Träger mit einer sogenannten "2,5D"-Form, beschichtet werden. Da hierbei der Träger zusätzlich auch 3D-Formen, beispielsweise aufgrund von Rahmen oder Schnappern oder sonstigen Strukturen auf der Oberfläche aufweisen kann, die eine konventionelle Integration, wie beim Optical Bonding verhindern würden, wird eine besonders hohe Gestaltungsfreiheit erreicht.

Überraschenderweise hat sich zudem gezeigt, dass infolge des Aufeinanderlegens von Label und Träger, insbesondere einer dabei stattfindenden Verdrängung des fließfähigen Klebstoffs, vorteilhafterweise Unebenheiten in der Oberfläche des Labels und/oder des Trägers mit Klebstoff ausgefüllt, sowie Luftblasen im Klebstoff geschlossen bzw. weggedrückt werden. Hierzu kann das Aufeinanderlegen von Label und Träger einen ausgeübten Druck auf das Label und den Träger und den dazwischen angeordneten fließfähigen Klebstoff und/oder eine Relativbewegung zwischen Label und Träger und dem dazwischen angeordneten fließfähigen Klebstoff umfassen. Somit können auch enge Krümmungsradien mittels des fließfähigen Klebstoffs besonders tiefgehend ausgefüllt sowie Störpartikel besonders eng umschlossen werden. Gleichzeitig kann mittels der definierten Relativbewegung und der definierten Form des Klebstoffs eine gleichmäßige Verteilung des Klebstoffs zur Ausformung der ein oder mehreren Kleberschichten erreicht werden, ohne dass - beispielsweise bei einem Zusammenfließen von Teilbereichen des Klebstoffs oder aufgrund von Unebenheiten an einer Oberfläche des Labels oder des Trägers - Lufteinschlüsse entstehen. Dabei kann vorteilhafterweise auch ein Herausquetschen des Klebstoffs an den Seiten des Labels reduziert oder vermieden werden, insbesondere so dass eine Härtung mit wenig bis keinem zusätzlichen Reinigungsaufwand erfolgen kann. Mittels der ausbleibenden oder reduzierten Erwärmung wird außerdem der Vorgang vermieden oder eingedämmt, dass beispielsweise für den Träger verwendete Kunststoffe Feuchtigkeit abgeben und Blasen in einer Kleberschicht verursachen. Gleichzeitig wird die Blasenbildung durch Ausgasen weiter verhindert, da die ein oder mehreren Kleberschichten, welche sich bei niedrigen Temperaturen verarbeiten lassen, aufgrund der verwendbaren Materialien und der Beschaffenheit, wie insbesondere einem vernetzten Zustand, als eine Gasbarriere dienen können. Somit können optische, wie auch mechanische Eigenschaften verbessert werden. Ferner können stabile Materialien für den Kleber verwendet werden, so dass beispielsweise der Verbund aus Träger, vernetztem Kleber und Label eine höhere mechanische Stabilität aufweist als beispielsweise ein thermoplastischer Kleber bzw. ein "weicher" Kleber, wie ein selbstklebender OCA (optically clear adhesive).

Unter einem Label ist insbesondere ein im Wesentlichen flächiges Gebilde zu verstehen. Vorzugsweise dient ein Label zur Beschichtung eines Trägers und/oder der Umfang des Labels, vorzugsweise bei Betrachtung senkrecht auf eine von dem Label aufgespannte Ebene, ist bevorzugt bei dem Bereitstellen des Labels bereits vollständig oder überwiegend entsprechend der Formgebung dieser Beschichtung ausgebildet, insbesondere zugeschnitten. Vorzugsweise weist ein Label einen flexiblen Schichtaufbau auf.

Unter einem flexiblen Schichtaufbau ist insbesondere zu verstehen, dass das Label biegbar, vorzugsweise elastisch biegbar, ist. Die Flexibilität kann insbesondere durch den Elastizitätsmodul (E-Modul) bestimmt werden. Der E-Modul ist insbesondere ein Materialkennwert aus der Werkstofftechnik, der bei linear elastischem Verhalten den proportionalen Zusammenhang zwischen Spannung und Dehnung bei der Verformung eines festen Körpers beschreibt. Der E-Modul wird vorzugsweise nach der Norm ISO 527-1:2019-12 (Kunststoffe - Bestimmung der Zugeigenschaften - Teil 1: Allgemeine Grundsätze, Ausgabedatum 2019-12) bestimmt und insbesondere in N/mm² bzw. MPa angegeben. Das Label weist insbesondere E-Modulen in einem Bereich von 500 MPa bis 5000 MPa, vorzugsweise in einem Bereich von 1000 MPa bis 4500 MPa, besonders bevorzugt in einem Bereich von 1500 MPa bis 3000 MPa, auf. Das Label wird insbesondere eher als "zähhartes Material" bezeichnet.

Die E-Modulen liegen vorzugsweise zumindest in Teilbereichen des Labels vor, insbesondere so dass das Label insgesamt flexibel und/oder biegbar ist. Es ist möglich, dass das Label, insbesondere zusätzlich zu dem flexiblen Schichtaufbau, bereichsweise nicht flexibel ist und/oder bereichsweise Bauelemente, wie insbesondere die ein oder mehreren elektrischen und/oder elektronischen und/oder optischen und/oder optoelektronischen Bauelemente, aufweist, welche nicht flexibel und/oder nicht schichtförmig sind, d.h. vorzugsweise höhere E-Modulen aufweisen als die Teilbereiche des Labels mit den vorgenannten E-Modulen.

Begriffe, wie "erste", "zweite" oder "dritte" werden lediglich zur Unterscheidung verwendet. Es können beispielsweise eine erste Schicht und eine zweite Schicht vorhanden sein, aber das Vorhandensein einer ersten Schicht ist nicht Voraussetzung für das Vorhandensein einer zweiten Schicht.

Das Bauteil ist insbesondere ein Verkleidungsbauteil, vorzugsweise ein Kraftfahrzeug-Verkleidungsbauteil, wie beispielsweise ein Fahrzeuginnenverkleidungsteil oder ein Fahrzeugaußenverkleidungsteil. Das Bauteil kann auch beispielsweise ein Bedienelement und/oder ein Dekorelement und/oder ein Anzeigeelement sein, insbesondere im Bereich der Weißen Ware oder anderen Haushaltsgeräten oder auch in Geräten der Konsumgüter- oder Automatisierungstechnik.

Unter Träger ist beispielsweise ein selbsttragender und/oder starrer Körper zu verstehen. Der Träger umfasst oder besteht bevorzugt aus Glas und/oder Kunststoff. Insbesondere weist der Träger bereits vor oder bei dessen Bereitstellung eine Form auf, welche der Träger auch im hergestellten Bauteil aufweist. Die Form des Trägers kann insbesondere dreidimensional sein, vorzugsweise bei dem Schritt b1) und/oder dem Schritt d) und/oder im fertigen Bauteil. Der Träger umfasst oder ist insbesondere eher ein "sprödhartes Material". Insbesondere weist der Träger, vorzugsweise zumindest bereichsweise oder überall, E-Modulen von 5000 MPa oder größer auf. Vorzugsweise wird der Träger bei dem Verfahren oder zumindest beim Aufeinanderlegen von Label und Träger nicht oder im Wesentlichen nicht verformt, insbesondere nicht plastisch verformt. Beispielsweise umfasst der Träger eine Spritzgussmasse. Insbesondere ist oder wird der Träger mittels Spritzgießens hergestellt. Es ist auch möglich, dass der Träger ein oder mehrere Dekorlagen aufweist, die beispielsweise mittels In-Mold Decoration (IMD) oder In-Mold Labeling (IML), insbesondere also während eines Spritzgießprozesses, aufgebracht sind oder werden. Vorzugsweise handelt es sich bei dem Träger um eine Blende, beispielsweise eines Fahrzeuginnenteils.

Der Träger kann auch nicht dekoriert sein oder alternativ dazu mit irgendeiner beliebigen Dekorationsmethode wie zum Beispiel Nasslackieren, Aufdampfen, Chemical Vapor Deposition (CVD), Physical Vapor Deposition (PVD), Foliendekoration, etc. dekoriert sein oder werden. Es ist, insbesondere bei einer bevorzugten Ausführungsform, wobei die weitere Schicht eine elektrisch leitfähige Funktionsschicht ist oder umfasst und/oder das Label bevorzugt einen kapazitiven Touchsensor umfasst, zweckmäßig, dass der Träger und eventuelle Beschichtungen und/oder Dekorationsschichten auf dem Träger nicht elektrisch leitfähig sind. Alternativ oder zusätzlich ist es möglich, dass der Träger ganz oder bereichsweise, insbesondere in Bereichen, welche zur Bedienung vorgesehen sind, transparent oder durchleuchtbar ist. Dies ist insbesondere vorteilhaft bei Bauteilen in Form von Bedienelementen.

Die weitere Schicht ist oder umfasst insbesondere eine elektrisch leitfähige Funktionsschicht. Die elektrisch leitfähige Funktionsschicht ist in dem bereitgestellten Label und/oder dem hergestellten Bauteil vorzugsweise elektrisch kontaktierbar. Die elektrisch leitfähige Funktionsschicht weist vorzugsweise eine elektrische und/oder elektronische und/oder optische und/oder optoelektronische Funktion auf, beispielsweise eine Sensor-Funktion (zum Beispiel für Temperatur, Feuchtigkeit, Druck, elektrische Kapazität, sichtbare und/oder nicht sichtbare elektromagnetische Wellenlängen (zum Beispiel IR, sichtbares Licht und/oder UV), elektrischen Widerstand und/oder Chemikalien), und/oder eine Touchsensor-Funktion, eine Heiz-Funktion, eine Kühl-Funktion und/oder eine Aktuator-Funktion. Bevorzugt ist die Trägerschicht und die elektrisch leitfähige Funktionsschicht von einer Sensorfolie, insbesondere einer Touchsensorfolie, umfasst oder davon gebildet.

Die ein oder mehreren ersten definierten Formen sind oder werden insbesondere durch eine Relativbewegung zwischen Klebstoffausgabe-Einheit und Label und/oder Träger und/oder durch die Ausgabemenge an Klebstoff durch die Klebstoffausgabe-Einheit und/oder durch die Viskosität des Klebstoffs bestimmt. Die ein oder mehreren zweiten definierten Formen sind oder werden insbesondere durch die ein oder mehreren ersten definierten Formen und durch das Aufeinanderlegen von Label und Träger bewirkte Verformung bestimmt. Bevorzugt ist oder wird durch die ein oder mehreren zweiten definierten Formen eine Oberfläche des Trägers, insbesondere zumindest eine ebene Oberfläche und/oder eine 2,5D-Oberfläche des Trägers, beschichtet, vorzugsweise vollflächig und/oder großflächig, beispielsweise bis auf einen definierten Abstand zum Rand der Oberfläche, beschichtet. Eine 2,5D-Oberfläche oder 2,5D-Form ist insbesondere durch eine zylindrische Biegung oder Krümmung gekennzeichnet. Es ist auch möglich, dass der Klebstoff aufgrund einer Bewegung des Label-Aufnehmers, beispielsweise hin zum Träger-Aufnehmer, verformt wird, insbesondere wobei zur Durchführung der definierten Relativbewegung von Label-Aufnehmer und Träger-Aufnehmer diese Verformung berücksichtigt ist oder wird. Die ein oder mehreren zweiten definierten Formen weisen bevorzugt einen Rand auf, der mit einem Rand des Labels überlappt oder einen bestimmten Abstand dazu aufweist. Diese Überlappung kann bereichsweise vorliegen oder vollständig vorliegen und/oder in einem Teilbereich vorliegen, in welchem das Label einen Rand, der im Bauteil mit dem Träger überlappt, aufweist.

Unter verdrängt bzw. verdrängen ist insbesondere zu verstehen, dass der Klebstoff aus einem Bereich, der von den ein oder mehreren ersten definierten Formen gebildet ist oder wird, in weitere Bereiche verdrängt ist oder wird, vorzugsweise wobei in dem Bereich, der von den ein oder mehreren ersten definierten Formen gebildet ist oder wird, ebenfalls Klebstoff verbleibt.

Unter Härten ist insbesondere ein Vernetzen, vorzugsweise Quervernetzen, zu verstehen. Beim Vernetzen, vorzugsweise Quervernetzen, wird insbesondere ein dreidimensionales Netzwerk aus vernetzten Polymerketten gebildet. Beim Quervernetzen werden insbesondere bereits bestehende und/oder zuvor ausbildete Polymerketten vernetzt. Der Klebstoff ist insbesondere dann ausgehärtet, bevorzugt vollständig ausgehärtet, wenn die Viskosität des Klebstoffs bei Raumtemperatur, beispielsweise von 20 °C, größer als 50000 mPa·s, bevorzugt größer als 100000 mPa·s ist. Der Klebstoff mit derartigen Viskositäten ist bevorzugt nicht mehr fließfähig. Unter vollständig ausgehärtet ist zu verstehen, wenn die zu einer Vernetzung fähigen Polymerbestandteile des Klebstoffs zu mehr als 90 % eine Vernetzung aufweisen. Ein vollständig ausgehärteter Klebstoff liegt dann vor, wenn eine vollständige (> 90 %) Vernetzung seiner Polymerbestandteile erfolgt ist. Unter einer Schicht oder Lage wird vorzugsweise ein im Wesentlichen flächiges Gebilde verstanden. Es ist möglich, dass eine Schicht vollflächig oder partiell, insbesondere musterförmig, vorliegt. Eine Schicht kann selbst einschichtig sein oder mehrschichtig sein.

Unter Muster oder musterförmig werden beispielsweise einzeln oder in Kombination Muster aus Punkten und/oder Linien, insbesondere gerade und/oder gekrümmte Linien, Knochenstruktur, T-Form, Y-Form, I-Form, U-Form, Serpentinen, Knotenpunkte, Verzweigungen, fraktale Formen verstanden. Eine teilflächig vorgesehene Schicht kann insbesondere musterförmig vorgesehen sein oder werden. Ein Muster kann auch ein Motiv sein, vorzugsweise einzeln oder in Kombination ausgewählt aus: geometrische Form, Guilloche, Endlosmuster, Bild, Symbol, Logo, Wappen, Portrait, alphanumerische Zeichen, QR-Code, Barcode. Ein Motiv kann als Einzelbild und/oder als Endlosmuster vorliegen.

Das Bereitstellen des Labels kann beispielsweise manuell und/oder auf einer dafür vorgesehenen Aufnahmefläche und/oder mittels einer ersten Zuführvorrichtung, beispielsweise umfassend ein oder mehrere Förderbänder und/oder ein oder mehrere Robotergreifer, erfolgen. Das Bereitstellen der Träger kann beispielsweise manuell und/oder auf einer dafür vorgesehenen Aufnahmefläche und/oder mittels einer zweiten Zuführvorrichtung, beispielsweise umfassend ein oder mehrere Förderbänder und/oder ein oder mehrere Robotergreifer, erfolgen.

Die Reihenfolge der Schritte des Verfahrens kann beliebig gewählt werden. Mehrere Schritte können nacheinander erfolgen und/oder mehrere Schritte des Verfahrens können auch gleichzeitig durchgeführt werden. Schritt a1) wird insbesondere vor Schritt a2) durchgeführt und Schritt b1) wird insbesondere vor Schritt b2) durchgeführt. Schritt c) wird vorzugsweise nach Schritt a2) durchgeführt. Schritt c) und Schritt b2) können zumindest teilweise gleichzeitig durchgeführt werden. Es ist auch möglich, dass Schritt c) vor und/oder nach Schritt b2) durchgeführt wird. Schritt d) wird vorzugsweise nach Schritt c) durchgeführt. Schritt e) wird vorzugsweise nach Schritt d) durchgeführt.

Vorteilhafte Ausgestaltungen der Erfindung sind in den Unteransprüchen bezeichnet.

Es ist möglich, dass aus dem Verfahren, insbesondere aus der definierten Relativbewegung und/oder aus Aushärtungs- und/oder Vernetzungsmechanismen des Klebstoffs, resultierende Drücke und/oder Temperaturen vorliegen, insbesondere ohne dass die Drücke und/oder Temperaturen voreingestellte und/oder gemessene und/oder kontrollierte Werte annehmen. Dabei sind die resultierenden Drücke und/oder Temperaturen jedoch vorteilhafterweise vergleichsweise gering. Es ist beispielsweise möglich, dass zum Verteilen des Klebstoffs keine Beaufschlagung eines Drucks, insbesondere im Wesentlichen keine Beaufschlagung eines Drucks, oder durch ein bevorzugt geringer Druck von dem Träger und/oder dem Label auf den Klebstoff ausgeübt wird und/oder eine Erwärmung des Klebstoffs, und insbesondere des Trägers und/oder des Labels, infolge einer Bestrahlung des Klebstoffs und/oder einer exothermen Reaktion des Klebstoffs stattfindet.

Es ist auch möglich, dass vorzugsweise beim Aufeinanderlegen von Label und Träger, ein Ausüben eines definierten Drucks und/oder eine definierte Erwärmung von Label, Klebstoff und Träger und/oder eine Einstellung eines definierten Temperaturbereichs von Label, Klebstoff und Träger durchgeführt und/oder mittels der Vorrichtung einstellbar ist.

Durch entsprechende resultierende und/oder definierte Drücke und/oder Temperaturen kann insbesondere die Fließfähigkeit des Klebstoffs ausgenutzt und/oder optimiert werden und es können Schäden oder Verzug durch zu hohe Temperaturen oder zu hohen Druck reduziert werden.

Vorzugsweise wird bei dem Verfahren, insbesondere dem Aufeinanderlegen von Label und Träger, von dem Träger, dem Label und/oder dem Klebstoff eine Temperatur nicht überschritten, die einer Glasübergangstemperatur eines Materials des Trägers, des Labels und/oder des Klebstoffs entspricht. Eine Erwärmung des Trägers und/oder des Labels oder Teilbereichen davon findet zweckmäßigerweise auf Temperaturen statt, die niedriger sind als die Glasübergangstemperaturen der verwendeten Materialien. Bei PET-basierten Folien, die insbesondere als Trägerschicht des Labels dienen, findet die Erwärmung beispielsweise auf weniger als 80°C statt bzw. es entsteht bei dem Verfahren keine Temperatur von 80 °C oder mehr. Es ist also möglich, dass bei dem Verfahren, insbesondere dem Aufeinanderlegen von Label und Träger, das Label, der Klebstoff, die ein oder mehreren Kleberschichten und/oder der Träger mit einer Temperatur von weniger als 80 °C, vorzugsweise von maximal 60 °C, verarbeitet werden. Es ist auch denkbar, dass, insbesondere bei dem Schritt d), ein Kühlen von Träger und/oder Label durchgeführt wird, beispielsweise wenn der Klebstoff selbsthärtend mit einer exothermen Reaktion ist. Geringe Temperaturen sind insbesondere vorteilhaft, da so eine negative Beeinflussung von Label und/oder Träger, z.B. durch ein zu starkes Erweichen des Labels oder ein Verbiegen des Trägers, vermieden werden kann.

Bevorzugt werden für maximal 30 s, vorzugsweise maximal 15 s, das Label, der Klebstoff, die ein oder mehreren Kleberschichten und/oder der Träger auf eine Temperatur von maximal 100 °C, vorzugsweise maximal 80 °C, erwärmt. Bei dem Verfahren, insbesondere bei dem Aufeinanderlegen von Label und Träger, überschreiten das Label, der Klebstoff, die ein oder mehreren Kleberschichten und/oder der Träger eine Temperatur von 80 °C, vorzugsweise von 60 °C, bevorzugt nicht oder insbesondere für maximal 60 s, vorzugsweise maximal 30 s, bevorzugt maximal 15 s.

Vorzugsweise wird das Verfahren derart durchgeführt und/oder die Vorrichtung ist derart ausgestaltet, dass, insbesondere nach Durchführung der definierten Relativbewegung, ein Halten des Label-Aufnehmers und/oder des Träger-Aufnehmers mit einer definierten Relativposition von Label-Aufnehmer und Träger-Aufnehmer durchgeführt wird bzw. durchführbar ist. Das Halten ist bevorzugt ein Teilschritt von Schritt d), d.h. des Aufeinanderlegens von Label und Träger. Vorzugsweise wird die definierte Relativbewegung zum Verteilen des Klebstoffs durchgeführt, insbesondere wobei ein Druck auf den Klebstoff ausgeübt wird oder auf den Klebstoff wirkt, der ausreichend zum Verteilen ist, ohne dass Klebstoff an einem Rand zwischen Label und Träger heraustritt. Das Halten wird insbesondere zum zumindest teilweisen Härten und/oder Vernetzen des verteilten Klebstoffs durchgeführt. Das Halten wird insbesondere durchgeführt bis das Label an dem Träger fixiert ist, beispielsweise durch ein ausreichendes Härten und/oder Vernetzen mittels Schritt e). Das Halten erfolgt insbesondere für maximal 240 s, beispielsweise falls der Klebstoff selbsthärtend ist, vorzugsweise für weniger als 60 s, bevorzugt für weniger als 10 s, beispielsweise falls der Klebstoff strahlenhärtend, insbesondere UV-strahlenhärtend und/oder durch sichtbares Licht härtend, ist.

Insbesondere wird das Verfahren derart durchgeführt und/oder die Vorrichtung ist derart ausgestaltet, dass die definierte Relativbewegung und/oder das Halten durchgeführt wird, wobei auf das Label, den Klebstoff, die ein oder mehreren Kleberschichten und/oder den Träger ein Druck ausgeübt wird oder wirkt, welcher 200 N/cm² nicht übersteigt und/oder in einem Bereich von 0,1 N/cm² bis 200 N/cm² liegt, und/oder ohne dass auf das Label, den Klebstoff, die ein oder mehreren Kleberschichten und/oder den Träger ein Druck, welcher 200 N/cm² oder mehr beträgt, ausgeübt wird. Es ist alternativ oder zusätzlich möglich, dass auf das Label, den Klebstoff, die ein oder mehreren Kleberschichten und/oder den Träger ein Druck ausgeübt wird oder wirkt, welcher 10 N/cm² nicht oder für maximal 10 s übersteigt, insbesondere bei dem Aufeinanderlegen von Label und Träger.

Der Label-Aufnehmer weist vorzugsweise eine Aufnahmefläche und/oder eine Aufnahmeform zur Aufnahme des Labels auf. Vorzugsweise ist die Aufnahmeform zumindest bereichsweise gekrümmt und/oder eine an das Label, und insbesondere an eine auf dem Träger auszubildende Form, bevorzugt gekrümmte Form, des Labels, angepasste Passform. Die Form der Aufnahmeform und/oder der Aufnahmefläche ist vorzugsweise angepasst an die Form des Labels, indem der Label-Aufnehmer zumindest eine Vertiefung mit zumindest einem Rand aufweist, welcher die zumindest eine Vertiefung begrenzt. Der Rand dient insbesondere zur Positionierung des Labels auf dem Label-Aufnehmer.

Vorzugsweise ist das Label, insbesondere in dem Schritt a1) und/oder vor dem Schritt a2) flach, aber flexibel. Bevorzugt ist die Aufnahmefläche des Label-Aufnehmers zumindest bereichsweise gekrümmt und das Label wird in dem Schritt a2), insbesondere über Vakuum oder mechanische Halter, gezwungen, die zumindest bereichsweise gekrümmte Form der Aufnahmefläche anzunehmen.

Vorzugsweise weist der Label-Aufnehmer und/oder der Träger-Aufnehmer Mittel zum Halten des Labels und/oder des Trägers auf, insbesondere einzeln oder in Kombination ausgewählt aus: Mittel zur Erzeugung eines Vakuums, insbesondere zum Ansaugen des Labels und/oder des Trägers, eine Klemmvorrichtung, einen Abstandshalter, eine Vertiefung, eine Verschraubung, eine Magnethalterung, eine Vakuumhalterung.

Das Label wird durch die Aufnahme mittels des Label-Aufnehmers gekrümmt. Erfindungsgemäß weist zumindest ein Krümmungsbereich des Label-Aufnehmers, welcher nach Aufnahme des Labels in Kontakt mit dem Label steht, eine gekrümmte Oberfläche auf. Vorzugsweise weist der Träger zumindest in einem Krümmungsbereich eine gekrümmte Träger-Oberfläche auf, insbesondere wobei bei dem Aufeinanderlegen von Label und Träger, bevorzugt ein Krümmungsbereich des Labels auf den Krümmungsbereich des Trägers aufgebracht wird. Vorzugsweise weist der Krümmungsbereich des Label-Aufnehmers eine dem Krümmungsbereich des Trägers entsprechende gekrümmte Oberfläche auf, insbesondere derart, dass bei der Aufnahme des Labels mit dem Label-Aufnehmer das Label derart gekrümmt ist oder wird, dass in dem Krümmungsbereich des Labels eine der gekrümmten Träger-Oberfläche entsprechende gekrümmte Label-Oberfläche, bevorzugt komplementäre gekrümmte Label-Oberfläche, gebildet ist oder wird. Es ist auch möglich, dass das Label beispielsweise eine gekrümmte Oberfläche aufweist, die auf eine Gesamtheit von Krümmungen, Vertiefungen und/oder Erhebungen des Trägers angepasst ist oder wird. So ist es beispielsweise auch möglich, dass ein oder mehrere Erhebungen und/oder Vertiefungen, die in dem Träger vorliegen, von durch eine Schichtdickenvariation der ein oder mehreren Kleberschichten ausgefüllt sind oder werden. Es ist insbesondere möglich, dass in dem Bauteil der Träger auf einer dem Label zugewandten Oberfläche eine gekrümmte Oberfläche und/oder Erhebungen und/oder Vertiefungen aufweist, insbesondere wobei die ein oder mehreren Kleberschichten eine der gekrümmten Oberfläche und/oder den Erhebungen und/oder den Vertiefungen folgende Schichtdickenvariation aufweisen.

Eine gekrümmte Oberfläche, insbesondere die Label-Oberfläche, die Träger-Oberfläche und/oder die gekrümmte Oberfläche des Label-Aufnehmers, weist insbesondere ein oder mehrere der folgenden Eigenschaften auf oder wird von diesen gebildet: einem minimalen Krümmungsradius von 10 mm, vorzugsweise von 20 mm, bevorzugt von 50 mm, besonders bevorzugt von 200 mm, ein oder mehrere Vertiefungen, ein oder mehrere Erhöhungen, einen über die gekrümmte Oberfläche variierender Krümmungsradius.

Es ist auch möglich, dass der Träger, vorzugsweise innerhalb und/oder außerhalb der gekrümmten Oberfläche des Trägers, bevorzugt innerhalb und/oder außerhalb des Krümmungsbereichs des Trägers, ein oder mehrere Schnapper, ein oder mehrere Rahmen und/oder ein oder mehrere Erhebungen und/oder Vertiefungen, vorzugsweise ein oder mehrere zusätzliche Erhebungen und/oder Vertiefungen, aufweist, welche insbesondere eine Höhe von höchstens 100 mm, bevorzugt von höchstens 50 mm, weiter bevorzugt von höchstens 20 mm, aufweisen, und/oder ein oder mehrere Ausnehmungen aufweist.

Zudem ist es möglich, dass alternativ oder zusätzlich zu dem Krümmungsbereich des Trägers, der Träger zumindest einen ebenen Bereich aufweist. Alternativ oder zusätzlich zu dem Krümmungsbereich des Labels kann das Label insbesondere zumindest einen ebenen Bereich aufweisen, mit welchem das Label, insbesondere bei dem Aufeinanderlegen von Label und Träger, auf den ebenen Bereich des Trägers aufgebracht wird. Insbesondere ist es auch möglich, dass zumindest ein ebener Bereich des Label-Aufnehmers nach Aufnahme des Labels in Kontakt mit dem Label steht, vorzugsweise wobei der zumindest eine ebene Bereich des Label-Aufnehmers und/oder des Labels dem zumindest einen ebenen Bereich des Trägers zugeordnet ist oder wird. Unter "ebener Bereich" ist hierbei insbesondere zu verstehen, dass innerhalb des ebenen Bereichs eine ebene Oberfläche, insbesondere ohne Krümmung, vorliegt. Es ist alternativ oder zusätzlich möglich, dass die Oberfläche des Trägers eine leicht gekrümmte Oberfläche aufweist, welche einen Radius in einer Ebene aufweist, der größer 100 mm ist. Es ist auch möglich, dass der Träger ein oder mehrere Bereiche aufweist, welche gegenüber der ebenen Oberfläche und/oder der leicht gekrümmten Oberfläche erhöht und/oder vertieft sind.

Unter Bereich wird insbesondere jeweils ein durch eine definierte Fläche vorgegebener Bereich verstanden, der bei Betrachtung in Draufsicht auf das Label, den Träger, den Klebstoff, die ein oder mehreren Kleberschichten, den Label-Aufnehmer und/oder den Träger-Aufnehmer, und/oder bei einer Betrachtung senkrecht auf eine von dem Label, dem Träger, dem Klebstoff, die ein oder mehreren Kleberschichten, dem Label-Aufnehmer und/oder dem Träger-Aufnehmer ausgebildeten Ebene eingenommen wird.

Die definierte Relativbewegung von Label-Aufnehmer und Träger-Aufnehmer ist insbesondere auf die Oberfläche, vorzugsweise die gekrümmte Oberfläche des Labels und/oder des Trägers, sowie bevorzugt die ein oder mehreren definierten Formen des Klebstoffs, abgestimmt. Insbesondere wird dabei die gekrümmte Oberfläche des Labels auf der gekrümmten Oberfläche des Trägers abgerollt. Vorzugsweise wird die definierte Relativbewegung von Label-Aufnehmer und Träger-Aufnehmer derart ausgeführt und/oder ist der Label-Aufnehmer derart ausgestaltet, dass bei der definierten Relativbewegung keine Verbiegung und/oder keine Krümmung des Labels stattfindet.

Es ist auch möglich, dass nach dem Aufbringen des Klebstoffs mittels der Klebstoffausgabe-Einheit und vor dem Aufeinanderlegen von Label und Träger maximal 0,5 s bis 60 s, bevorzugt 0,5 s bis 20 s vergehen (s = Sekunden). Der Label-Aufnehmer, der Träger-Aufnehmer und die Klebstoffausgabe-Einheit weisen untereinander bevorzugt einen maximalen Abstand von 2 m auf. Hiermit kann vorteilhafterweise ein ungewolltes Fließen des Klebstoffs vermieden werden, indem ein geringer Zeitraum für ungewolltes Fließen des Klebstoffs vorliegt und ausreichend Zeit für eine nicht zu starke Beschleunigung des Klebstoffs beim Positionieren für das Aufeinanderlegen von Label und Träger gewährleistet ist. Durch ein automatisiertes Verfahren kann der Zeitraum zuverlässig bestimmt und eingehalten werden.

Es ist bevorzugt, dass der Klebstoff und/oder die ein oder mehreren Kleberschichten einen Kaltkleber umfassen oder daraus bestehen. Insbesondere ist der Klebstoff ein optischer Kleber oder umfasst diesen und/oder die ein oder mehreren Kleberschichten sind oder umfassen ein oder mehrere optische Kleber. Unter einem optischen Kleber wird insbesondere verstanden, dass, insbesondere im ausgehärteten Zustand, der Transmissionsgrad mindestens 50 %, bevorzugt mindestens 80 % beträgt und/oder der optische Kleber glasklar transparent ist und/oder der Klebstoff farblos ist und/oder der Kleber frei von ein oder mehreren der folgenden Materialien ist: Füllstoffe, Farbstoffen, Farbpigmenten.

Das Aufbringen des Klebstoffs erfolgt insbesondere teilflächig, vorzugsweise musterförmig, oder vollflächig auf eine Oberfläche, insbesondere zumindest im Krümmungsbereich, des Labels und/oder auf eine Oberfläche, insbesondere zumindest im Krümmungsbereich, des Trägers. Das Aufbringen des Klebstoffs erfolgt vorzugsweise durch Dispensen, insbesondere mit einer Volumendosierung des Klebstoffs, oder durch Drucken, insbesondere durch Digitaldruck und/oder Siebdruck. Es ist möglich, dass die Klebstoffausgabe-Einheit von eine Druckvorrichtung, insbesondere eine Digitaldruckvorrichtung und/oder eine Siebdruckvorrichtung und/oder einen Dispenser, umfasst ist oder davon gebildet ist. Die Klebstoffausgabe-Einheit umfasst bevorzugt ein oder mehrere Düsen und/oder Kanäle und/oder Dispenser zur Ausgabe des fließfähigen Klebstoffs. Insbesondere umfasst die Klebstoffausgabe-Einheit ein oder mehrere Druckköpfe, vorzugsweise Inkjet-Druckköpfe. Insbesondere ist mittels Siebdrucks beispielsweise ein vollflächiger und/oder großflächiger Auftrag des Klebstoffs durchführbar oder wird damit durchgeführt.

Es ist möglich, dass der Klebstoff und/oder die ein oder mehreren Kleberschichten härtbar sind, gehärtet sind oder gehärtet werden einzeln oder in Kombination ausgewählt aus: mittels Strahlung, vorzugsweise UV-Strahlung und/oder sichtbares Licht und/oder IR-Strahlung, mittels physikalischer Härtung, mittels chemischer Härtung, mittels Dual Cure. Insbesondere wird das Verfahren zur Herstellung des Bauteils derart ausgestaltet und/oder die Vorrichtung derart konfiguriert, dass der Klebstoff vernetzbar ist oder vernetzt wird und/oder die ein oder mehreren Kleberschichten vernetzbar sind und/oder vernetzt sind oder werden. Es ist insbesondere möglich, dass der Klebstoff und/oder die ein oder mehreren Kleberschichten insbesondere mittels UV-Strahlung und/oder sichtbarem Licht vernetzbar sind, vernetzt sind oder vernetzt werden.

Es ist möglich, dass der Klebstoff beim Aufbringen des Klebstoffs eine Viskosität in einem Bereich von 0,5 mPa·s bis 100000 mPa·s, insbesondere von 1 mPa·s bis 100000 mPa·s, vorzugsweise von 300 mPa·s bis 50.000 mPa·s, bevorzugt von 1000 bis 10.000 mPa·s und/oder von 500 mPa·s bis 2000 mPa·s, bevorzugt 1000 mPa·s bis 1500 mPa·s, aufweist. Beim Aufbringen des Klebstoffs und/oder beim Aufeinanderlegen von Label und Träger weist der Klebstoff insbesondere newtonsche oder scherverdünnende Fluideigenschaften auf. Die Fluideigenschaften, insbesondere die Viskosität ist oder wird vorzugsweise derart ausgestaltet, dass beim Aufeinanderlegen von Label und Träger ein Fließen des Klebstoffs möglich ist und/oder die ein oder mehreren ersten definierten Formen des Klebstoffs bis zum Aufeinanderlegen von Label und Träger erhalten bleiben oder kontrolliert verformt werden. Es kann insbesondere eine automatisierbare Positionierung des Klebstoffs und vorzugsweise eine weitgehend gleichmäßige Verteilung des Klebstoffs über die Fläche des Labels und/oder des Trägers, insbesondere nach dem Aufeinanderlegen von Label und Träger, erhalten werden.

Die Viskosität, insbesondere die dynamische Viskosität, wird hierbei vorzugsweise für einen Zustand des Klebstoffs angegeben, welcher besteht bevor der Klebstoff der Klebstoffausgabe-Einheit zugeführt wird und/oder während der Klebstoff auf das Label und/oder den Träger aufgebracht wird. Bei der in dem vorstehenden Bereich angegebenen Viskosität, insbesondere dynamischen Viskosität, kann es sich insbesondere auch um einen Mittelwert handeln, um den insbesondere Toleranzwerte schwanken. Eine derartige Viskosität gewährleistet insbesondere eine optimale Benetzung des Labels und/oder des Trägers. Eine zu geringe Viskosität kann beispielsweise zu einem ungewollten Verlaufen des Klebstoffs vor dem Aufeinanderlegen von Label und Träger führen und eine zu hohe Viskosität kann beispielsweise zu einem schlechten bzw. unzureichenden Fließen des Klebers beim Aufeinanderlegen von Label und Träger führen.

Die Viskosität des Klebstoffs wird insbesondere gemessen, vorzugsweise mittels eines Viskosimeters, bevorzugt nach der Norm ISO 3219, weiter bevorzugt nach DIN EN ISO 3219-1:2021-08 (Rheologie - Teil 1: Begriffe und Formelzeichen für die Rotations- und Oszillationsrheometrie, Ausgabedatum 2021-08) oder nach DIN EN ISO 3219-2:2021-08 (Rheologie - Teil 2: Allgemeine Grundlagen der Rotations- und Oszillationsrheometrie, Ausgabedatum 2021-08). Vorzugsweise ist der Klebstoff derart ausgebildet, dass seine Fließgrenze zumindest nach dem Aufbringen auf das Label und/oder den Träger und/oder vor dem Aufeinanderlegen von Label und Träger unterschritten wird und/oder der Klebstoff nach dem Aufbringen mittels der Klebstoffausgabe-Einheit in den ein oder mehreren ersten definierten Formen verbleibt und bevorzugt seine Form nicht oder im Wesentlichen nicht ändert, vorzugsweise bis beim Aufeinanderlegen von Label und Träger die Fließgrenze wieder überschritten wird. Somit kann eine gleichmäßige Verteilung zwischen Label und Träger erreicht werden, ohne dass Klebstoff an einem Rand von Label und/oder Träger herausläuft.

Es ist möglich, dass die ein oder mehreren ersten definierten Formen des Klebstoffs Querschnittsabmessungen, insbesondere Durchmesser, in einem Bereich von 50 µm bis 5000 µm, bevorzugt in einem Bereich von 500 µm bis 3000 µm, aufweisen. Es ist auch möglich, dass der Klebstoff mit einer Breite in einem Bereich von 100 µm bis 10000 µm, bevorzugt in einem Bereich von 1000 µm bis 6000 µm aufgebracht wird. Die Breite wird bevorzugt in Draufsicht und/oder bei Betrachtung senkrecht auf eine von dem Label und/oder dem Träger aufgespannte Ebene gemessen. Somit kann bevorzugt ein ausreichendes Fließen beim Aufeinanderlegen von Label und Träger erreicht werden.

Der Klebstoff ist oder wird vorzugsweise vollflächig und/oder teilflächig, bevorzugt musterförmig, aufgebracht. Es ist insbesondere möglich, dass die ersten definierten Formen des Klebstoffs ein oder mehrere der folgenden Formen aufweisen: gerade und/oder gekrümmte Linien, Knochenstruktur, T-Form, Y-Form, I-Form, U-Form, Serpentinen, Knotenpunkte, Verzweigungen, fraktale Formen.

Es ist möglich, dass die ein oder mehreren ersten definierten Formen von ein oder mehreren ersten Schichten des Klebstoffs gebildet werden, welche vollflächig und/oder teilflächig aufgebracht sind oder werden. Beim Aufeinanderlegen von Label und Träger ist es möglich, dass ein Verdrängen des Klebstoffs zu einer höheren Flächenbelegung und/oder einer vollflächigen Flächenbelegung des Labels und/oder des Trägers mit Klebstoff führt. Daraus werden insbesondere die ein oder mehreren Kleberschichten erhalten. Das Aufeinanderlegen von Label und Träger erfolgt vorzugsweise derart, dass die ein oder mehreren Kleberschichten mit einer Mindestdicke von 2 µm, bevorzugt 3 µm, zwischen dem Label und dem Träger angeordnet werden. Das Bauteil weist bevorzugt eine Mindestdicke der ein oder mehreren Kleberschichten von 2 µm, bevorzugt 3 µm, auf. Bevorzugt weisen die ein oder mehreren Kleberschichten in dem Bauteil eine Dicke in einem Bereich von 2 µm bis 150 µm, vorzugsweise von 3 µm bis 50 µm, auf. Die definierte Relativbewegung ist vorzugsweise derart durchführbar und/oder wird derart durchgeführt, dass die ein oder mehreren Kleberschichten mit einer Dicke von mindestens 2 µm, insbesondere in einem Bereich von 2 µm bis 200 µm, vorzugsweise von 3 µm bis 50 µm, zwischen Label und Träger angeordnet werden. Es ist auch möglich, dass die Schichtdicke der ein oder mehreren Kleberschichten vorzugsweise in einem Bereich von 1 µm bis 1 mm, bevorzugt im Bereich von 50 µm bis 250 µm, liegt. Bevorzugt weisen die ein oder mehreren Kleberschichten eine Dicke auf, die mindestens 30% größer ist als jeweils auszugleichende Strukturen hoch bzw. tief ist. Jeweils auszugleichende Strukturen können insbesondere Erhebungen und/oder Vertiefungen des Trägers sein, welche mit dem Label und/oder dem Klebstoff und/oder den ein oder mehreren Kleberschichten zu versehen sind bzw. versehen werden. Unter "mindestens 30 % größer" ist insbesondere zu verstehen, dass die Dicke der ein oder mehreren Kleberschichten mindestens das 1,3-fache der Höhe und/oder Tiefe dieser Erhebungen und/oder Vertiefungen beträgt. Durch eine Mindestdicke der Kleberschicht(en) kann vorteilhafterweise gewährleistet werden, dass Störpartikel von den ein oder mehreren Kleberschichten umschlossen werden.

Beispielsweise wird der Klebstoff in Form von "Raupen" aufgetragen. Insbesondere, wenn der Klebstoff partiell, vorzugsweise musterförmig, aufgetragen wird. Beispielsweise bei Klebstoff in Form einer Raupe ist eine Viskosität des Klebstoffs in einem Bereich von 500 mPa·s bis 2000 mPa·s von Vorteil. Dies ermöglicht insbesondere, dass der Klebstoff gut aufgebracht werden kann und bis zum Aufeinanderlegen von Label und Träger stabil bleibt. Als Raupe wird insbesondere eine Form mit einem im Wesentlichen kreisförmigen oder elliptischen Querschnitt verstanden.

Das Aufbringen ein oder mehrerer Schichten der ein oder mehreren Kleberschichten auf das Label erfolgt vorteilhafterweise auf eine einfach zu beschichtende Oberfläche des Labels, da diese beispielsweise flach ist oder gleichmäßig gebogen ist. Insbesondere weist das Label eine 2,5D-Form auf. Der Träger und/oder das Bauteil weist insbesondere eine zu beschichtende 2,5D-Oberfläche, jedoch auch eine 3D-Form auf, insbesondere aufgrund von Erhebungen, Vertiefungen, Schnappern und/oder Rahmen. Somit kann ein zweckmäßigerweise besonders unkomplizierter Klebstoffauftrag durchgeführt werden. Von Vorteil kann hierbei insbesondere auch eine geringere Masse des Labels gegenüber dem Träger sowie eine bessere Handhabbarkeit sein.

Es ist möglich, dass in Schritt c) ein oder mehrere erste Schichten des Klebstoffs partiell, bevorzugt musterförmig, auf das Label und ein oder mehrere zweite Schichten des Klebstoffs vollflächig und/oder großflächig auf den Träger aufgebracht werden oder ein oder mehrere erste Schichten des Klebstoffs partiell, bevorzugt musterförmig, auf den Träger und ein oder mehrere zweite Schichten des Klebstoffs vollflächig und/oder großflächig auf das Label aufgebracht werden.

Es ist auch möglich, dass die Schichtdicke der ein oder mehreren ersten definierten Formen zumindest bereichsweise größer als die Schichtdicke der ein oder mehreren zweiten definierten Formen und/oder in einer Draufsicht der Flächeninhalt der ein oder mehreren ersten definierten Formen größer als der Flächeninhalt der ein oder mehreren zweiten definierten Formen ist. Die Flächendichte der ersten definierten Formen bezogen auf die mit den ein oder mehreren Kleberschichten bedeckte Fläche nach dem Aufeinanderlegen von Label und Träger beträgt insbesondere weniger als 90 %, vorzugsweise weniger als 80 %. Es ist zweckmäßig, dass die Flächendichte der ein oder mehreren ersten Formen mindestens 5 % beträgt.

Das Verfahren wird vorzugsweise derart durchgeführt und/oder die Vorrichtung derart konfiguriert, dass der Klebstoff innerhalb ein oder mehrerer erster Bereiche des Labels und/oder des Trägers je Bereich der ein oder mehreren ersten Bereiche insbesondere in einem Initialbereich und in einem Folgebereich aufgetragen wird, wobei beim Aufeinanderlegen von Label und Träger ein Kontakt von Label, Klebstoff und Träger zuerst in dem Initialbereich und danach, insbesondere zuletzt, in dem Folgebereich hergestellt wird. Vorteilhafterweise weist der Klebstoff in den ein oder mehreren ersten definierten Formen in dem Initialbereich eine höhere Flächendichte auf als in dem Folgebereich. Es ist dabei auch möglich, dass zwischen dem Initialbereich und dem Folgebereich ein Zwischenbereich angeordnet ist oder wird. Dabei ist die Flächendichte des Klebers in der ersten definierten Form im Initialbereich bevorzugt größer als im Zwischenbereich und/oder im Folgebereich. Im Zwischenbereich ist die Flächendichte in der ersten definierten Form bevorzugt größer als im Folgebereich. Es ist jedoch auch möglich, dass die Flächendichte in der ersten definierten Form im Folgebereich größer ist als im Zwischenbereich. Bevorzugt verringert sich die Flächendichte der ein oder mehreren ersten definierten Formen vom Initialbereich hin zum Folgebereich zumindest bereichsweise.

Je nach Geometrie von Label und Träger sowie beispielsweise den Anforderungen an die Klebeflächen kann somit das Fließen des Klebers beim Zusammenbringen von Label und Träger optimiert werden. Die ein oder mehreren ersten definierten Formen können beispielsweise empirisch und/oder per Simulation ermittelt werden. Dabei ist die Form insbesondere so zu wählen, dass nach dem Aufeinanderlegen von Label und Träger und insbesondere im hergestellten Bauteil eine vorzugsweise gleichmäßig verteilte Klebeschicht ohne Blasen über die komplette mit Label versehene Fläche des Trägers verteilt ist.

Die Flächendichte wird vorzugsweise bei Betrachtung senkrecht auf eine von dem Label und/oder der Träger aufgespannte Ebene berechnet. Bevorzugt berechnet sich die Flächendichte aus dem Flächeninhalt einer von Klebstoff in der ersten definierten Form bedeckten Fläche im Verhältnis zur Fläche des Labels und/oder des Träger, welche nach dem Aufeinanderlegen von Label und Träger mit dem Klebstoff in der zweiten definierten Form bzw. mit den ein oder mehreren Kleberschichten versehen ist.

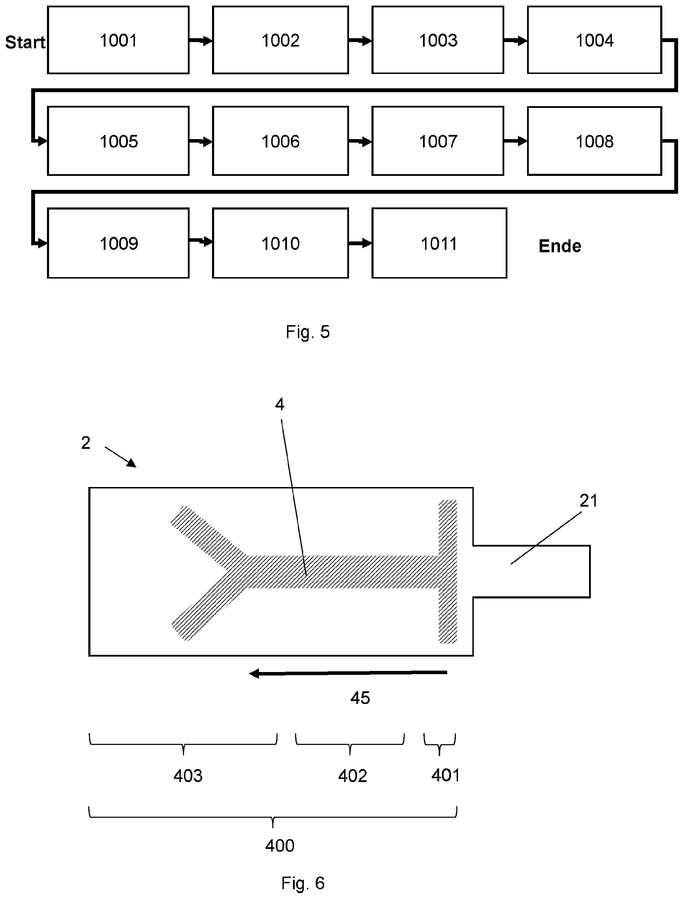

Der Initialbereich kann beispielsweise von einem Anteil von maximal 20%, bevorzugt von maximal 10%, der Gesamtfläche des Labels gebildet werden, die in dem jeweiligen ersten Bereich zuerst eine Verbindung von Label, Klebstoff und Träger aufweist. Der Folgebereich kann beispielsweise von einem Anteil von mindestens 80%, bevorzugt von mindestens 90% der Gesamtfläche des Labels gebildet werden, die in dem jeweiligen ersten Bereich zuletzt eine Verbindung von Label, Klebstoff und Träger aufweist. Die ein oder mehreren ersten definierten Formen können im Folgebereich insbesondere auch nicht vorgesehen sein und Klebstoff erst durch dessen Verdrängen dorthin verteilt werden. Es ist denkbar, dass nur ein erster Bereich vorliegt, wie dies beispielhaft durch Fig. 6 veranschaulicht ist.

Es ist auch möglich, dass der Klebstoff mit den ein oder mehreren ersten definierten Formen mit einem Abstand von mindestens 1 mm, vorzugsweise mindestens 2 mm von einem äußeren Rand und/oder von einer äußeren Kante einer Oberfläche des Labels und/oder des Trägers, auf welche der Klebstoff aufgebracht wird, und/oder von einem Rand einer Aussparung innerhalb des Labels und/oder des Trägers aufgebracht ist oder wird.

Somit kann bevorzugt ein "Herausquetschen" aus einem von Label und Träger gebildeten Spalt vermieden werden.

Es ist auch denkbar, dass der Klebstoff ausschließlich auf das Label aufgebracht wird oder dass der Klebstoff großflächig auf das Label aufgebracht wird und kleinflächig auf den Träger aufgebracht wird oder kleinflächig auf das Label aufgebracht wird und großflächig auf den Träger aufgebracht wird. Großflächig und kleinflächig sind vorzugsweise so zu verstehen, dass der Flächeninhalt der großflächig mit Klebstoff bedeckten Fläche größer ist als der Flächeninhalt der großflächig mit Klebstoff bedeckten Fläche. Beispielsweise kann auf dem Träger oder dem Label ein großflächiges Aufbringen des Klebers durchgeführt sein oder werden, wobei auf dem jeweils anderen Teil aus Träger oder Label ein oder mehrere Kontaktregionen, insbesondere Kontaktpunkte, aufgebracht sind oder werden. Die Kontaktpunkte weisen insbesondere einen Flächeninhalt von maximal 20 cm², bevorzugt maximal 4 cm², auf, insbesondere bei Betrachtung senkrecht auf eine von dem Träger und/oder dem Label aufgespannte Ebene.

Vorteilhaft an einem Aufbringen des Klebstoffs auf das Label ist insbesondere, dass typischerweise das Label eine weniger komplexe Oberflächengeometrie aufweist sowie insbesondere relativ flach und leicht ausgestaltet ist. Ein Aufbringen auf den Träger kann sich schwieriger gestalten, insbesondere wenn dieser eine 3D-Form ggf. mit Rand aufweist. Vorteilhaft kann es jedoch auch sein, in bestimmten Bereichen des Trägers oder des Labels die Kontaktregionen vorzusehen, um Anhäufungen von Klebstoff auf dem jeweils anderen Teil, welche beispielsweise zu einem stärkeren Fließen bei der Handhabung führen können, zu vermeiden und/oder um die Relativbewegung von Label und Träger zusammen mit der Klebstoffmenge in Bezug auf ein Verdrängen des Klebstoffs zu optimieren.

Es ist auch möglich, dass der Klebstoff auf das Label aufgebracht wird und auf dem Träger ein Primer aufgebracht ist oder wird oder auf dem Label ein Primer aufgebracht ist oder wird und der Klebstoff auf den Träger aufgebracht wird. Der Primer wird insbesondere an einer mit Klebstoff zu versehenden Seite oder Fläche aufgebracht. Vorzugsweise ist oder wird der Primer partiell oder vollflächig aufgebracht. Der Primer ist vorzugsweise mit dem Klebstoff chemisch abgestimmt. Ein Primer wird insbesondere auch als Haftvermittler oder "tie coat" bezeichnet. Der Primer ist oder wird insbesondere als Schicht aufgetragen.

Es ist möglich, dass ein oder mehrere erste Schichten der ein oder mehreren Klebeschichten und/oder der für diese Schichten aufgetragene Klebstoff einen dispensierbaren Lack aufweisen oder daraus bestehen, bevorzugt einen UV-Dispensinglack, aufweisen oder daraus bestehen. Die Klebstoffausgabe-Einheit weist bevorzugt ein oder mehrere Dispenser und/oder ein oder mehrere Volumen-Dosimeter auf, mittels welchem vorzugsweise ein solcher Dispensinglack druckbar ist oder gedruckt wird. Insbesondere wird das Verfahren zur Herstellung des Bauteils derart ausgestaltet und/oder die Vorrichtung derart konfiguriert, dass ein oder mehrere erste Schichten der ein oder mehreren Klebeschichten mit den ein oder mehreren Dispensern aufgebracht werden. Es ist weiter möglich, dass ein oder mehrere Schichten der ein oder mehreren Klebeschichten vernetzbar sind oder vernetzt sind oder werden, insbesondere mittels Strahlung, vorzugsweise mit sichtbarem Licht und/oder mit UV-Strahlung. Zweckmäßigerweise sind oder werden die ein oder mehreren Dispenser auf die jeweilige Kleberschicht abgestimmt, insbesondere deren Viskosität, Füllstoffe, Verarbeitungstemperatur und/oder Auftragsmenge.

Es ist möglich, dass ein oder mehrere erste Schichten der ein oder mehreren Klebeschichten und/oder der für diese Schichten aufgetragene Klebstoff eine Digitaldruckfarbe aufweisen oder daraus bestehen, vorzugsweise eine Tintenstrahldruckfarbe, bevorzugt eine UV-Tintenstrahldruckfarbe, aufweisen oder daraus bestehen. Die Klebstoffausgabe-Einheit weist bevorzugt ein oder mehrere Tintenstrahldruckköpfe auf, mittels welchem vorzugsweise eine solche Tintenstrahldruckfarbe druckbar ist oder gedruckt wird. Insbesondere wird das Verfahren zur Herstellung des Bauteils derart ausgestaltet und/oder die Vorrichtung derart konfiguriert, dass ein oder mehrere erste Schichten der ein oder mehreren Klebeschichten mit einem Digitaldruckverfahren, vorzugsweise einem Tintenstrahldruckverfahren, bevorzugt einem UV-Tintenstrahldruckverfahren, aufgebracht werden. Es ist weiter möglich, dass ein oder mehrere Schichten der ein oder mehreren Klebeschichten vernetzbar sind oder vernetzt sind oder werden, insbesondere mittels Strahlung, vorzugsweise mit sichtbarem Licht und/oder mit UV-Strahlung. Klebeschichten in Form einer Tintenstrahldruckfarbe sind oder werden bevorzugt mit einer Viskosität in einem Bereich von 0,5 mPa·s bis 100 mPa·s, vorteilhafterweise 8 mPa·s bis 30 mPa·s, aufgebracht.

Es ist denkbar, dass alternativ oder zusätzlich ein oder mehrere Schichten der ein oder mehreren Klebeschichten mittels Tiefdrucks und/oder Siebdrucks aufgebracht sind oder werden. Es ist somit auch möglich, dass ein oder mehrere Schichten der ein oder mehreren Klebeschichten des Gesamtaufbaus, insbesondere der ein oder mehreren definierten Formen, eine Tiefdruckfarbe und/oder eine Siebdruckfarbe umfassen. Es ist ferner auch denkbar, dass ein oder mehrere Schichten der ein oder mehreren Klebeschichten neben Strahlungshärtungseigenschaften, insbesondere UV-Härtungseigenschaften und/oder durch sichtbares Licht hervorgerufene Härtungseigenschaften, auch thermisch härtende, selbsthärtende und/oder aufgrund eines Mehr-Komponenten-Systems durch Vernetzung härtende Eigenschaften aufweisen. Vorzugsweise weisen die ein oder mehreren Kleberschichten beim Auftragen eine ausreichend hohe Viskosität auf, damit die Form des Klebers während des Prozesses weitgehend erhalten bleibt, bis das Label auf das Bauteil aufgebracht wird. Beispielsweise weist der Klebstoff und/oder der für ein oder mehrere Schichten der ein oder mehreren Kleberschichten aufgetragene Klebstoff newtonsche und/oder scherverdünnende Fluideigenschaften auf.

Der Klebstoff und/oder die daraus erhaltenen ein oder mehreren Klebeschicht(en) oder ein oder mehrere Schichten davon sind oder werden vorzugsweise aus der Klasse der Polyacrylate und/oder Polymethacrylate, Polyurethane, insbesondere aus der Gruppe der Polyesterpolyole, Polyetherpolyole, Polycarbonatpolyole, Polyacrylatpolyole und/oder Kombinationen dieser Polymeren, Polyester, Polyether, Polyolefine, Epoxidharze und/oder aus Derivaten der genannten gebildet. Diese Formulierungen können insbesondere sowohl unvernetzt als auch weiter vernetzt sein oder werden, bevorzugt durch Isocyanate, Carbodiimide, Melamine und/oder Aziridine und/oder Derivate der genannten Verbindungen.

Der Klebstoff und/oder die daraus erhaltenen ein oder mehreren Klebeschicht(en) oder ein oder mehrere Schichten davon können weiter insbesondere aufgebaut sein oder werden aus strahlungshärtenden Stoffen, insbesondere strahlungshärtenden Acrylaten und/oder Methacrylaten, umfassend oder bestehend aus Polyacrylatacrylaten (engl.: "acrylic acrylate"), Polyurethanacrylaten, Polyesteracrylaten, Polycarbonatacrylaten und/oder Polyetheracrylaten und/oder Copolymeren aus den genannten. Bei den strahlungshärtenden Formulierungen, insbesondere den strahlungshärtenden Acrylaten und/oder Methacrylaten, handelt es sich hierbei vorzugsweise um Oligomere. Ein Oligomer ist insbesondere ein Molekül mit einer Anzahl an Monomeren in einem Bereich von 2 bis 100. Ein Polymer ist insbesondere ein Molekül mit einer Anzahl an Monomeren ab 101.

Der Klebstoff und/oder die daraus erhaltenen ein oder mehreren Klebeschicht(en) oder ein oder mehrere Schichten davon enthalten vorzugsweise, insbesondere neben den genannten Polyacrylaten, weitere UV-härtbare Acrylatmonomere und/oder Methacrylatmonomere, und/oder werden daraus hergestellt. Diese Monomere enthalten je nach Ausführung insbesondere eine oder mehrere Acrylatgruppen und/oder vorzugsweise weitere Nebengruppen wie z.B. Alkyl-, Aryl-, Cycloalkyl-, Cycloalkylaryl-, Alkoxyalkyl-, Alkoxyaryl-, Thionyl-, Thionylaryl-, Cyclothionyl-, Cyclothionylaryl-, Alkoxythionyl-, Cycloalkoxythionyl-, Alkoxycyclothionyl-, Cycloalkoxycyclothionyl-, Alkoxythionylaryl-, Cycloalkoxythionylaryl-, Alkoxycyclothionylaryl- und/oder Cycloalkoxycyclothionylarylgruppen. Hierdurch können insbesondere spezielle Lackeigenschaften, wie z.B. die Viskosität und eine optimierte Ausbildung des dreidimensionalen Netzwerks bei der Strahlungshärtung, eingestellt werden. Durch die Auswahl der Monomere oder Kombinationen dieser können insbesondere weitere Eigenschaften, wie z.B. die Oberflächenhärte oder Restklebrigkeit (üblicherweise bezeichnet mit dem englischen Begriff "tackiness") der ein oder mehreren Klebeschichten gezielt gesteuert werden.

Im fertigen Bauteil umfassen die ein oder mehreren Kleberschichten bevorzugt oder bestehen bevorzugt aus entsprechend strahlungsgehärteten, insbesondere UVstrahlungsgehärteten und/oder mit sichtbarem Licht gehärteten, Stoffen.

Der Klebstoff und/oder die daraus erhaltenen ein oder mehreren Klebeschicht(en) oder ein oder mehrere Schichten davon können, insbesondere im Sinne einer Kombination der vorgenannten, aus einem strahlenhärtenden Dual Cure Lack bestehen oder daraus hergestellt sein oder werden. Dual Cure Lacke können aus verschiedenen Polymeren oder Oligomeren bestehen, die ungesättigte AcrylatGruppen und/oder Methacrylat-Gruppen besitzen. Diese funktionellen Gruppen können im strahlungshärtenden Schritt wiederum radikalisch miteinander vernetzt werden. Zur thermischen Vorvernetzung im ersten Schritt werden bei diesen Polymeren oder Oligomeren vorzugsweise auch mindestens zwei oder mehrere Alkoholgruppen verwendet. Diese Alkoholgruppen können insbesondere mit multifunktionellen Isocyanaten oder Melaminformaldehydharzen vernetzt werden. Als vorzugsweise ungesättigte Oligomere, Polymere oder Dendrimere kommen beispielsweise verschiedene UV-Rohstoffe wie Epoxyacrylate, Polyetheracrylate, Polyesteracrylate und insbesondere Polyacrylatacrylate in Frage. Als Isocyanat werden insbesondere geblockte und/oder ungeblockte Vertreter auf TDI (TDI = Toluol-2,4-diisocyanat), HDI (HDI = Hexamethylen¬diisocyanat) oder IPDI-Basis (IPDI = Isophorondiisocyanat) verwendet. Die Melaminvernetzer können aus der Gruppe der vollveretherten, der Imino-Typen und/oder der Benzoguanamine stammen.

Der Klebstoff und/oder die daraus erhaltenen ein oder mehreren Klebeschicht(en) oder ein oder mehrere Schichten davon können insbesondere zur Optimierung von rheologischen Eigenschaften auch mit Füllstoffen wie beispielsweise HDK (hochdisperse Kieselsäure) ausgestattet sein oder werden.

Vorzugsweise enthalten die ein oder mehreren Klebeschichten insbesondere zur Initiation der Strahlungshärtung, wenn es sich bei dieser insbesondere um eine UV-Strahlungshärtung handelt, sogenannte Initiatoren, insbesondere UV-Initiatoren. Die UV-Initiatoren werden bevorzugt aus der Klasse der α-Alkoxy-, α-Hydroxy- oder α-Amino-Arylketonen und/oder der Klasse der Acylphosphinoxide und/oder polymergebundene Varianten dieser vorgenannten Klassen ausgewählt. Acylphosphinoxide werden insbesondere aufgrund ihrer besonders geeigneten Absorptionseigenschaften im UV-LED-Bereich, bevorzugt in Kombination mit Dispensern, UV-Tintenstrahldruck, Flexodruck, Tampondruck oder Siebdruck der ein oder mehreren Klebeschichten, eingesetzt.

Insbesondere zur Verbesserung spezieller und typischer Lackeigenschaften wie z.B. der Benetzung, des Verlaufs, der Schaumbildung usw. ist es möglich, dass die ein oder mehreren Klebeschichten Additive enthalten. Zur Einbindung dieser Additive in das dreidimensionale Netzwerk sind diese typischerweise ihrerseits mit strahlungshärtenden oder thermisch vernetzbaren Gruppen oder Kombinationen daraus versehen.

Es ist möglich, dass insbesondere zur Minimierung von Kettenabbrüchen während der Strahlungshärtung durch Reaktionen der gebildeten Radikale mit Sauerstoffmolekülen der Luft und/oder zur Verminderung der Migration von Radikalketten an die Schichtoberfläche, dem Klebstoff und/oder den daraus erhaltenen ein oder mehreren Klebeschicht(en) oder ein oder mehrere Schichten davon bevorzugt tertiäre Amine und/oder Acrylatamine, insbesondere sogenannte Aminsynergisten, zugesetzt sind oder werden. Insbesondere zur Einbindung dieser Additive in das dreidimensionale Netzwerk sind diese bevorzugt ebenfalls ihrerseits mit strahlungshärtenden oder thermisch vernetzbaren Gruppen oder Kombinationen daraus versehen.

Das Verfahren wird vorzugsweise derart durchgeführt und/oder die Vorrichtung ist vorzugsweise derart konfiguriert, dass durch die definierte Relativbewegung von Label-Aufnehmer und Träger-Aufnehmer der Klebstoff zumindest bereichsweise von den ein oder mehreren ersten definierten Formen hin zu den ein oder mehreren zweiten definierten Formen der ein oder mehreren Kleberschichten verdrängt wird oder verdrängbar ist. Das Verfahren wird derart durchgeführt und die Vorrichtung ist derart konfiguriert, dass das Aufeinanderlegen von Label und Träger durch eine rotatorische und optional eine translatorische und rotatorische Bewegung des Labels in Relation zu dem Träger durchführbar ist oder durchgeführt wird. Die definierte Relativbewegung von Label-Aufnehmer und Träger-Aufnehmer ist oder umfasst insbesondere ein Wippen und/oder ein Abrollen. Die definierte Relativbewegung von Label-Aufnehmer und Träger-Aufnehmer wird vorzugsweise automatisch durchgeführt und/oder ist automatisch durchführbar.

Das Verfahren wird vorzugsweise derart durchgeführt und/oder die Vorrichtung ist vorzugsweise derart konfiguriert, dass zur Durchführung der definierten Relativbewegung von Label und Träger das Label um einen Rotationspunkt und/oder mit einem Winkel in einem Bereich von 0° bis 45° und/oder mit einer Winkelgeschwindigkeit von 0,01 rad/s bis 100 rad/s rotiert wird und/oder rotierbar ist.

Alternativ oder zusätzlich wird das Verfahren besonders bevorzugt derart durchgeführt und/oder die Vorrichtung ist besonders bevorzugt derart konfiguriert, dass zur Durchführung der definierten Relativbewegung von Label-Aufnehmer und Träger-Aufnehmer und/oder von Label und Träger eine Wipp-Bewegung und/oder eine Abroll-Bewegung des Labels bzw. des Label-Aufnehmers durchgeführt wird und/oder durchführbar ist. Unter einer Wipp-Bewegung ist hierbei insbesondere eine rotatorische Bewegung um eine räumlich feste Achse oberhalb des Trägers und/oder oberhalb des Träger-Aufnehmers zu verstehen, insbesondere wobei es eine translatorische Bewegung zwischen Label-Aufnehmer, insbesondere Label auf dem Label-Aufnehmer, und dem Träger-Aufnehmer, insbesondere dem Träger auf dem Träger-Aufnehmer, gibt. Unter einer Abroll-Bewegung ist hierbei insbesondere eine rotatorische Bewegung mit einer Drehachse oberhalb des Träger-Aufnehmers, vorzugsweise oberhalb des Trägers auf dem Träger-Aufnehmer, zu verstehen, insbesondere wobei sich die Drehachse bewegt, vorzugsweise in Richtung einer Abroll-Richtung bewegt. Hierbei gibt es bevorzugt keine translatorische Bewegung zwischen dem Label-Aufnehmer, insbesondere dem Label auf dem Label-Aufnehmer, und dem Träger-Aufnehmer, insbesondere dem Träger auf dem Träger-Aufnehmer. Es ist möglich, dass die Wipp-Bewegung mehrfach erfolgt, wobei die Rotationsrichtung alterniert, d.h. dass insbesondere ein Hin- und Her-Wippen erfolgt. Es ist möglich, dass die Abroll-Bewegung mehrfach erfolgt, insbesondere wobei die Rotationsrichtung und die translatorische Richtung der Drehachse alterniert, d.h. wobei vorzugsweise ein Hin- und Her-Abrollen erfolgt.

Es ist, insbesondere bei Labels mit einer Fläche, die bevorzugt bei einer Draufsicht und/oder einer Betrachtung senkrecht auf eine von dem Label aufgespannte Ebene, kleiner als 100 cm², bevorzugt kleiner als 20 cm² ist, denkbar, das Verfahren derart durchzuführen und/oder die Vorrichtung derart auszugestalten, dass von Label-Aufnehmer und oder Träger-Aufnehmer eine reine Hub-Bewegung als Relativbewegung von Label und Träger durchgeführt wird und/oder durchführbar ist. Die Hub-Bewegung ist insbesondere als reine translatorische Bewegung zu verstehen. Vorteilhaft ist hierbei insbesondere der einfache Aufbau der Vorrichtung und der einfache Verfahrensablauf. Insbesondere bei größeren Labels ist vorzugsweise jedoch eine rotatorische Komponente der Bewegung vorteilhaft.

Insbesondere weist die Vorrichtung Mittel zur Durchführung der Relativbewegung von Label-Aufnehmer und Träger-Aufnehmer auf, welche insbesondere bewegliche Bauteile, Aktoren zum Bewegen der Bauteile und Mittel zur Ansteuerung der Aktoren, vorzugsweise basierend auf Befehlen einer Software, insbesondere mittels zumindest einem Speichermedium und zumindest einem Prozessor, umfassen. Vorzugsweise ist die definierte Relativbewegung von Label und Träger basierend auf insbesondere von einem Speichermedium abrufbaren Daten zur Position, Stellung und/oder Bewegung des Labels und/oder des Trägers durchführbar oder wird darauf basierend durchgeführt. Bevorzugt ist oder wird der Label-Aufnehmer mittels eines Robotersystems, vorzugsweise eines kollaborierenden Robotersystems, gehalten und/oder bewegt. Das Robotersystem weist hierzu vorzugsweise ein oder mehrere der folgenden Komponenten auf: ein oder mehrere Roboterarme, ein oder mehrere Gelenke zur beweglichen Anordnung der ein oder mehreren Roboterarme, ein oder mehrere Aktoren zur Bewegung der ein oder mehreren Roboterarme, vorzugsweise ein oder mehrere hydraulische Aktoren, ein oder mehrere pneumatische Aktoren und/oder ein oder mehrere Elektromotoren, bevorzugt ein oder mehrere Servomotoren, zur Bewegung der ein oder mehreren Roboterarme, ein oder mehrere Sensoren zur Erfassung der Position und/oder Stellung des Label-Aufnehmers und/oder der ein oder mehreren Roboterarme, eine Steuervorrichtung, insbesondere zur Speicherung und Ausführung von Bewegungsabläufen, eine Schnittstelle für eine Bedienvorrichtung und/oder eine Bedienvorrichtung, insbesondere zum Eingeben, Speichern und/oder Abrufen der Bewegungsabläufe.

Vorzugsweise stellen die ein oder mehreren Gelenke oder zumindest ein Gelenk davon eine rotatorische Beweglichkeit bereit. Eine translatorische Bewegung kann hierbei vorzugsweise durch das Zusammenwirken mehrerer rotatorischer Bewegungen durchführbar sein oder durchgeführt werden. Die Bewegungsabläufe können beispielsweise durch ein manuelles Bewegen und/oder manuelles Positionieren des Label-Aufnehmers in der Steuervorrichtung gespeichert sein oder werden, insbesondere durch Speichern von Daten der ein oder mehreren Sensoren zur Bewegung und/oder Position und/oder Stellung der ein oder mehreren Roboterarme.

Bevorzugt ist, dass der Label-Aufnehmer von einem Robotersystem, insbesondere einem Roboterarm, beweglich führbar ist und/oder geführt wird und der Träger-Aufnehmer in einer fixen Position der Vorrichtung angeordnet ist.

Es ist möglich, dass das Verfahren derart ausgeführt wird und/oder die Vorrichtung derart konfiguriert ist, dass beim Aufbringen des Klebstoffs die Klebstoffauftrags-Vorrichtung und/oder der Label-Aufnehmer bewegt werden. Das Verfahren wird bevorzugt derart durchgeführt und/oder die Vorrichtung derart konfiguriert, dass der Label-Aufnehmer vorzugsweise in eine Druckposition gebracht wird und/oder mittels einer Relativbewegung von Klebstoffausgabe-Einheit und Label-Aufnehmer der Klebstoff in der ersten definierten Form aufgebracht wird. Dabei ist es möglich, dass die Klebstoffausgabe-Einheit und/oder der Label-Aufnehmer in eine oder mehrere Raumrichtungen, insbesondere ausgewählt aus x-Richtung, y-Richtung und/oder z-Richtung eines kartesischen Koordinatensystems, bewegt wird.

Insbesondere wird mittels der Mittel zur Durchführung der Relativbewegung von Label-Aufnehmer und Träger-Aufnehmer zudem eine Bewegung des Label-Aufnehmers zu der Kleberausgabe-Einheit und/oder zu der Härtungs-Einheit durchgeführt.

Es ist bevorzugt, dass das Label in dem Label-Aufnehmer passgenau gehalten wird und/oder der Label-Aufnehmer zum passgenauen Halten des Labels ausgestaltet ist und/oder das Label und/oder der Label-Aufnehmer beispielsweise Markierungen als Passermarken aufweist, die vorzugsweise eine passgenaue Halte-Position erkennbar machen. Zum passgenauen Halten des Labels kann der Label-Aufnehmer beispielsweise eine an die Form des Labels angepasste Form und/oder angepasste Halteelemente aufweisen.

Es ist möglich, dass das Aufeinanderlegen von Label und Träger passgenau durchgeführt wird, insbesondere mit einer Toleranz von weniger als ±1 mm, vorzugsweise ±0,5 mm, bevorzugt ±0,2 mm. Die Toleranz ist insbesondere eine Abweichung der Ist-Position von einer Soll-Position.

Hierzu kann die Vorrichtung ein oder mehrere Sensoren zur Ermittlung der Relativposition von Label und Label-Aufnehmer und/oder von Label und Träger aufweisen. Es ist auch möglich, dass Label-Aufnehmer und/oder Träger-Aufnehmer, Label und/oder Träger ein oder mehrere Passermarken aufweisen oder ein oder mehrere Elemente von Label und/oder Träger als Passermarken verwendet werden, wobei die Position der Passermarken von den ein oder mehreren Sensoren ermittelt und mit einem Soll-Wert abgeglichen wird sowie daraus ggf. eine Anpassung der Relativposition von Label und Träger abgeleitet wird.

Der Träger-Aufnehmer umfasst oder besteht vorzugsweise aus ein oder mehreren der folgenden Teile: eine starre Fläche, worauf der Träger platziert wird, einen Tisch, Vertiefung, Abstandshalter, Klemmvorrichtungen, Verschraubung, Magnethalterung, Vakuumhalterung. Das Bereitstellen des Trägers kann beispielsweise erfolgen mittels eines manuellen Ablegens auf dem Träger-Aufnehmer und/oder mittels eines Ablegens auf dem Träger-Aufnehmer, vorzugsweise durch einen Roboterarm.

Insbesondere wird der Träger, vorzugsweise mittels den ein oder mehreren Klemmvorrichtungen und/oder Verschraubung und/oder Vertiefung und/oder Magnethalterung und/oder Vakuumhalterung, in einer definierten Position von dem Träger-Aufnehmer gehalten und/oder der Träger-Aufnehmer in einer definierten und festen Position vorgesehen. Der Träger-Aufnehmer ist insbesondere der Geometrie des Trägers angepasst. Der Träger-Aufnehmer kann dabei aus Stahl bestehen oder aus Kunststoff. Der Träger-Aufnehmer kann insbesondere mittels 3D-Druck hergestellt sein.

Die Vorrichtung umfasst bevorzugt eine Härtungs-Einheit zum zumindest teilweise Härten und/oder zumindest teilweise Vernetzen der ein oder mehreren Kleberschichten. Es ist möglich, dass vor dem zumindest teilweise Härten und/oder zumindest teilweise Vernetzen, insbesondere vor einem Aushärten und/oder vollständig Vernetzen, der ein oder mehreren Kleberschichten der Label-Aufnehmer von dem Label entfernt wird. Es ist auch möglich, dass das zumindest teilweise Härten und/oder zumindest teilweise Vernetzen mittels ein oder mehreren der folgenden Schritte erfolgt: Bestrahlung, insbesondere im sichtbaren Bereich, d.h. insbesondere mittels Bestrahlung mit sichtbarem Licht und/oder mittels UV-Bestrahlung, bevorzugt mittels UV-A Strahlung, UV-B Strahlung und/oder UV-C-Strahlung, Elektronenstrahlhärtung, Härten durch Wärme, anaerobe Aushärtung, anionische Aushärtung, Feuchtigkeits-initiierte Vernetzung, Mehrkomponenten-Härtung, insbesondere Zweikomponenten-Härtung, erfolgt. Es ist also beispielsweise möglich, dass bei selbsthärtenden Klebstoffen die Härtung durch Warten und/oder einen Wärmeeintrag durchgeführt wird.

UV-Strahlung wird insbesondere von Wellenlängen in einem Bereich von 100 nm bis 400 nm gebildet. UV-A-Strahlung wird insbesondere von Wellenlängen in einem Bereich von 315 nm bis 400 nm gebildet. UV-B-Strahlung wird insbesondere von Wellenlängen in einem Bereich von 280 nm bis 315 nm gebildet. UV-C-Strahlung wird insbesondere von Wellenlängen in einem Bereich von 100 nm bis 280 nm gebildet. Sichtbares Licht wird insbesondere von Wellenlängen in einem Bereich von 400 nm bis 780 nm gebildet. IR-Strahlung wird insbesondere von Wellenlängen in einem Bereich von 780 nm bis 1 mm gebildet. Nahes Infrarot (NIR) wird insbesondere von Wellenlängen in einem Bereich von 780 nm bis 3 µm gebildet. Mittleres Infrarot (MIR) wird insbesondere von Wellenlängen in einem Bereich von 3 µm bis 50 µm gebildet. Fernes Infrarot wird insbesondere von Wellenlängen in einem Bereich von 50 µm bis 1 mm gebildet.

Es ist insbesondere möglich, dass die Härtungs-Einheit eine Bestrahlungseinheit, insbesondere zur Bestrahlung mit sichtbarem Licht und/oder mit UV-Strahlung, vorzugsweise UV-A, UV-B und/oder UV-C Strahlung, zum Bestrahlen der ein oder mehreren Kleberschichten aufweist oder davon gebildet ist und/oder dass das zumindest teilweise Härten und/oder zumindest teilweise Vernetzen mittels Bestrahlung, insbesondere UV-Bestrahlung, bevorzugt mittels UV-A-Strahlung, UV-B-Strahlung und/oder UV-C-Strahlung, und/oder mittels sichtbarem Licht, erfolgt oder durchführbar ist.

Die Bestrahlungs-Einheit ist vorzugsweise derart ausgestaltet oder die Bestrahlung wird vorzugsweise derart durchgeführt, dass eine Bestrahlung mit Wellenlängen in einem Bereich von 50 nm bis 600 nm, bevorzugt von 100 nm bis 450 nm, weiter bevorzugt von 100 nm bis 405 nm, durchgeführt wird und/oder eine Bestrahlung mit einer Dauer in einem Bereich von 0,25 s bis 20 s, bevorzugt 1 s bis 5 s durchgeführt wird, und/oder dass während der Bestrahlung eine Temperatur, insbesondere des Labels, des Trägers und/oder der ein oder mehreren Kleberschichten, in einem Bereich von 10°C bis 100°C, vorzugsweise 15°C bis 40°C vorliegt. Die Bestrahlung wird beispielsweise mittels ein oder mehrerer Lampen, insbesondere UV-Lampen, bevorzugt UV-LEDs, und/oder LEDs für Strahlung im sichtbaren Bereich und/oder Quecksilberdampflampen, die mit Eisen und/oder Gallium und/oder Indium und/oder Bismut und/oder Blei und oder Zinn dotiert sind, durchgeführt. Der Abstand der ein oder mehreren Lampen liegt bevorzugt in einem Bereich von 10 mm bis 1000 mm, vorzugsweise von 50 mm bis 200 mm. Die Leistung der ein oder mehreren Lampen, insbesondere UV-Lampen, bevorzugt UV-LEDs, und/oder LEDs für Strahlung im sichtbaren Bereich und/oder Quecksilberdampflampen, die mit Eisen und/oder Gallium und/oder Indium und/oder Bismut und/oder Blei und oder Zinn dotiert sind, liegt vorzugsweise in einem Bereich von 10 mW/cm² bis 5000 mW/cm², bevorzugt 50 mW/cm² bis 500 mW/cm².

Die Bestrahlung erfolgt bevorzugt vollflächig, insbesondere nachdem das Label vom Label-Aufnehmer entfernt wurde. Damit sollen die ein oder mehreren Kleberschichten insbesondere nahezu vollständig aushärten bzw. vernetzen. Ein komplettes Aushärten und/oder komplettes Vernetzen, also insbesondere ein Vernetzen auf 100 % der zu einer Vernetzung fähigen Polymerbestandteile und/oder eine Erreichung der Endhärte der ein oder mehreren Kleberschichten, kann dann beispielsweise innerhalb eines Zeitraums von 12 Stunden erfolgen.

Vorzugsweise wird bei dem Verfahren folgender Schritt durchgeführt: teilflächiges oder vollflächiges Vorhärten der ein oder mehreren Kleberschichten. Hiermit kann eine Fixierung des Labels an einer Stelle oder mehreren Stellen des Trägers erreicht werden, so dass bei einem Abnehmen des Label-Aufnehmers vom Label das Label nicht verrutscht oder samt Label-Abnehmer abhebt. Es ist möglich, dass die Vorrichtung eine Vorhärtungs-Einheit zum partiellen oder vollflächigen Vorhärten der ein oder mehreren Kleberschichten, insbesondere während der Label-Aufnehmer in Kontakt mit dem Label steht, aufweist. Die Vorhärtungseinheit ist bevorzugt eine Bestrahlungseinheit, insbesondere zur Bestrahlung mit UV-Strahlung, vorzugsweise UV-A, UV-B und/oder UV-C Strahlung, und/oder mit sichtbarem Licht, und/oder mit IR-Strahlung. Vorzugsweise sind oder werden die ein oder mehreren Kleberschichten hierbei zumindest bereichsweise noch nicht vollständig ausgehärtet bzw. noch nicht vollständig vernetzt.

Insbesondere weist der Label-Aufnehmer ein oder mehrere transparente, vorzugsweise UV-transparente, Bereiche und/oder ein oder mehrere Löcher auf, und/oder die ein oder mehreren Kleberschicht werden durch die ein oder mehreren transparenten Bereiche und/oder Löcher hindurch bestrahlt oder sind durch diese hindurch bestrahlbar, insbesondere während der Label-Aufnehmer noch in Kontakt mit dem Label steht.

Es ist also möglich, dass die Strahlung der Vorhärtungs-Einheit bevorzugt die transparenten Bereiche und/oder die Löcher durchtritt bevor die Strahlung auf die ein oder mehreren Kleberschichten auftrifft. Dies ermöglicht es vor der Abnahme des Labels von dem Label-Aufnehmer die Haftung zwischen Label und Träger zu erhöhen. So kann insbesondere ein sicheres, zuverlässiges und die ein oder mehreren Kleberschichten schonendes Abnehmen des Label-Aufnehmers von dem Label durchgeführt werden.

Es ist auch ein Vorhärten des Klebstoffs nach dem Aufbringen des Klebstoffs, insbesondere direkt nach dem Aufbringen des Klebstoffs, und vor dem Aufeinanderlegen von Label und Träger denkbar. Hierdurch kann insbesondere ungewolltes Fließen des Klebstoffs verhindert werden.

Es ist auch möglich, dass die ein oder mehreren Kleberschichten insbesondere mittels Bestrahlung, vorzugsweise UV-Bestrahlung, und/oder Bestrahlung mit sichtbarem Licht und/oder IR-Bestrahlung, bevorzugt nach einem Abnehmen des Label-Aufnehmers ausgehärtet und/oder vollständig vernetzt werden, insbesondere mittels der Härtungs-Einheit. Die Vorrichtung, insbesondere die Härtungs-Einheit, ist vorzugsweise derart ausgestaltet, dass die ein oder mehreren Kleberschichten nach einem Abnehmen des Label-Aufnehmers insbesondere durch Bestrahlung, vorzugsweise UV-Bestrahlung und/oder Bestrahlung mit sichtbarem Licht, mittels der Härtungs-Einheit ausgehärtet und/oder vollständig vernetzt werden.

Als noch nicht vollständig ausgehärtet wird bevorzugt eine Schicht, insbesondere die Schutzlackschicht bezeichnet, wenn ihre Härte und/oder Beständigkeit noch nicht einen festgelegten Mindestwert aufweist. Der festgelegte Mindestwert der Härte und/oder der Beständigkeit ist vorzugsweise eine Funktion des endgültigen Verwendungszwecks der Schicht, beispielsweise als eine Schutzlackschicht. Mit "vollständig ausgehärtet" im Sinne der vorliegenden Erfindung wird folglich eine Schicht dann bezeichnet, wenn ihre Härte und/oder Beständigkeit einen festgelegten Mindestwert aufweist.

Es ist möglich, dass die oben genannten Mindestwerte so festgelegt sind, dass eine Schicht dann als noch nicht vollständig ausgehärtet im Sinne der vorliegenden Erfindung bezeichnet wird, wenn nicht mehr als 95 % der zu einer Vernetzung fähigen Polymerbestandteile der Schicht eine Vernetzung aufweisen. Folglich wird eine Schicht dann als vollständig ausgehärtet im Sinne der vorliegenden Erfindung bezeichnet, wenn die zu einer Vernetzung fähigen Polymerbestandteile der Schicht zu mehr als 95 % eine Vernetzung aufweisen. Eine vollständig ausgehärtete bzw. vollständig vernetzte Schicht liegt dann vor, wenn eine vollständige (> 95 %) Vernetzung seiner Polymerbestandteile erfolgt ist.

Es ist auch möglich, dass die ein oder mehreren Kleberschichten nur partiell in einem Bestrahlungsbereich bestrahlt werden, beispielsweise indem das Label und/oder der Träger außerhalb des Bestrahlungsbereichs, zumindest bereichsweise opak für die zur Bestrahlung verwendete Strahlung ist. Hierbei wird vorzugsweise die im Bestrahlungsbereich initiierte Vernetzung außerhalb des Bestrahlungsbereichs in Form einer Kettenreaktion fortgesetzt, so dass die ein oder mehreren Kleberschichten vollflächig und vollständig aushärten oder aushärtbar sind. Unter opak wird vorzugsweise ein Transmissionsgrad in einem Bereich von 0% bis 15% verstanden. Unter semitransparent oder teiltransparent wird vorzugsweise ein Transmissionsgrad in einem Bereich von 15% bis 50% verstanden. Unter transparent wird vorzugsweise ein Transmissionsgrad in einem Bereich von 50% bis 100% verstanden. Insbesondere, wenn das Label und/oder der Kleber vollflächig opak ist, ist es möglich, dass vorteilhafterweise ein selbsthärtender und/oder reaktiv härtender Klebstoff verwendet ist, der zur Härtung keine energiereiche Strahlung wie beispielsweise UV-Strahlung benötigt.

Es ist möglich, dass die Vorhärtungs-Einheit und die Härtungs-Einheit von zwei separaten Vorrichtungen oder von derselben Vorrichtung gebildet werden. Insbesondere ist es also möglich, dass das Vorhärten sowie das Aushärten und/oder vollständigen Vernetzen der ein oder mehreren Kleberschichten mittels einer einzigen Bestrahlungseinheit oder mittels separater Bestrahlungseinheiten durchgeführt wird.

Das Vorhärten erfolgt insbesondere mittels einer ersten Bestrahlungseinheit, die vorzugsweise an dem Label-Aufnehmer oder an dem Träger-Aufnehmer befestigt ist. Es ist zudem möglich, dass das Aushärten und/oder vollständige Vernetzen mittels einer zweiten Bestrahlungseinheit erfolgt, die insbesondere an dem Label-Aufnehmer oder an dem Träger-Aufnehmer befestigt ist. Bevorzugt sind die erste und die zweite Bestrahlungseinheit an dem Träger-Aufnehmer befestigt.

Das Label umfasst vorzugsweise eine Sensorfolie oder wird davon gebildet. Die Sensorfolie bildet bevorzugt eine Sensorfunktion, vorzugsweise Touchsensorfunktion, aus. Die Sensorfunktion, vorzugsweise Touchsensorfunktion, ist oder wird insbesondere mittels der elektrisch leitfähigen Funktionsschicht des Labels bereitgestellt. Hierzu weist die elektrisch leitfähige Funktionsschicht vorzugsweise ein oder mehrere Leiterbahnen und/oder ein oder mehrere kapazitive Elemente auf. Es ist möglich, dass die Sensorfolie und/oder die elektrisch leitfähige Funktionsschicht, insbesondere die ein oder mehreren Leiterbahnen und/oder die ein oder mehreren kapazitiven Elemente, und/oder die Trägerschicht transparent ist bzw. sind und/oder nicht transparent, insbesondere opak, ist bzw. sind.

Es ist insbesondere möglich, dass das Label, vorzugsweise zusätzlich zu der Sensorfolie, und/oder die Sensorfolie, mit einem Dekor versehen ist und/oder mit weiteren Folien oder Schichten versehen ist, z.B. mit zumindest einem optisch wirksamen Diffusor, zumindest einer optisch wirksamen Maskenschicht, zumindest einem Lichtleiter, zumindest einer Licht emittierenden Schicht versehen ist, und/oder mit einer die ein oder mehreren elektrischen und/oder elektronischen und/oder optischen und/oder optoelektronischen Bauelemente enthaltenden Funktionsschicht und/oder mit einer ein oder mehrere weitere elektrische und/oder elektronische und/oder optische und/oder optoelektronische Bauelemente enthaltenden Funktionsschicht und/oder mit einer optische Bauelemente enthaltenden Funktionsschicht versehen ist.

Wie aus den vorhergehenden Ausführungen hervorgeht, aber auch unabhängig davon denkbar ist, ist es möglich, dass das Label derart ausgestaltet ist, dass es eine Touchfunktion des Bauteils bereitstellt. Alternativ oder zusätzlich ist es möglich, dass das Label derart ausgestaltet ist, dass es eine Dekoration des Bauteils bereitstellt, insbesondere dass es lediglich eine Dekoration des Bauteils bereitstellt. Alternativ oder zusätzlich ist es auch möglich, dass das Label derart ausgestaltet ist, dass es eine elektrische Funktion bereitstellt, indem das Label zum Beispiel eine flexible Leiterplatte mit LEDs, mit Leiterbahnen, und/oder mit Heizungsbahnen etc. bildet. Vorzugsweise wird dabei der flexible Schichtaufbau durch die zumindest eine Trägerschicht bereitgestellt und entsprechende Funktionen durch die weitere Schicht und/oder die ein oder mehreren elektrischen und/oder elektronischen und/oder optischen und/oder optoelektronischen Bauelemente bereitgestellt.

Die zumindest eine weitere Schicht ist vorzugsweise einzeln oder in Kombination ausgewählt aus: zumindest eine elektrisch leitfähige Funktionsschicht, insbesondere die elektrisch leitfähige Funktionsschicht, zumindest eine Farbschicht, zumindest eine elektrisch isolierende Funktionsschicht, zumindest eine optische Diffusorschicht, zumindest eine optische Maskenschicht, zumindest eine Lichtleiterschicht, zumindest eine Licht emittierende Schicht, zumindest eine Schutzschicht, zumindest eine Barriereschicht, zumindest eine Ausgleichsschicht, zumindest eine Haftvermittlerschicht, zumindest eine Kleberschicht, zumindest eine Barriereschicht, zumindest eine Oxidschicht, zumindest eine Metallschicht.

Die ein oder mehreren elektrischen und/oder elektronischen und/oder optischen und/oder optoelektronischen Bauelemente und/oder die ein oder mehreren weiteren elektrischen und/oder elektronischen und/oder optischen und/oder optoelektronischen Bauelemente können aktive Bauelemente und/oder passive Bauelemente umfassen. Die ein oder mehreren elektrischen und/oder elektronischen und/oder optischen und/oder optoelektronischen Bauelemente und/oder die ein oder mehreren weiteren elektrischen und/oder elektronischen und/oder optischen und/oder optoelektronischen Bauelemente sind vorzugsweise einzeln oder in Kombination ausgewählt aus: zumindest einer LED; zumindest einer OLED, zumindest einem Stecker, zumindest einer Buchse, zumindest einem Sensor, zumindest einen elektrischen Widerstand, zumindest einen Kondensator, zumindest einen Controller, zumindest einem Prozessor. Die ein oder mehreren elektrischen und/oder elektronischen und/oder optischen und/oder optoelektronischen Bauelemente sind vorzugsweise mit der zumindest einen elektrisch leitfähigen Funktionsschicht elektrisch kontaktiert, insbesondere so dass die elektrisch leitfähige Funktionsschicht insbesondere als Leiterbahn fungiert.

Es ist denkbar, dass die ein oder mehreren elektrischen und/oder elektronischen und/oder optischen und/oder optoelektronischen Bauelemente gesondert und/oder freiliegend in dem Label, vorzugsweise zumindest auf der Trägerschicht, vorliegen oder dass die weitere Schicht eine Funktionsschicht umfasst oder daraus besteht, welche die ein oder mehreren elektrischen und/oder elektronischen und/oder optischen und/oder optoelektronischen Bauelemente oder Teile davon umfasst und/oder verkapselt.

Das Label weist vorzugsweise folgende Schichten auf, insbesondere in der angegebenen Reihenfolge, bevorzugt beginnend mit einer Seite, welche eine Sichtseite des Bauteils bildet, einzeln oder in Kombination ausgewählt aus:
eine erste Schutzschicht;
die weitere Schicht, insbesondere umfassend oder bestehend aus: ein oder mehreren ersten Farbschichten; ein oder mehreren ersten Dekorschichten;
der elektrisch leitfähigen Funktionsschicht und/oder den ein oder mehreren elektrischen und/oder elektronischen und/oder optischen und/oder
optoelektronischen Bauelementen oder Teilen davon;
die Trägerschicht;
ein Primer.

Weitere Schichten und beliebige Reihenfolgen der Schichten sind jedoch auch möglich. Die erste Schutzschicht ist insbesondere fest in dem Label integriert oder ablösbar von dem Label ausgestaltet. Bevorzugt weist das Label zumindest die erste Schutzschicht und den Primer auf, wobei zwischen dem Primer, insbesondere in beliebiger Reihenfolge, die Trägerschicht und die weitere Schicht, insbesondere die elektrisch leitfähige Funktionsschicht, und/oder die ein oder mehreren elektrischen und/oder elektronischen und/oder optischen und/oder optoelektronischen Bauelemente, angeordnet sind, welche bevorzugt von der Sensorfolie umfasst sind. Es ist auch denkbar, dass eine zweite Schutzschicht auf einer der Trägerschicht zugewandten Seite des Primers angeordnet ist. Es ist auch denkbar, dass eine dritte Schutzschicht auf einer der Trägerschicht abgewandten Seite des Primers angeordnet ist, wobei die dritte Schutzschicht ablösbar ist und vorzugsweise vor dem Aufbringen des Klebstoffs abgelöst wird.

Es ist möglich, dass die Trägerschicht des Labels ein oder mehrere der folgenden Materialien aufweist oder daraus besteht: PET (Polyethylenterephthalat), PC (Polycarbonat), PMMA (Polymethylmethacrylat), ABS (Acrylnitril-Butadien-Styrol), PC-ABS, PP (Polypropylen), PA (Polyamid), PE (Polyethylen). Insbesondere weist das Label eine Dicke in einem Bereich von 25 µm bis 350 µm, vorzugsweise in einem Bereich von 50 µm bis 150 µm, auf. Es ist auch möglich, dass das Label eine Fläche, insbesondere in Draufsicht und/oder bei Betrachtung senkrecht auf eine von dem Label aufgespannte Ebene und/oder bei Vernachlässigung der Dicke des Labels, in einem Bereich von 1 cm² bis 2000 cm², insbesondere in einem Bereich von 1 cm² bis 1000 cm², aufweist. Insbesondere ist es beispielsweise möglich, dass das Label keine rein rechteckige oder keine rein runde Kontur aufweist. Es ist auch möglich, dass das Label eine Fläche, insbesondere bei Betrachtung senkrecht auf eine von dem Label aufgespannte Ebene und/oder bei Vernachlässigung der Dicke des Labels, aufweist, welche zumindest bereichsweise eine Kontur eines Teils oder eines Ganzen ein oder mehrerer der folgenden Formen umfasst: Kreis, Ellipse, Dreieck, Rechteck, alphanumerisches Zeichen, Fraktalform. Die Kontur kann zumindest bereichsweise auch von Aussparungen gebildet sein.

Es ist möglich, dass der Träger bereichsweise oder vollflächig transparent, opak, teiltransparent und/oder nicht-transparent ist. Insbesondere kann der Träger ein oder mehrere transparente Fenster, beispielsweise für ein Display, und/oder ein oder mehrere musterförmige transparente Bereiche, beispielsweise symbolförmige Bereiche, insbesondere für Buttons, aufweisen. Vorteilhaft ist es daher, wenn der Klebstoff und/oder die ein oder mehreren Kleberschichten die Transparenz zweckmäßigerweise nicht beeinflussen.

Der Träger weist bevorzugt eine maximale Wandstärke in einem Bereich von 0,1 mm bis 10 mm, insbesondere in einem Bereich von 0,1 mm bis 5 mm, vorzugsweise in einem Bereich von 1 mm bis 5 mm, bevorzugt in einem Bereich von 1,5 mm bis 3,5 mm, oder in einem Bereich von 0,15 mm bis 10 mm, vorzugsweise in einem Bereich von 0,2 mm bis 10 mm, auf. Es ist möglich, dass der Träger eine solche maximale Wandstärke nur in Teilbereichen aufweist oder in sämtlichen Bereichen aufweist. Insbesondere bei geringen Wandstärken fällt der Vorteil einer geringen thermischen Belastung besonders ins Gewicht.

Bei einem bevorzugten Ausführungsbeispiel weist der Träger keinen Rahmen auf. Er kann jedoch einen Rahmen aufweisen mit einer Höhe von höchstens 100 mm, bevorzugt von höchstens 50 mm, besonders bevorzugt von höchstens 20 mm. Hierbei wird insbesondere trotz einer vergleichsweise schlechten Handhabung aufgrund des automatisierten Verfahrens bzw. der automatisierten Vorrichtung eine schnelle, sichere und reproduzierbare Verarbeitung gewährleistet.

Es ist möglich, dass der Träger, insbesondere vor dem Aufbringen des Labels, vorderseitig und/oder rückseitig dekoriert ist. Es ist auch möglich, dass das Bauteil nach dem Aufbringen des Labels auf den Träger vorderseitig und/oder rückseitig dekoriert wird.

Es ist möglich, dass das Label einen Kontaktierungstail zum Kontaktieren, insbesondere elektrischen Kontaktieren, der weiteren Schicht, insbesondere der elektrisch leitfähigen Funktionsschicht, und/oder der ein oder mehreren elektrischen und/oder elektronischen und/oder optischen und/oder optoelektronischen Bauelemente aufweist. Der Kontaktierungstail ist und/oder verbleibt in dem Verfahren vorzugsweise frei von Klebstoff und/oder frei von Material des Trägers, bevorzugt zumindest in einem Kontaktbereich frei von Klebstoff und/oder frei von Material des Trägers. Hierzu werden insbesondere die ein oder mehreren definierten Formen des Klebstoffs mit einer angepassten Form und Menge, beispielsweise zur Ausbildung von Raupen in einer Knochenstruktur, aufgebracht und insbesondere der Kontaktbereich frei von Klebstoff gelassen. Ferner ist oder wird bevorzugt die Relativbewegung von Label und Träger, insbesondere mittels einer Hub-Bewegung und/oder einer Wipp-Bewegung, angepasst, vorzugsweise so dass der Kontaktbereich frei von Klebstoff und/oder frei von Material des Trägers bleibt.

Es kann insbesondere auch ein definierter Druck und/oder eine definierte Relativbewegung auf Label, Klebstoff und Träger ausgeübt werden. Ferner kann ein definierter Temperaturbereich von Label, Klebstoff und Träger beim Aufeinanderlegen von Label und Träger eingestellt sein oder werden. So kann vorteilhafterweise ein Herausquetschen des Klebers an den Seiten des Labels, das den Kontaktierungstail beeinträchtigen würde, vermieden werden.

Der Kontaktierungstail wird an dem Label-Aufnehmer bevorzugt in einer definierten Position gehalten. Hierzu kann der Label-Aufnehmer zum Beispiel Mittel zum Ansaugen des Tails mittels Vakuum, ein oder mehrere Klemmvorrichtungen und/oder ein oder mehrere Abstandshalter aufweisen. Der Kontaktierungstail weist, insbesondere bei Betrachtung senkrecht auf eine von dem Label aufgespannte Ebene, bevorzugt eine geringere Fläche auf als der Rest des Labels.

Es ist möglich, dass ein oder mehrere der folgenden Schritte durchgeführt werden, insbesondere nach dem Aufeinanderlegen von Label und Träger, vorzugsweise nach dem vollständigen Aushärten und/oder vollständigen Vernetzen der ein oder mehreren Kleberschichten:
Entnehmen des Bauteils aus der Träger-Aufnahme,
Abziehen einer ersten Schutzschicht des Labels.

Es ist möglich, dass ein oder mehrere der folgenden Schritte durchgeführt werden, insbesondere vor dem Aufbringen des Klebstoffs und/oder vor dem Aufeinanderlegen von Label und Träger:
Vorbehandeln des Labels und/oder des Trägers, insbesondere durch Reinigung, Anströmen mit ionisierter Luft, Reinigung mit Chemikalien, z.B. mit Alkohol, PlasmaBehandlung und/oder Corona-Behandlung einer Oberfläche des Labels und/oder
einer Oberfläche des Trägers,
Abziehen einer zweiten Schutzschicht des Labels.

Die Vorrichtung weist bevorzugt eine Vorbehandlungs-Einheit zur Vorbehandlung des Labels und/oder des Trägers auf, beispielsweise durch Anströmen des Trägers mit ionisierter Luft und/oder durch eine Plasmabehandlung und/oder durch eine Coronabehandlung und/oder durch eine Reinigung mit Chemikalien, z.B. mit Alkohol. Die Vorbehandlungseinheit ist oder umfasst beispielsweise einzeln oder in Kombination: einen Ionisator und Mittel zum Anströmen des Trägers mit ionisierter Luft, eine Vorrichtung zur Plasmabehandlung, eine Vorrichtung zur Coronabehandlung, eine Vorrichtung zur Reinigung mit Chemikalien, z.B. mit Alkohol.

Durch das Vorbehandeln wird insbesondere zumindest die Oberfläche des Labels und/oder des Trägers vorbehandelt, welche anschließend mit den ein oder mehreren Kleberschichten in Kontakt gebracht wird. Die Vorbehandlung ist also vorzugsweise ein Reinigen oder ein Aktivieren der entsprechenden Oberfläche. So können z.B. eine verbesserte Benetzung durch den Klebstoff und/oder verbesserte Fließeigenschaften des Klebstoffs im Prozess und/oder eine verbesserte Haftkraft im Prozess und/oder im Endprodukt erreicht werden.

Der Label-Aufnehmer wird vorzugsweise vor dem vollständigen Aushärten und/oder vollständigen Vernetzen von dem Label abgelöst und/oder entfernt. Vor dem Entfernen und/oder Ablösen des Label-Aufnehmers von dem Label wird vorzugsweise das Vorhärten des Klebstoffs bzw. der ein oder mehreren Kleberschichten durchgeführt.

Es ist möglich, dass in den ein oder mehreren Kleberschichten ein oder mehrere blasenfrei umschlossene Störpartikel vorliegen und/oder eine blasenfrei mit ein oder mehreren Kleberschichten versehene Oberfläche des Trägers, welche Unebenheiten, Stufen, Vertiefungen und/oder Erhebungen aufweist, vorliegt. Es ist auch möglich, dass der Träger auf einer dem Label zugewandten Oberfläche eine gekrümmte Oberfläche und/oder Erhebungen und/oder Vertiefungen aufweist, insbesondere wobei die ein oder mehreren Kleberschichten eine der gekrümmten Oberfläche und/oder den Erhebungen und/oder den Vertiefungen folgende Schichtdickenvariation aufweisen. Ferner kann der Träger ein oder mehrere Erhebungen und/oder Vertiefungen, insbesondere zusätzliche Erhebungen und/oder Vertiefungen, aufweisen, die insbesondere in der Form zumindest eines Rahmens und/oder ein oder mehrerer Schnapper vorliegen. "Zusätzliche Erhebungen und/oder Vertiefungen" meint hier insbesondere, dass diese zusätzlich zu der mit den ein oder mehreren Kleberschichten versehenen Oberfläche des Trägers vorliegen. Insbesondere weist der Träger somit eine dreidimensionale Form auf. Trotz entsprechend komplexer Geometrien solcher Träger können diese insbesondere durch das erfindungsgemäße Verfahren dennoch zuverlässig mit einem Label versehen werden.

Im Folgenden wird die Erfindung anhand von mehreren Ausführungsbeispielen unter Zuhilfenahme der beiliegenden Zeichnungen beispielhaft erläutert. Dabei zeigen:
- Fig. 1a bis 1c: schematische Querschnitte eines Bauteils und dessen Komponenten,
- Fig. 2a bis 2c: schematische Zeichnungen von Bauteilen,
- Fig. 3a bis 3i: Verfahren und Vorrichtung zur Herstellung des Bauteils,
- Fig. 4a und 4b: schematische Querschnitte eines Bauteils und dessen Komponenten,
- Fig. 5: schematisch ein Verfahren zur Herstellung eines Bauteils,
- Fig. 6: schematisch eine Draufsicht auf ein Label mit Klebstoff,
- Fig. 7a bis 7c: schematisch eine Draufsicht auf ein Label und Querschnitte davon,
- Fig. 8a bis 8g: schematische Querschnitte von Labeln.

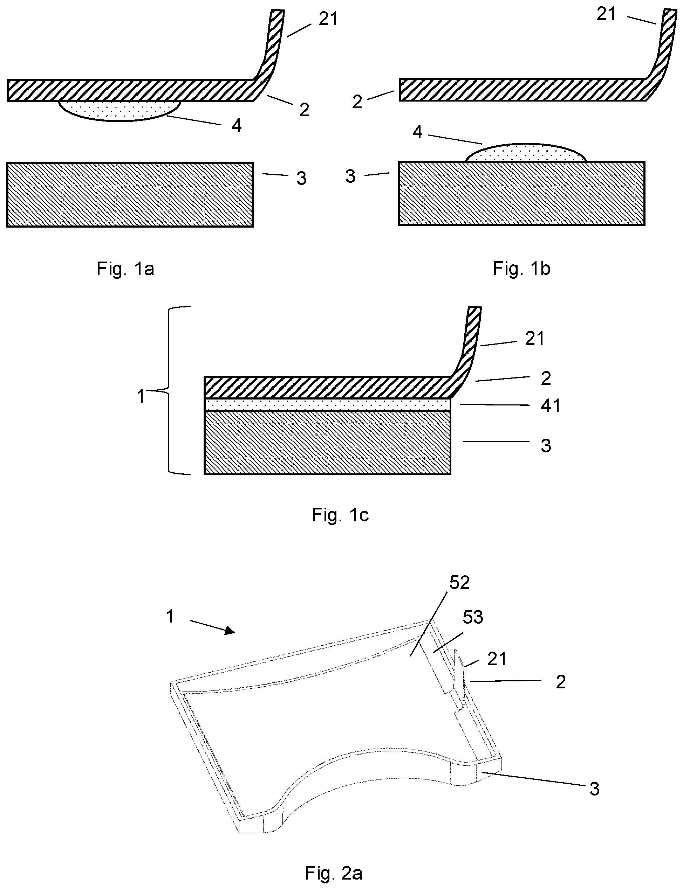

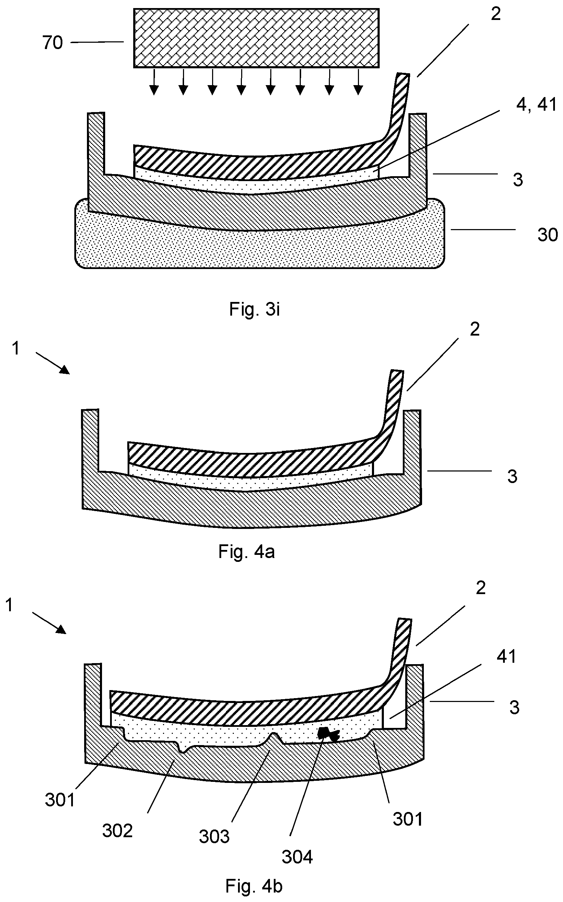

Fig. 1a und Fig. 1b zeigen schematische Querschnitte der Komponenten eines beispielhaften Bauteils 1 vor dem Aufeinanderlegen von Label 2 und Blende 3 anhand von schematischen Querschnitten durch das Label 3, den Klebstoff 4 sowie durch den Träger 3. Fig. 1c zeigt schematisch einen Querschnitt durch ein beispielhaftes Bauteil 1 mit dem Label 2, der Kleberschicht 41 und dem Träger 3. Wie durch Fig. 1a bis 1c beispielhaft veranschaulicht ist, ist es möglich, dass der Kleber von den ein oder mehreren ersten definierten Formen, beispielsweise der in Fig. 1a oder Fig. 1b gezeigten Form, durch das Aufeinanderlegen von Label 2 und Träger 3 zu ein oder mehreren zweiten definierten Formen, wie der Form der Kleberschicht 41, verdrängt wird, so dass sich daraus die ein oder mehreren Kleberschichten, insbesondere die Kleberschicht 41, ergibt. Durch das Fließen des Klebstoffs 4 bei diesem Vorgang können insbesondere Erhebungen und Vertiefungen, bevorzugt mit kleinen Krümmungsradien, mit Klebstoff 4 gefüllt werden und/oder Störpartikel, bevorzugt ohne Blasenbildung, umschlossen werden. Dies ist beispielhaft in Fig. 4b veranschaulicht und dazu näher beschrieben.

Vorteilhafterweise ist es möglich, ein automatisiertes Verfahren durchzuführen und/oder eine Vorrichtung zur Durchführung des automatisierten Verfahrens einzusetzen. Dabei ist insbesondere zumindest das Aufeinanderlegen von Label 2 und Träger 3 automatisiert durchführbar oder wird automatisiert durchgeführt.

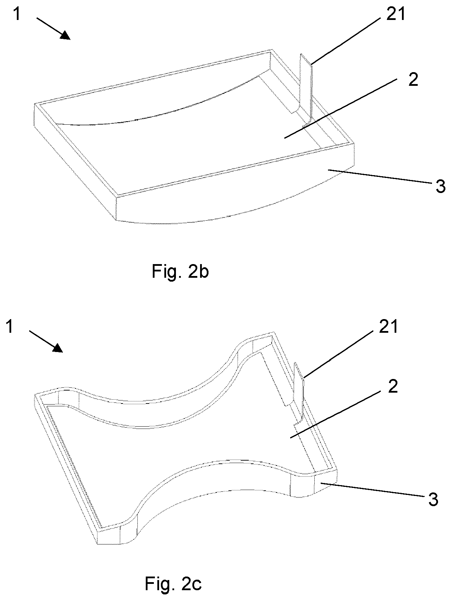

Fig. 2a bis 2c zeigen beispielhafte Bauteile 1. Wie dort gezeigt ist, ist es möglich, dass der Träger 3 eine komplexe Geometrie aufweist. Der Träger 3 weist beispielsweise eine zylinderförmige Krümmung, insbesondere eine sogenannte 2,5D-Form, auf. Insbesondere ist es möglich, dass der Träger 3 zusätzlich einen Rahmen aufweist. Es ist also insbesondere möglich, dass der Träger 3 eine 3D-Form mit einer mit dem Label 2 zu beschichtenden 2,5D-Fläche aufweist. Es ist jedoch auch denkbar, dass der Träger 3 eben und flach ausgestaltet ist, zum Beispiel in Form eines Glassubstrats. Es ist möglich, dass der Träger 3 durch Kunststoff-Spritzguss hergestellt ist oder wird. Es ist zudem möglich, dass der Träger 3 bereichsweise oder vollflächig transparent, opak, teil-transparent und/oder nichttransparent ist. Insbesondere kann der Träger 3 ein oder mehrere transparente Fenster, beispielsweise für ein Display, und/oder ein oder mehrere musterförmige transparente Bereiche, beispielsweise symbolförmige Bereiche, insbesondere für Buttons, aufweisen. Vorteilhaft ist es daher, wenn der Klebstoff und/oder die ein oder mehreren Kleberschichten die Transparenz zweckmäßigerweise nicht beeinflussen.

Der Träger 3 weist bevorzugt eine maximale Wandstärke in einem Bereich von 0,15 mm bis 10 mm, insbesondere von 1 mm bis 5 mm, auf. Es ist möglich, dass der Träger 3 eine solche maximale Wandstärke nur in Teilbereichen aufweist oder in sämtlichen Bereichen aufweist. Insbesondere bei geringen Wandstärken fällt der Vorteil einer geringen thermischen und mechanischen Belastung besonders ins Gewicht.

Bei einem bevorzugten Ausführungsbeispiel weist der Träger 3 einen Rahmen oder andere Erhöhungen (z.B. Befestigungselemente) mit einer Höhe von höchstens 100 mm, bevorzugt von höchstens 50 mm, besonders bevorzugt von höchstens 20 mm auf. Hierbei wird insbesondere trotz einer vergleichsweise schlechten Handhabung aufgrund eines vorteilhafterweise automatisierten Verfahrens bzw. einer vorteilhafterweise automatisierten Vorrichtung eine schnelle, sichere und reproduzierbare Verarbeitung gewährleistet.

Es ist auch möglich, dass der Träger 3 vorderseitig und/oder rückseitig dekoriert ist. Es ist auch möglich, dass das Bauteil 1 nach dem Aufbringen des Labels 2 auf den Träger 3 vorderseitig und/oder rückseitig dekoriert wird.

Wie außerdem durch die Fig. 2a bis 2c veranschaulicht ist, ist es möglich, dass der optionale Kontaktierungstail 21 frei von Klebstoff 4 und Material des Trägers 3 ist. Mit dem Kontaktierungstail 21 kann somit beispielsweise eine Kopplung zu einem elektronischen Bauteil erfolgen bzw. das Bauteil 1 in ein elektronisches Bauteil integriert werden.

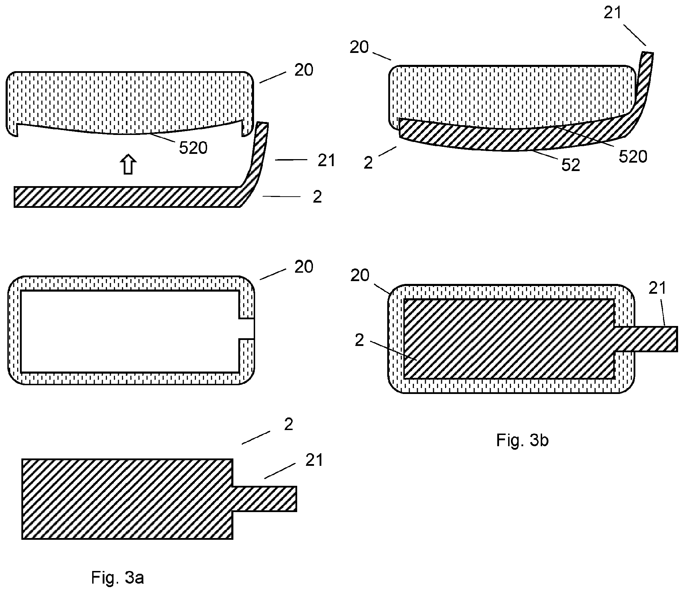

Bevorzugt weist der Träger 3 zumindest eine gekrümmte Oberfläche auf, welche in Fig. 2a beispielsweise in dem Krümmungsbereich 53 liegt. In diesem Beispiel ist der Krümmungsbereich 53 durch den Rahmen des Bauteils 1 bzw. des Trägers 3 begrenzt. In dem Bereich Krümmungsbereich 53 ist dabei das Label 2 aufgebracht, welches ebenfalls eine gekrümmte Oberfläche aufweist, die in dem Krümmungsbereich 52 des Labels vorliegt. Der Krümmungsbereich 52 des Labels kann dabei das gesamte Label 2 bedecken, oder wie z.B. in Fig. 2a zu sehen ist, nur einen Teilbereich des Labels 2 bedecken. Die gekrümmte Oberfläche des Trägers 3 liegt dabei beispielsweise schon bei Bereitstellung des Trägers 3 vor. Die gekrümmte Oberfläche des Labels 2 wird vorzugsweise erst durch die Aufnahme des Labels 2 mit dem Label-Aufnehmer 20 gebildet, wie dies beispielsweise durch Fig. 3a und 3b veranschaulicht ist.

Wie insbesondere durch Fig. 2a und Fig. 2c veranschaulicht ist, ist es beispielsweise möglich, dass das Label 2 und/oder der Träger 3 keine rein rechteckige oder keine rein runde Kontur aufweist. Es ist auch möglich, dass das Label 2 und/oder der Träger 3 eine Fläche, insbesondere bei Betrachtung senkrecht auf eine von dem Label 2 und/oder dem Träger 3 aufgespannte Ebene und/oder bei Vernachlässigung der Dicke des Labels 2 und/oder des Trägers 3, aufweist, welche zumindest bereichsweise eine Kontur eines Teils oder Ganzen ein oder mehrerer der folgenden Formen umfasst: Kreis, Ellipse, Dreieck, Rechteck, alphanumerisches Zeichen, Fraktalform. In Draufsicht auf das durch Fig. 2a beispielhaft gezeigte Label 2 wäre beispielsweise eine Kontur aus einem Teil eines Rechtecks und einem Teil eines Kreises oder einer Ellipse zu sehen. Nicht durch Fig. 2a bis 2c veranschaulicht, aber auch möglich, ist, dass der Träger 3 zusätzlich Erhebungen und/oder Vertiefungen und/oder Aussparungen aufweist und das Label 2 beispielsweise durch Verformungen, die insbesondere durch den Label-Aufnehmer 20 bewirkt werden, oder durch in dem Label vorhandene Aussparungen an einen solchen Träger 3 angepasst ist oder wird. Die Kontur von Label 2 und/oder Träger 3 kann also zumindest bereichsweise auch von Aussparungen gebildet sein. Es ist auch möglich, dass ein oder mehrere Erhebungen und/oder Vertiefungen, die in dem Träger 3 vorliegen, von dem Klebstoff 4 ausgefüllt werden, wobei das Label 2 beispielsweise eine gekrümmte Oberfläche aufweist, die auf eine Gesamtheit von Krümmung, Vertiefungen und/oder Erhebungen des Trägers 3 angepasst ist oder wird, wie dies beispielsweise in Fig. 4b zu sehen ist.

Fig. 3a bis 3i zeigen schematisch die Schritte eines beispielhaften Verfahrens zur Herstellung des Bauteils 1 mittels einer Vorrichtung. Die Vorrichtung weist einen Label-Aufnehmer 20, einen Träger-Aufnehmer 30 sowie eine Klebstoffausgabe-Einheit 40 auf. Bei dem beispielhaften Verfahren werden die nachfolgenden Schritte durchgeführt, vorzugsweise in der angegebenen Reihenfolge.

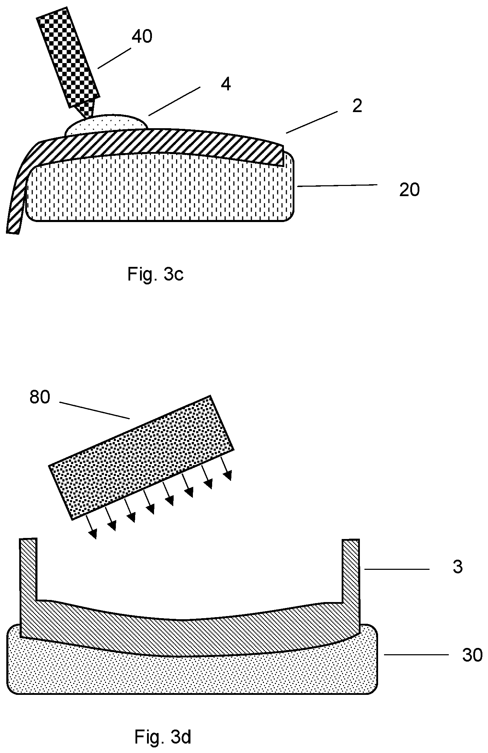

Die nachfolgend beschriebenen Schritte a1) und a2) sowie b1 und b2) sind beispielhaft durch Fig. 3a und Fig. 3b sowie Fig. 3c veranschaulicht. Fig. 3a zeigt dabei in den unteren beiden Abbildungen eine Draufsicht auf den Label-Aufnehmer 20 und eine Draufsicht auf das Label 2. Fig. 3b zeigt in der unteren Abbildung eine Draufsicht auf den Label-Aufnehmer mit dem Label 2.

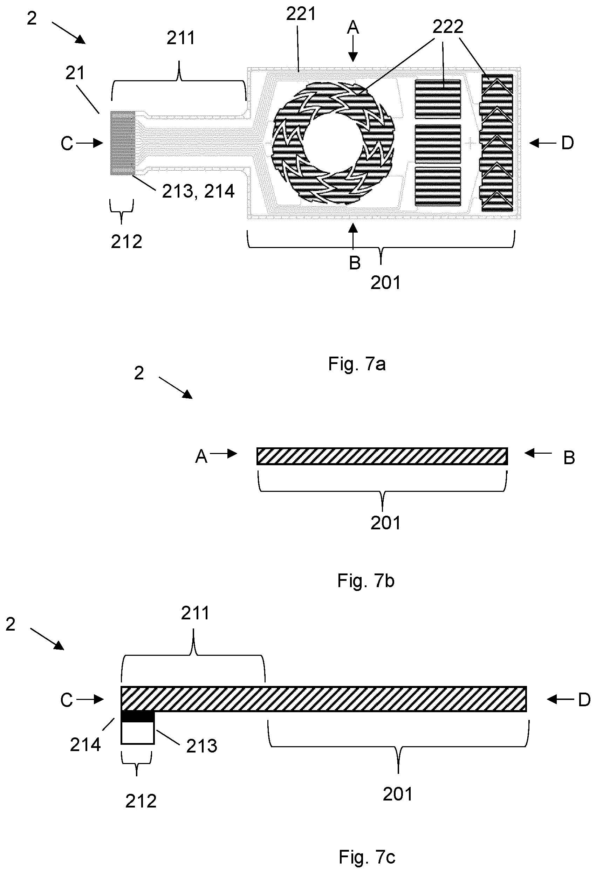

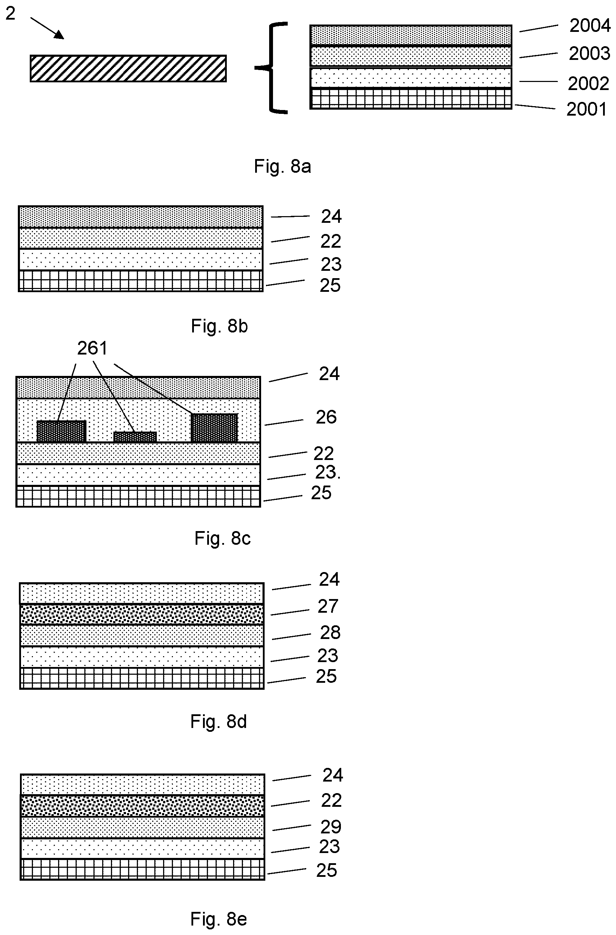

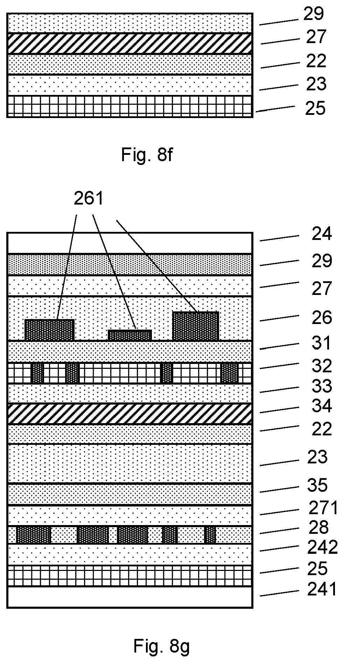

Schritt a1) Bereitstellen eines Labels 2. Das Label 2 weist einen flexiblen Schichtaufbau auf. Das Label 2 umfasst zumindest eine Trägerschicht, wie die Trägerschicht 23, und umfasst zudem eine weitere Schicht, wie zum Beispiel die elektrisch leitfähige Funktionsschicht 22, wobei die Trägerschicht 23 und die Funktionsschicht 22 beispielsweise anhand einer der Fig. 4a, 4b, 8a bis 8g veranschaulicht sind. Es ist alternativ zu der weiteren Schicht, insbesondere zu der Funktionsschicht 22, oder zusätzlich dazu möglich, dass das Label 2 ein oder mehrere elektrische und/oder elektronische und/oder optische und/oder optoelektronische Bauelemente aufweist, wie diese beispielhaft anhand der Bauelemente 261 der Fig. 8c oder 8g veranschaulicht sind. Das Label kann ferner insbesondere aufgebaut sein, wie dies beispielsweise zu Fig. 7a bis 7c und Fig. 8a bis 8g näher beschrieben ist. Optional weist das Label 2 einen Kontaktierungstail 21 auf. Mögliche Ausgestaltungen des Kontaktierungstails sind beispielsweise zu Fig. 7a bis 7c näher beschrieben ist.

Schritt a2) Aufnahme des Labels 2 mit dem Label-Aufnehmer 20.

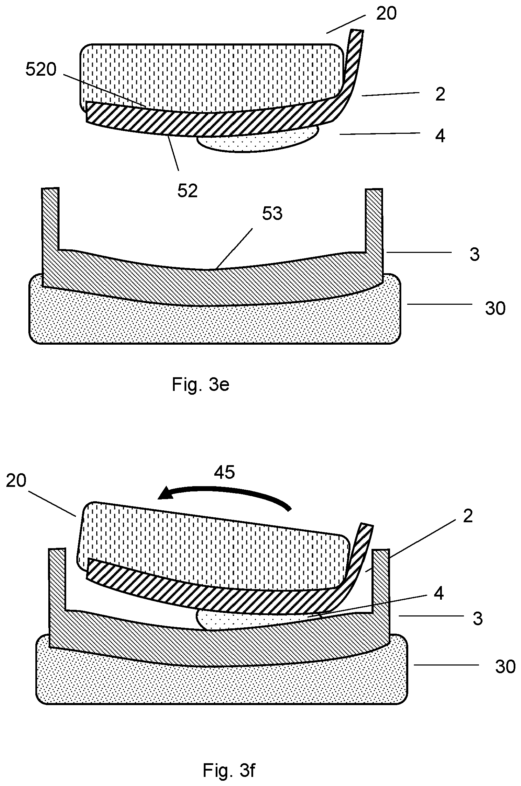

Das in Fig. 3a gezeigte Label 2 kann beispielsweise manuell und/oder mittels Roboterarm, insbesondere in bzw. aus einem Magazin bereitgestellt werden. Nach dem Bereitstellen wird durch den Label-Aufnehmer 20, insbesondere durch Mittel zum Erzeugen eines Vakuums, die von dem Label-Aufnehmer 20 aufgewiesen werden, beispielsweise ein Vakuum erzeugt, so dass das Label 2 vom Label-Aufnehmer 20 angesaugt wird. Wie durch Fig. 3a und 3b veranschaulicht ist, ist es möglich, dass der Label-Aufnehmer 20 eine an die Form des Labels 2 angepasste Passform aufweist. Bei der Aufnahme des Labels 2 ist es bevorzugt möglich, dass das Label 2 gekrümmt wird und eine der Kontur des Label-Aufnehmers 20 folgende Form annimmt. Hierzu kann mittels des Label-Aufnehmers 20 beispielsweise ein Vakuum erzeugt werden, welches das Label 2 ansaugt. Der Label-Aufnehmer 20 weist in diesem Beispiel den Krümmungsbereich 520 auf, welcher eine gekrümmte Oberfläche umfasst. Indem das Label 2 in diesem Bereich 520 aufgenommen wird, insbesondere angesaugt wird, wird das Label 2 verformt und der Krümmungsbereich 52 des Labels 2 mit einer entsprechenden gekrümmten Oberfläche ausgebildet. Die gekrümmte Oberfläche des Labels 2 in dem Krümmungsbereich 52 ist insbesondere abhängig von einer gekrümmten Oberfläche des Trägers 3 angepasst, wie diese beispielsweise in dem Krümmungsbereich 53 des Trägers vorliegt. Beispielhaft sind derartige Krümmungsbereiche auch Fig. 2a bis Fig. 2c beschrieben. Somit kann durch eine definierte Relativbewegung, wie diese beispielhaft zu Fig. 3f näher beschrieben ist, der zwischen Label 2 und Träger 3 vorgesehene Klebstoff 4 kontrolliert verdrängt werden und die ein oder mehreren Kleberschichten, insbesondere die Kleberschicht 41, ausgebildet werden.

Es ist auch möglich, dass der Label-Aufnehmer 20 zur Aufnahme des Labels 2 alternativ oder zusätzlich zu den Mitteln zur Erzeugung eines Vakuums, beispielsweise eine mechanische Halterung und/oder eine Klemmung aufweist.

Vorzugsweise ist der Label-Aufnehmer 20 mit einem Robotersystem verbunden, welches die Bewegung des Label-Aufnehmers 20 zu verschiedenen Positionen zur Durchführung der jeweiligen Schritte ermöglicht. Bezüglich des Robotersystems ist insbesondere auf obige Ausführungen verwiesen.

Das Bereitstellen des Labels 2 erfolgt vor der Aufnahme des Labels 2 mit dem Label-Aufnehmer 20. Das Bereitstellen des Trägers 3 erfolgt vor der Aufnahme des Trägers 3 mit dem Träger-Aufnehmer 30, wobei es möglich ist, dass zuerst die Aufnahme des Labels 2 oder zuerst die Aufnahme des Trägers 3 oder beides simultan durchgeführt wird.

Fig. 3c veranschaulicht ein Beispiel für den nachfolgend beschriebenen Schritt c). Schritt c) Aufbringen eines fließfähigen Klebstoffs 4 mittels der Klebstoffausgabe-Einheit 40 in ein oder mehreren ersten definierten Formen auf das mittels des Label-Aufnehmers 20 gehaltene Label 2. Zu Fig. 6 sind beispielhafte definierte Formen des Klebstoffs 4 beschrieben. Es ist alternativ möglich, den Klebstoff 4 auf den mittels des Träger-Aufnehmers 30 gehaltenen Träger 3 aufzubringen. Wie durch Fig. 3c veranschaulicht ist, ist es bevorzugt möglich, dass die Klebstoffausgabe-Einheit 40 zumindest eine Düse und/oder zumindest einen Dispenser zum Aufbringen des Klebstoffs 4 aufweist. Bevorzugt wird der Label-Aufnehmer 20 insbesondere mittels eines Robotersystem zu der Klebstoffauftrags-Einheit 40 geführt. Insbesondere wird dann zum Aufbringen des Klebstoffs 4 der Label-Aufnehmer 20 entsprechend einer aufzubringenden Form, vorzugsweise den ein oder mehreren ersten definierten Formen, des Klebstoffs 4 bewegt während die Klebstoffausgabe-Einheit 40 den Klebstoff 4 auf das Label 2 ausgibt und dabei bevorzugt bewegungslos gehalten wird. Es ist auch denkbar, dass die Klebstoffausgabe-Einheit 40 entsprechend einer aufzubringenden Form, vorzugsweise den ein oder mehreren ersten definierten Formen, des Klebstoffs 4 bewegt wird während die Klebstoffausgabe-Einheit 40 den Klebstoff 4 auf das Label 2 ausgibt und der Label-Aufnehmer 20 dabei vorzugsweise bewegungslos gehalten wird.

Fig. 3d) zeigt den auf dem Träger-Aufnehmer 30 aufgenommenen Träger 3 mit einer optionalen Vorbehandlungseinheit 80. Hiermit sind beispielhaft die nachfolgenden Beispiele der Schritte b1) und b2) veranschaulicht.

Schritt b1) Bereitstellen eines Trägers 3. Der Träger 3 ist beispielsweise aufgebaut, wie dies näher zu einer der Fig. 2a bis 2c, 7a bis 7c und 8a bis 8g beschrieben ist. Die Bereitstellung des Trägers 3 erfolgt beispielsweise mittels eines manuellen Ablegens auf dem Träger-Aufnehmer 30 und/oder mittels eines Ablegens auf dem Träger-Aufnehmer 30 durch einen Roboterarm.

Schritt b2) Aufnahme des Trägers 3 mittels des Träger-Aufnehmers 30.

Fig. 3d veranschaulicht zusätzlich einen optionalen Schritt x1), welcher bevorzugt vor dem Schritt d) durchgeführt wird.

Schritt x1) Vorbehandeln des Trägers 3 mittels einer Vorbehandlungs-Einheit 80, beispielsweise durch Anströmen des Trägers 3 mit ionisierter Luft und/oder durch eine Plasmabehandlung und/oder eine Coronabehandlung und/oder durch eine chemische Reinigung, z.B. mit Alkohol. Die Vorbehandlungs-Einheit 80 ist oder umfasst beispielsweise einzeln oder in Kombination: einen Ionisator und Mittel zum Anströmen des Trägers 3 mit ionisierter Luft, eine Vorrichtung zur Plasmabehandlung, eine Vorrichtung zur Coronabehandlung, eine Vorrichtung zur Reinigung mit Chemikalien, z.B. mit Alkohol.

Fig. 3e und Fig. 3f zeigen ein Beispiel für den nachfolgend beschriebenen Schritt d).

Schritt d) Aufeinanderlegen von Label 2 und Träger 3 mittels einer definierten Relativbewegung von Label-Aufnehmer 20 und Träger-Aufnehmer 30, derart dass der Klebstoff 4 zwischen Label 2 und Träger 3 angeordnet wird und zwischen Label 2 und Träger 3 ein oder mehrere Kleberschichten, insbesondere die Kleberschicht 41, vorzugsweise in ein oder mehreren zweiten definierten Formen, erhalten werden. Hierbei können, insbesondere bei komplexen Geometrien des Trägers 3, die ein oder mehreren ersten definierten Formen des Klebstoffs 4 und die Relativbewegung von Label 2 und Träger 3 gezielt aufeinander abgestimmt werden, so dass sich daraus die ein oder mehreren Kleberschichten, insbesondere die Klebersicht 41, ergibt. Die Relativbewegung umfasst in dem durch Fig. 3f gezeigten Beispiel vorzugsweise eine rotatorische Bewegung. Insbesondere ist die Relativbewegung eine optionale Wipp-Bewegung. Die Bewegung ist durch den Pfeil 45 angedeutet. Diese Relativbewegung ermöglicht vorteilhafterweise ein gerichtetes und/oder definiertes Verdrängen des fließfähigen Klebstoffs 4. Spezifische optionale Ausführungen der ein oder mehreren definierten ersten Formen des Klebstoffs und der Relativbewegung sind insbesondere zu Fig. 6 beschrieben. Das Aufeinanderlegen von Label 2 und Träger 3 erfolgt vorzugsweise derart, dass die ein oder mehreren Kleberschichten, insbesondere die Kleberschicht 41, mit einer Mindestdicke von 5 µm zwischen dem Label 2 und dem Träger 3 angeordnet sind oder werden.

Wie beispielhaft anhand eines Vergleichs von Fig. 3e und 3f mit Fig. 4a und 4b veranschaulicht ist, ist es möglich, dass die ein oder mehreren ersten definierten Formen von ein oder mehreren ersten Schichten des Klebstoffs 4 gebildet werden, wobei diese ein oder mehreren ersten Schichten des Klebstoffs teilflächig aufgebracht werden und beim Aufeinanderlegen von Label 2 und Träger 3 ein Verdrängen des Klebstoffs 4 zu einer höheren Flächenbelegung und/oder einer vollflächigen Flächenbelegung führt. Durch das Verdrängen des Klebstoffs 4 werden so vorteilhafterweise blasenfreie und gleichmäßig verteilte ein oder mehrere Kleberschichten, insbesondere die Kleberschicht 41, erhalten.

Bevorzugt wird der Label-Aufnehmer 20 insbesondere mittels eines Robotersystem zu dem Träger-Aufnehmer 30 geführt, insbesondere als ein Teil der definierten Relativbewegung von Label 2 und/oder Träger 3 oder sodann die definierte Relativbewegung durchgeführt und/oder fortgeführt.

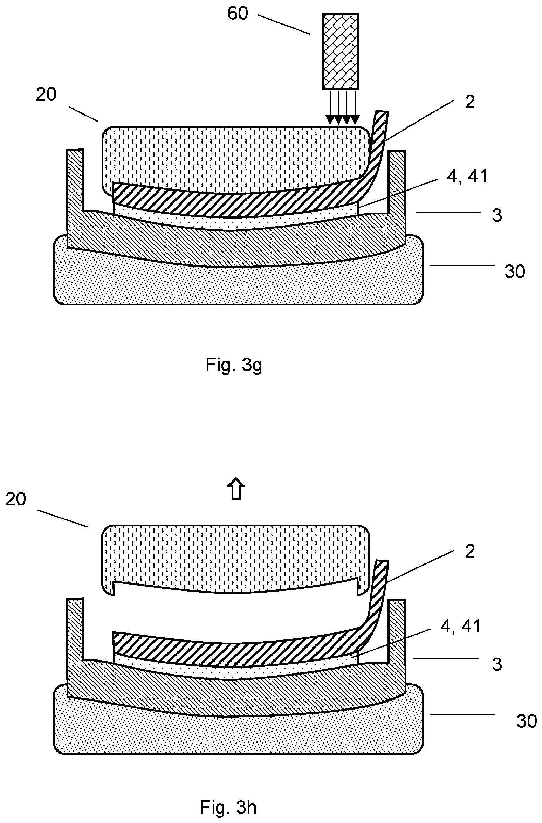

Fig. 3g zeigt ein Beispiel eines nachfolgend beschriebenen optionalen Schritts x2).

Schritt x2) teilflächiges Vorhärten der ein oder mehreren Kleberschichten.

Es ist möglich, dass die Vorrichtung eine wie in Fig. 3g beispielhaft gezeigte Vorhärtungs-Einheit 60 zum partiellen Vorhärten der ein oder mehreren Kleberschichten, insbesondere während der Label-Aufnehmer 20 in Kontakt mit dem Label 2 steht, aufweist. Die Vorhärtungs-Einheit 60 ist bevorzugt eine Bestrahlungseinheit, insbesondere zur Bestrahlung mit UV-Strahlung, vorzugsweise UV-A, UV-B und/oder UV-C Strahlung, und/oder mit sichtbarem Licht und/oder mittels IR-Strahlung. Insbesondere ist für das durch Fig. 3g veranschaulichte Beispiel ein UV-Strahler mit einer fokussierten Bestrahlung bevorzugt. Es ist auch denkbar, dass das Vorhärten vollflächig durchgeführt wird, indem der Label-Aufnehmer 20 vollständig transparent für die entsprechende Bestrahlung ausgebildet ist. Insbesondere weist der Label-Aufnehmer zumindest ein oder mehrere transparente, vorzugsweise UV-transparente, Bereiche und/oder ein oder mehrere Löcher auf, und/oder die ein oder mehreren Kleberschichten, insbesondere die Kleberschicht 41, werden durch die ein oder mehreren transparenten Bereiche und/oder Löcher hindurch bestrahlt oder sind durch diese hindurch bestrahlbar, insbesondere während der Label-Aufnehmer 20 noch in Kontakt mit dem Label 2 steht. Es ist also möglich, dass die Strahlung der Vorhärtungs-Einheit 60 also bevorzugt die transparenten Bereiche und/oder die Löcher durchtritt bevor die Strahlung auf die ein oder mehreren Kleberschichten, insbesondere die Kleberschicht 41, auftrifft. Dies ermöglicht es vor der Abnahme des Labels 2 von dem Label-Aufnehmer 20 die Haftung zwischen Label 2 und Träger 3 zu erhöhen. So kann insbesondere ein sicheres, zuverlässiges und die ein oder mehreren Kleberschichten schonendes Abnehmen des Label-Aufnehmers 20 von dem Label 2 durchgeführt werden. Vorzugsweise sind oder werden die ein oder mehreren Kleberschichten, insbesondere die Kleberschicht 41, durch das Vorhärten zumindest bereichsweise noch nicht vollständig ausgehärtet bzw. noch nicht vollständig vernetzt. Hiermit kann vorteilhafterweise schon eine ausreichende Fixierung für ein sicheres Abnehmen des Label-Aufnehmers 20 erreicht werden.

Fig. 3h zeigt ein Beispiel eines nachfolgend beschriebenen optionalen Schritts x3).

Schritt x3) Ablösen des Labels 2 vom Label-Aufnehmer 20.

Hierzu wird der Label-Aufnehmer 20 vom Label 2 wegbewegt. Dabei ist es zum Beispiel möglich, dass am Label-Aufnehmer 2 das Vakuum aufgegeben und/oder ein Druck erhöht wird.

Fig. 3i) zeigt beispielhaft den nachfolgend beschriebenen Schritt e).

Schritt e) zumindest teilweises Härten und/oder zumindest teilweises Vernetzen der ein oder mehreren Kleberschichten, insbesondere der Kleberschicht 41.

Hierbei ist es möglich, dass das Härten mittels Bestrahlung, vorzugsweise UV-Strahlung, bevorzugt UV-A und/oder UV-B und/oder UV-C Strahlung, und/oder mit sichtbarem Licht und/oder IR-Strahlung durchgeführt wird, wie dies insbesondere durch Fig. 3i) veranschaulicht ist. Es ist jedoch auch denkbar, dass der Klebstoff 4 bzw. die daraus gebildeten ein oder mehreren Kleberschichten, insbesondere die Kleberschicht 4, selbsthärtend sind, vorzugsweise, so dass der Schritt des Härtens und/oder Vernetzens beispielsweise durch Warten durchgeführt werden kann und/oder sich von selbst in Gang setzt, bevorzugt sobald der Klebstoff 4 aufgebracht ist.

Nach dem Härten kann das hergestellte Bauteil 1 aus der Vorrichtung entnommen werden.

Die erfindungsgemäße Vorrichtung zur Herstellung des Bauteils 1 dient bevorzugt zur Durchführung des Verfahrens und/oder ist dazu konfiguriert. Wie beispielsweise durch die Fig. 3a) bis 3i) gezeigt und dazu beschrieben ist, umfasst die Vorrichtung: den Label-Aufnehmer 20 zur Aufnahme des Labels 2. Das Label 2 weist einen flexiblen Schichtaufbau auf. Das Label umfasst zumindest eine Trägerschicht, wie zum Beispiel die Trägerschicht 23 und eine weitere Schicht, wie zum Beispiel die elektrisch leitfähige Funktionsschicht 22. Es ist alternativ zu der weiteren Schicht, insbesondere zu der Funktionsschicht 22, oder zusätzlich dazu möglich, dass das Label 2 ein oder mehrere elektrische und/oder elektronische und/oder optische und/oder optoelektronische Bauelemente, wie beispielhaft die Bauelemente 261 aufweist. Optional weist das Label 2 einen Kontaktierungstail 21 auf. Das Label 2 kann ferner insbesondere aufgebaut sein, wie dies beispielsweise zu Fig. 7a bis 7c und Fig. 8a bis 8g näher beschrieben ist. Zudem umfasst die Vorrichtung den Träger-Aufnehmer 30 zur Aufnahme des Trägers 3 und eine Klebstoffausgabe-Einheit 40 zum Aufbringen des fließfähigen Klebstoffs 4 mittels der Klebstoffausgabe-Einheit 40 in ein oder mehreren ersten definierten Formen auf das Label 2. Es ist alternativ oder zusätzlich auch möglich, dass mittels der Klebstoffausgabe-Einheit 40 der fließfähige Kleber 4 in ein oder mehreren ersten definierten Formen auf den Träger 3 aufbringbar ist. Die Vorrichtung ist dabei derart konfiguriert, dass ein Aufeinanderlegen von Label 2 und Träger 3 mittels einer definierten Relativbewegung von Label-Aufnehmer 20 und Träger-Aufnehmer 30 durchführbar ist. Durch diese Relativbewegung ist eine Anordnung des Klebstoffs 4 zwischen Label 2 und Träger 3 möglich, derart dass zwischen Label 2 und Träger 3 ein oder mehrere Kleberschichten, vorzugsweise die Kleberschicht 41, insbesondere in ein oder mehreren zweiten definierten Formen, erhältlich sind.

Es ist auch möglich, dass die Vorrichtung eine optionale Härtungs-Einheit 70 zum zumindest teilweise Härten der ein oder mehreren Kleberschichten, vorzugsweise der Kleberschicht 41, aufweist.

Fig. 4a und 4b zeigen schematische Beispiele eines Querschnitts eines hergestellten Bauteils 1.

Fig. 4a zeigt beispielsweise einen schematischen Querschnitt durch ein wie zu Fig. 2a bis 2c beschriebenes Bauteil 1. Das Label 2 weist dabei beispielsweise eine zu dem Träger 3 komplementäre gekrümmte Oberfläche auf. Ein wie beispielhaft mittels Fig. 4b veranschaulichtes Bauteil 1 weist zusätzlich zu zumindest einer gekrümmten Oberfläche insbesondere Vertiefungen und/oder Erhebungen auf. Es ist also auch möglich, dass ein oder mehrere Erhebungen und/oder Vertiefungen, die in dem Träger 3 vorliegen, von dem Klebstoff 4 ausgefüllt werden, wobei das Label 2 beispielsweise eine gekrümmte Oberfläche aufweist, die auf eine Gesamtheit von Krümmung, Vertiefungen und/oder Erhebungen des Trägers 3 angepasst ist oder wird. Hierbei ist oder wird insbesondere eine Schichtdickenvariation der ein oder mehreren Kleberschichten, insbesondere der Kleberschicht 41, gebildet, welche sich bevorzugt infolge des Verdrängens bei der Relativbewegung von Label 2 und Träger 3 ergibt.

Wie durch beispielhaft Fig. 4a und Fig. 4b gezeigt ist, ist also ein Bauteil 1 möglich, das vorzugsweise hergestellt mittels des erfindungsgemäßen Verfahrens und/oder mittels der erfindungsgemäßen Vorrichtung ist oder wird. Das Bauteil 1 umfasst ein Label 2. Das Label 2 umfasst zumindest eine Trägerschicht, wie die Trägerschicht 23, und eine weitere Schicht, wie die elektrisch leitfähige Funktionsschicht 22.

Alternativ oder zusätzlich zur weiteren Schicht umfasst das Label 2, ein oder mehrere elektrische und/oder elektronische und/oder optische und/oder optoelektronische Bauelemente, wie die Bauelemente 261. Ferner umfasst das Bauteil 1 einen Träger 3 sowie ein oder mehrere Kleberschichten, wie die Kleberschicht 41, welche zwischen dem Label 2 und dem Träger 3 angeordnet sind. Dabei sind die ein oder mehreren Kleberschichten, wie die Kleberschicht 41, als fließfähiger Klebstoff 4 aufgebracht, dann durch eine definierte Relativbewegung von Label 2 und Träger 3 verdrängt und anschließend ausgehärtet und vernetzt. Der Träger 3 weist hierbei eine insbesondere komplexe Form auf, indem die zu beschichtende Oberfläche beispielsweise Stufen 301, eine Vertiefung 302 sowie eine Erhöhung 303 aufweist. Insbesondere durch die Anordnung zwischen Label 2 und Träger 3 und dem Aufbringen des Klebers 4 in fließfähiger Form mit der anschließenden Verdrängung sind die ein oder mehreren Kleberschichten somit derart auf der beschichteten Oberfläche des Trägers 3 verteilt, dass die Erhebungen 303 und Vertiefungen 301 sowie die Radien an den Stufen 301 vollständig ausgefüllt sind, was insbesondere durch eine Schichtdickenvariation der Kleberschicht 41 erreicht wird, die sich vorzugsweise aufgrund der Fließfähigkeit des Klebstoffs 4 beim Aufeinanderlegen von Label 2 und Träger 3 ergibt. Zudem ist zwischen Label 2 und Träger 3 ein Störpartikel 304 angeordnet. Vorteilhafterweise ist dieses Störpartikel 304 ohne Blasenbildung von dem Klebstoff 4 bzw. den daraus erhaltenen ein oder mehreren Kleberschichten, insbesondere der Kleberschicht 41 umschlossen. Wie hierdurch veranschaulicht ist, ist es also möglich, dass in den ein oder mehreren Kleberschichten ein oder mehrere blasenfrei umschlossene Störpartikel vorliegen und/oder eine blasenfrei mit ein oder mehreren Kleberschichten versehene Oberfläche des Trägers, welche Unebenheiten, Stufen, Vertiefungen und/oder Erhebungen aufweist, vorliegt. Bevorzugt weist dabei die Kleberschicht 41 eine Dicke auf, die mindestens 30% größer ist als die jeweils auszugleichende Struktur (hier beispielhaft: Stufe 301, Vertiefung 302, Erhöhung 303, Störpartikel 304) hoch bzw. tief ist.

Fig. 5 zeigt ein Beispiel für ein Verfahren mit den Schritten, insbesondere in der angegebenen Reihenfolge:
Schritt 1001: Bereitstellen des Labels 2, welches einen flexiblen Schichtaufbau aufweist und bevorzugt eine Sensorfolie ist oder umfasst, manuell und/oder mittels Roboterarm, insbesondere in bzw. aus einem Magazin und des Trägers 3 mittels eines manuellen Ablegens auf dem Träger-Aufnehmer und/oder mittels eines Ablegens auf dem Träger-Aufnehmer durch einen Roboterarm.
Schritt 1002: Optional Vorbehandeln des Trägers, beispielsweise mittels Behandlung mit ionisierter Luft, Coronabehandlung und/oder Plasmabehandlung und/oder Reinigung mit Chemikalien, z.B. mit Alkohol.
Schritt 1003: Aufnahme des Labels 2 mittels des Label-Aufnehmers 20, insbesondere durch Ansaugen mittels Vakuums,
Schritt 1004: Aufbringen des fließfähigen Klebstoffs 4 auf das Label 2
Schritt 1005: Auflegen des Labels 2 auf den Träger 3, insbesondere mittels einer Bewegung des Label-Aufnehmers 20.
Schritt 1006: Optional Vorhärten des Klebstoffs 4 oder der draus erhaltenen ein oder mehreren Kleberschichten, insbesondere der Kleberschicht 41, vorzugsweise wobei das Vorhärten nur in einem Teilbereich stattfindet und/oder mittels Bestrahlung durch den Label-Aufnehmer 20 und/oder ein oder mehrere Löcher des Label-Aufnehmers 20 hindurch stattfindet.
Schritt 1007: Entfernen des Label-Aufnehmers 20 vom Label 2, insbesondere durch eine Bewegung des Label-Aufnehmers 20.
Schritt 1008: Aushärten und/oder vollständiges Vernetzen der ein oder mehreren Kleberschichten, insbesondere der Kleberschicht 41.
Schritt 1009: Optional Entnehmen des Bauteils 1 aus der Träger-Aufnahme 30, beispielsweise manuell, mittels Roboterarm, mittels eines Entnahme-Mittel und/oder mittels des Label-Aufnehmers. Hierbei ist es auch möglich, dass eine Übergabe des Bauteils 1, beispielsweise mittels einer X/Y- oder X/Y/Z-Verschiebemechanik, erfolgt, zum Beispiel auf ein Förderband und/oder auf und/oder in ein Gehäuse, erfolgt.
Schritt 1010: Optional Kontrolle des Bauteils 1 mittels optischer Prüfung mittels Kameras und/oder optischer Sensoren oder menschliche Sichtprüfung und/oder mittels ein oder mehrerer Sensoren. Hierbei werden insbesondere Messwerte bezüglich der Geometrie, Transmissionsgrad, elektrische Kapazität, elektrischer Widerstand, mit einem Sollwert abgeglichen. Die Vorrichtung weist bevorzugt Mittel zum Abgleichen der mittels der ein oder mehreren Sensoren gemessenen Werte mit einem Soll-Wert auf.
Schritt 1011: Optional Ablage des Bauteils 1, insbesondere manuell und/oder mittels Roboterarm und/oder mittels einer X/Y- oder X/Y/Z-Verschiebemechanik oder mittels Fördermittel, beispielsweise an einem Lagerort und/oder in einer Verpackung.

Die Vorrichtung ist insbesondere zur automatisierten Durchführung einer oder mehrere der Schritt 1001 bis 1011, insbesondere des Schritts 1005, konfiguriert.

Fig. 6 zeigt schematisch ein Beispiel für ein Label 2, auf welches der Klebstoff 4 aufgetragen ist oder wird. Es handelt sich insbesondere um eine Draufsicht und/oder eine Betrachtung senkrecht auf eine von dem beispielhaften Label 2 aufgespannte Ebene. Wie beispielhaft durch Fig. 6 gezeigt ist, ist es möglich, dass der Klebstoff 4 teilflächig auf das Label 2 aufgebracht ist oder wird. Dabei weist der Klebstoff 4 ein oder mehrere erste definierte Formen auf. Es ist insbesondere möglich, dass die ersten definierten Formen des Klebstoffs 4 ein oder mehrere der folgenden Formen aufweist: gerade und/oder gekrümmte Linien, Knochenstruktur, T-Form, Y-Form, I-Form, U-Form, Serpentinen, Knotenpunkte, Verzweigungen, fraktale Formen.

Es ist insbesondere möglich, dass die ein oder mehreren ersten definierten Formen Querschnittsabmessungen, insbesondere Durchmesser, in einem Bereich von 50 µm bis 5000 µm, bevorzugt in einem Bereich von 500 µm bis 3000 µm, aufweisen. Beispielsweise wird der Klebstoff als "Raupe" aufgebracht. Ein bevorzugter Bereich der Viskosität liegt in einem Bereich von 500 mPa·s bis 2000 mPa·s, weiter bevorzugt in einem Bereich von 1000 mPa·s bis 1500 mPa·s. Dabei ist vorteilhafterweise gewährleistet, dass der Klebstoff in den ein oder mehreren ersten definierten Formen stabil bleibt. Der Klebstoff 4 ist oder wird vorzugsweise mit einer Breite in einem Bereich von 100 µm bis 10000 µm, bevorzugt in einem Bereich von 1000 µm bis 6000 µm aufgebracht. Die Breite wird dabei vorzugsweise in Draufsicht und/oder einer Betrachtung senkrecht auf eine von dem Label 2 oder dem Träger 3 aufgespannte Ebene, also insbesondere bei einer wie in Fig. 6 gezeigten Betrachtung gemessen.

Ein bevorzugter Klebstoff weist eine Temperaturbeständigkeit von -50°C bis 150 °C auf und/oder einen Flammpunkt von über 100 °C auf und/oder einen Brechungsindex (nD20) in einem Bereich von 1 bis 2, vorzugsweise 1,2 bis 1,8, bevorzugt von 1,46 bis 1,48, auf.

Wie durch Fig. 6 beispielhaft veranschaulicht wird, ist es möglich, dass in Schritt c) ausschließlich auf das Label 2 Klebstoff 4 aufgebracht ist oder wird. Es ist jedoch auch denkbar, dass in Schritt c) ein oder mehrere erste Schichten des Klebstoffs 4 partiell, insbesondere kleinflächig, auf das Label 2 und ein oder mehrere zweite Schichten des Klebstoffs 4 vollflächig und/oder großflächig auf den Träger 3 aufgebracht werden oder ein oder mehrere erste Schichten des Klebstoffs 4 partiell, insbesondere kleinflächig, auf den Träger 3 und ein oder mehrere zweite Schichten des Klebstoffs 4 vollflächig und/oder großflächig auf das Label 2 aufgebracht werden.

Es ist zudem denkbar, dass der Klebstoff 4 auf das Label 2 aufgebracht wird und auf dem Träger 3 ein Primer aufgebracht ist oder wird oder auf dem Label 2 ein Primer aufgebracht ist oder wird und der Klebstoff 4 auf den Träger 3 aufgebracht wird.

Hinsichtlich der Zusammensetzung des Klebstoffs 4 wird insbesondere auf obige Ausführungen verwiesen. Bevorzugt handelt es sich um einen mittels UV-Strahlung und/oder mit sichtbarem Licht vernetzbaren Klebstoff.

Bei dem Aufeinanderlegen von Label 2 und Träger 4 wird der Klebstoff insbesondere weiter zwischen dem Label 2 und dem Träger 4 verteilt, woraus sich die ein oder mehreren Kleberschichten 41 mit ein oder mehreren zweiten definierten Formen ergeben, so dass vorzugsweise die Schichtdicke der ersten definierten Formen zumindest bereichsweise größer ist als die Schichtdicke der zweiten definierten Formen und/oder in einer Draufsicht der Flächeninhalt der ersten definierten Form größer als der Flächeninhalt der zweiten definierten Formen ist. Wie auch durch Fig. 6 beispielhaft veranschaulicht wird, ist es möglich, dass die Flächendichte der ersten definierten Formen bezogen auf die mit den ein oder mehreren Kleberschichten 41 bedeckte Fläche nach dem Aufeinanderlegen von Label 2 und Träger 3 weniger als 90 %, vorzugsweise weniger als 80 % beträgt. Es ist zweckmäßig, dass die Flächendichte der ein oder mehreren ersten Formen mindestens 5 % beträgt.

Eine beispielhafte definierte Relativbewegung von Label 2 und Träger 3 wird hier insbesondere durch den Pfeil 45 angedeutet, wobei der Pfeil den Startpunkt eines Kontakts von Label 2, Klebstoff 4 und Träger 3 und die Richtung von Bereichen angibt, in welchen anschließend ein Kontakt von Label 2, Klebstoff 4 und Träger 3 hergestellt wird. Der gezeigte Ablauf kann beispielsweise durch eine rotatorische Bewegung des Label-Aufnehmers 20, insbesondere Wipp-Bewegung und/oder eine Abroll-Bewegung erreicht werden. Unter Kontakt ist hierbei insbesondere zu verstehen, dass in einem Querschnitt, beispielsweise einem wie zu Fig. 3f gezeigten Querschnitt, eine Linie, vorzugsweise Vertikale, gebildet werden kann, die sich durch das Label 2, den Klebstoff 4 und den Träger 3 erstreckt.

Wie zudem durch Fig. 6 beispielhaft veranschaulicht wird, ist es möglich, dass der Klebstoff 4 innerhalb ein oder mehrerer erster Bereiche, wie dem Bereich 400, des Labels 2 je Bereich der ein oder mehreren ersten Bereiche, also hier in dem Bereich 400, in einem Initialbereich 401 und in einem Folgebereich 403 des Labels 2 aufgetragen wird. Beim Aufeinanderlegen von Label 2 und Träger 3 wird dabei ein Kontakt von Label 2, Klebstoff 4 und Träger 3 zuerst in dem Initialbereich 41 und danach, vorzugsweise zuletzt, in dem Folgebereich 403 hergestellt wird. Der Klebstoff 4 mit den ein oder mehreren ersten definierten Formen weist dabei in dem Initialbereich 401 eine höhere Flächendichte auf als in dem Folgebereich 403.

Bei einem Auftrag des Klebstoffs 4 auf den Träger können derartige Bereiche analog definiert werden.

Der Initialbereich 401 kann beispielsweise von einem Anteil von maximal 20% der Gesamtfläche des Labels gebildet werden, die in dem jeweiligen ersten Bereich zuerst eine Verbindung von Label 2, Klebstoff 4 und Träger 3 aufweist. Der Folgebereich 403 kann beispielsweise von einem Anteil von mindestens 80% der Gesamtfläche des Labels gebildet werden, die in dem jeweiligen ersten Bereich zuletzt eine Verbindung von Label 2, Klebstoff 4 und Träger 3 aufweist. Die ein oder mehreren ersten definierten Formen können im Folgebereich 403 insbesondere auch nicht vorgesehen sein und Klebstoff 4 erst durch dessen Verdrängen dorthin verteilt werden. Es ist denkbar, dass nur ein erster Bereich 40 vorliegt, wie dies beispielhaft durch Fig. 6 veranschaulicht ist. Es ist auch möglich, dass, beispielsweise zwischen dem Initialbereich 401 und dem Folgebereich 403, ein Zwischenbereich 402 vorliegt. In dem Zwischenbereich 402 ist die Flächendichte bevorzugt geringer als im Initialbereich 401 und kann geringer oder höher sein als im Folgebereich 403.

Die Flächendichte wird vorzugsweise bei Betrachtung senkrecht auf eine von dem Label und/oder der Träger aufgespannte Ebene berechnet. Bevorzugt berechnet sich die Flächendichte aus dem Flächeninhalt einer von Klebstoff 4 in den ersten definierten Formen bedeckten Fläche im Verhältnis zur Fläche des Labels 2 und/oder des Träger 3, welche nach dem Aufeinanderlegen von Label 2 und Träger 3 mit dem Klebstoff 4 in der zweiten definierten Form bzw. mit den ein oder mehreren Kleberschichten 41 versehen ist.

Der Klebstoff 4 mit den ein oder mehreren ersten definierten Formen ist oder wird bevorzugt mit einem Abstand von mindestens 1 mm, vorzugsweise mindestens 2 mm von einem äußeren Rand und/oder von einer äußeren Kante einer Oberfläche des Labels 2 und/oder des Trägers 3 und/oder von einem Rand einer Aussparung innerhalb des Labels 2 und/oder des Trägers 3, auf welche der Klebstoff 4 aufgebracht wird.

Fig. 7a zeigt schematisch eine Draufsicht auf ein beispielhaftes Label 2 und/oder eine Betrachtung senkrecht auf eine von einem beispielhaften Label 2 aufgespannte Ebene. Das Label 2 umfasst den optionalen Kontaktierungstail 21, der zumindest in einem Kontaktbereich 211 angeordnet ist. Wie so insbesondere durch Fig. 7a beispielhaft gezeigt ist, ist es möglich, dass das Label 2 einen optionalen Kontaktierungstail 21 zum Kontaktieren, insbesondere elektrischen Kontaktieren, der weiteren Schicht, insbesondere der elektrisch leitfähigen Funktionsschicht 22, und/oder der ein oder mehreren elektrischen und/oder elektronischen und/oder optischen und/oder optoelektronischen Bauelemente 261 aufweist. Wie zudem durch Fig. 7a beispielhaft gezeigt ist, ist es möglich, dass das Label 2 Leiterbahnen 221 und Touchbereiche 222, vorzugsweise für Touchsensoren, insbesondere mit kapazitiven Elementen für Touchsensoren, welche über die Leiterbahnen 222 mittels des Kontatkierungstails 21 kontaktierbar sind, aufweist. Zumindest derartige Leiterbahnen 221 und/oder Touchbereiche 222 sind bevorzugt von der Funktionsschicht 22 umfasst. Es ist möglich, dass ein oder mehrere Touchbereiche ausgebildet sind. Vorzugsweise sind die ein oder mehreren Touchbereiche teilflächig vorgesehen und insbesondere in ihrer Form angepasst an Bedienfunktionen des Bauteils. Bevorzugt liegen in den Touchbereichen 222 leitfähige Strukturen, insbesondere aus strukturierten Metallflächen (beispielsweise als regelmäßiges oder unregelmäßiges bevorzugt feines Raster) oder aus bevorzugt sehr dünnen Metallflächen oder aus transparenten elektrisch leitfähigen Stoffen, wie z.B. elektrisch leitfähigen Metalloxiden, wie ITO (Indium-Zinn-Oxid), und/oder aus elektrisch leitfähigen Kunststoffen, wie PEDOT, vor, welche bevorzugt transparent und/oder für das menschliche Auge transparent erscheinend ausgestaltet sind. Es ist also möglich, dass das Label 2 insbesondere eine Sensorfolie umfasst oder davon gebildet ist, wobei die Sensorfolie bevorzugt eine Sensorfunktion, vorzugsweise Touchsensorfunktion, ausbildet. Die Sensorfunktion, vorzugsweise Touchsensorfunktion, ist oder wird insbesondere mittels der elektrisch leitfähigen Funktionsschicht des Labels bereitgestellt. Dabei ist es möglich, dass die Sensorfolie und/oder die elektrisch leitfähige Funktionsschicht, insbesondere die ein oder mehreren Leiterbahnen und/oder die ein oder mehreren kapazitiven Elemente, und/oder die Trägerschicht transparent ist bzw. sind und/oder nicht transparent, insbesondere opak, ist bzw. sind.

Fig. 7c zeigt beispielhaft den Kontaktbereich 211 in einem schematischen Querschnitt durch das Label 2 eines Bereichs, der in Fig. 7a von C nach D gekennzeichnet ist. Fig. 7b zeigt beispielhaft einen schematischen Querschnitt durch das Label 2 in dem Bereich von A nach B der Fig. 7a. Beispielsweise ist die im Querschnitt gezeigte obere Seite oder die untere Seite zur Verbindung mit dem Träger 3 vorgesehen. Auf dieser Seite werden somit, insbesondere durch das Aufeinanderlegen von Label 2 und Träger 3 die ein oder mehreren Kleberschichten 41 ausgebildet. Der Querschnitt der Fig. 7b zeigt so beispielsweise nur den Sensorbereich 201, wobei der Querschnitt der Fig. 7c sowohl Sensorbereich 201 als auch Kontaktbereich 211 zeigt.

Der Kontaktierungstail 21 weist, insbesondere bei Betrachtung senkrecht auf eine von dem Label 2 aufgespannte Ebene, bevorzugt eine geringere Fläche auf als der Rest des Labels 2. Der Kontaktierungstail 21 ist und/oder verbleibt in dem Verfahren vorzugsweise frei von Klebstoff 4, bevorzugt zumindest in einem Kontaktbereich 211 frei von Klebstoff 4 und/oder frei von Material des Trägers 3, und/oder die Vorrichtung, insbesondere der Träger-Aufnehmer und der Label-Aufnehmer, ist derart konfiguriert, dass dies möglich ist.

Insbesondere werden die ein oder mehreren ersten definierten Formen des Klebstoffs 4 mit einer angepassten Form und Menge, beispielsweise zur Ausbildung von Raupen in einer Knochenstruktur, aufgebracht und insbesondere der Kontaktbereich 211 frei von Klebstoff 4 gelassen, wie dies beispielsweise in Fig. 6 zu sehen ist. Bevorzugt ist oder wird die definierte Relativbewegung von Label 2 und Träger 3, insbesondere mittels einer Hub-Bewegung und/oder einer Wipp-Bewegung, angepasst, so dass der Kontaktbereich 211 frei von Klebstoff 4 bleibt, insbesondere auch wenn ein Verdrängen des Klebstoffs 4 stattfindet. Der Kontaktierungstail 21 wird an dem Label-Aufnehmer 20 bevorzugt in einer definierten Position gehalten, insbesondere beim Aufeinanderlegen von Label 2 und Träger 3. Hierzu kann der Label-Aufnehmer zum Beispiel Mittel zum Ansaugen des Kontaktierungstails 21 mittels Vakuums, ein oder mehrere Klemmvorrichtungen und/oder ein oder mehrere Abstandshalter aufweisen.

Zumindest ein Teilbereich des Kontaktbereichs 211 eignet sich zur elektrischen Kontaktierung der Funktionsschicht 22 und/oder der ein oder mehreren elektrischen und/oder elektronischen und/oder optischen und/oder optoelektronischen Bauelemente. Wie beispielhaft durch Fig. 7a gezeigt ist, ist es möglich, dass ein Teilbereich 212 des Kontaktbereichs 211 des Kontaktierungstails 21 ein Verstärkungselement 213 aufweist. Ein derartiges Verstärkungselement wird insbesondere auch als "Stiffener" bezeichnet. Das Verstärkungselement 213 ist oder wird bevorzugt über einen Kleber 214, der insbesondere auch als "Stiffener glue" bezeichnet wird, mit dem Label 2 verbunden, wie dies beispielhaft anhand der Fig. 7c veranschaulicht ist. Insbesondere in dem Teilbereich 21 ist somit eine elektrische Kontaktierung der Funktionsschicht 22 herstellbar. Fig. 7a, 7b, und 7c zeigen ferner beispielhaft einen Sensorbereich 201, welcher vorzugsweise einen mit dem Träger 3 verbundenen oder zu verbindenden Bereich darstellt und benachbart zum Kontaktbereich 211 vorliegt. Vorzugsweise werden in dem Sensorbereich 201 die ein oder mehreren Kleberschichten, insbesondere die Kleberschicht 41, ausgebildet. Der Kontaktierungstail 21 stellt somit vorzugsweise eine elektrische Kontaktierungsmöglichkeit auf einer von dem Sensorbereich 201 abgewandten Seite des Kontaktierungstails 21 bereit. Vorzugsweise erstreckt sich hierzu zumindest eine elektrisch leitfähige Schicht der Funktionsschicht 22 von dem Sensorbereich 201 in den Kontaktierungsbereich 211.

Fig. 8a zeigt schematisch ein Beispiel eines Querschnitts eines Labels 2 mit einem komplexen Schichtaufbau. Das Label 2 kann beispielsweise mehrschichtig sein, wie durch die Schichten 2001 bis 2002 veranschaulicht ist. Ein oder mehrere Schichten des Labels 2, insbesondere alle Schichten des Labels 2, können auch im Kontaktbereich 211 und/oder im Kontaktierungstail 21 vorliegen. Die Unterseite des Labels 2 wird mit Klebstoff 4 versehen und mit dem Träger 3 verbunden. Die obere Seite kommt bei dem Verfahren beispielsweise direkt mit dem Label-Aufnehmer 20 in Kontakt. Vorzugsweise ist eine der Schichten 2001 bis 2004 als die zumindest eine Trägerschicht ausgebildet und eine andere der Schichten 2001 bis 2004 als die weitere Schicht ausgebildet. Die übrigen Schichten sind optional. Alternativ zur weiteren Schicht oder zusätzlich dazu können jedoch auch ein oder mehrere Bauelemente auf der Trägerschicht angeordnet sein, beispielsweise die in Fig. 8c und Fig. 8g gezeigten Bauelemente 261.

Fig. 8b zeigt schematisch einen Querschnitt eines Labels 2 mit der folgenden Schichtfolge: eine Schutzschicht 24, die Funktionsschicht 22, welche hier bevorzugt eine Sensorschicht 22 mit ein oder mehreren elektrisch leitfähigen Schichten ist, die Trägerschicht 23, einen Primer 25. Der Primer 25 stellt insbesondere eine Haftvermittlerschicht 25 dar. Es ist denkbar, dass die weitere Schicht den Primer 25 umfasst oder von diesem gebildet wird und die übrigen Schichten auf der anderen Seite der Trägerschicht 23 optional sind. Alternativ ist der Primer 25 optional und die weitere Schicht zumindest eine andere Schicht, die insbesondere auf der dem Primer 25 gegenüberliegenden Seite der Trägerschicht 23 vorliegt.

Die Schutzschicht 25 ist beispielsweise eine Lackschicht oder eine Folie. Es ist möglich, dass die Schutzschicht fest in das Label 2 integriert ist oder dass die Schutzschicht 24 ablösbar ausgestaltet ist, insbesondere so dass nach einem Ablösen des Labels 2 von dem Label-Aufnehmer 20 die Schutzschicht 24 abgelöst werden kann. Die Trägerschicht 23 ist beispielsweise ein Foliensubstrat und/oder umfasst ein oder mehrere der folgenden Materialien: PET, PC, PMMA, ABS, PC-ABS, PP, PA, PE. Es ist auch denkbar, dass anstelle der Schutzschicht 24 oder zwischen der Schutzschicht 24 und der Funktionsschicht 22 ein oder mehrere Farbschichten vorgesehen sind. Die weitere Schicht kann hierbei eine oder mehrere der Schichten 22 und 24 umfassen, wobei die übrige, nicht von der weiteren Schicht umfasste Schicht, optional ist.

Fig. 8c zeigt einen schematischen Querschnitt eines wie zu Fig. 8b beschriebenen Labels 2, bis auf, dass zwischen der Schutzschicht 24 und der Funktionsschicht 22 eine Funktionsschicht 26 vorgesehen ist, welche ein oder mehrere Bauelemente 261, bevorzugt hybride Bauelemente, umfasst, beispielsweise einzeln oder in Kombination ausgewählt aus: passive Bauelemente, aktive Bauelemente, LEDs, OLEDs, Buchsen, Controller, Prozessoren, Widerstände, Displayelemente, Stecker, Sensoren, Aktuatoren, Kondensatoren, etc. Die Bauelemente sind vorzugsweise mittels eines Kunststoffmaterials verkapselt, bevorzugt mittels Polyurethan (PUR), verkapselt. Es ist auch denkbar, dass die weitere Schicht eine Funktionsschicht, wie beispielsweise die Funktionsschicht 26, umfasst oder daraus besteht, welche insbesondere die ein oder mehreren elektrischen und/oder elektronischen und/oder optischen und/oder optoelektronischen Bauelemente, wie die Bauelemente 261, umfasst und/oder verkapselt. Die weitere Schicht kann insbesondere eine oder mehrere der Schichten 22, 24 und 26 umfassen, wobei die übrigen, nicht von der weiteren Schicht umfassten Schichten, optional sind.

Fig. 8d zeigt einen schematischen Querschnitt eines wie zu Fig. 8b beschriebenen Labels 2, bis auf, dass anstelle einer Funktionsschicht 22, welche bevorzugt eine Sensorschicht 22 mit ein oder mehreren elektrisch leitfähigen Schichten ist, hier eine Funktionsschicht 27 mit einer optischen Funktion vorgesehen ist. Die optische Funktion kann insbesondere eine Dekoration und/oder eine Anzeige mittels eines Bildschirms sein. Insbesondere umfasst die optische Funktionsschicht 27 oder sie besteht vorzugsweise aus ein oder mehreren der folgenden Komponenten:
Polarisator, Farbfilter, Diffusor, Privacy-Filter, Antireflexschicht, Entspiegelungsschicht. Zudem weist das Label 2 hier ein oder mehrere Dekorschichten 28 auf, welche beispielsweise zwischen der Funktionsschicht 27 und der Trägerschicht 23 angeordnet sind. Die ein oder mehreren Dekorschichten 28 umfassen bevorzugt oder bestehen bevorzugt aus ein oder mehreren der folgenden Schichten: Schicht mit Endlosmuster, Schicht mit Einzelbild, partielle Schicht, vollflächige Schicht, Metallschicht, Farbschicht, bevorzugt Farblackschicht, insbesondere Farblackschicht im Vollton und/oder Farblackschicht im Halbton, bevorzugt Farblackschicht mit einem Druckraster, Lackschicht mit darin eingeprägter Reliefstruktur, Reflexionsschicht, insbesondere Metallschicht oder HRI-Schicht (HRI= High Refractive Index). Die weitere Schicht kann insbesondere eine oder mehrere der Schichten 24, 27 und 28 umfassen, wobei die übrigen, nicht von der weiteren Schicht umfassten Schichten, optional sind.

Fig. 8e zeigt einen schematischen Querschnitt eines wie zu Fig. 8b beschriebenen Labels 2, bis auf, dass zwischen der Funktionsschicht 22 und der Trägerschicht 23 ein oder mehrere Farbschichten 29 vorgesehen sind, welche insbesondere vollflächig und/oder teilflächig vorgesehen sein können. Die ein oder mehreren Farbschichten 29 umfassen bevorzugt oder bestehen bevorzugt aus ein oder mehreren der folgenden Schichten: ein oder mehrere Lackschichten, vorzugsweise mit Pigmenten und/oder Farbstoffen eingefärbte Lackschichten, ein oder mehrere Druckschichten, Druckschicht mit Endlosmuster, Druckschicht mit Einzelbild, partielle Druckschicht, vollflächige Druckschicht, Druckschicht im Vollton und/oder Druckschicht im Halbton, bevorzugt Druckschicht mit einem Druckraster. Die weitere

Schicht kann insbesondere eine oder mehrere der Schichten 22, 24 und 29 umfassen, wobei die übrigen, nicht von der weiteren Schicht umfassten Schichten, optional sind.

Fig. 8f zeigt einen schematischen Querschnitt eines wie zu Fig. 8b beschriebenen Labels 2, bis auf, dass anstelle der Schutzschicht 24 ein oder mehrere Farbschichten 29 sowie zwischen den Farbschichten 29 und der Funktionsschicht 22 eine Funktionsschicht 27 angeordnet ist. Die ein oder mehreren Farbschichten können insbesondere wie zu Fig. 8e beschrieben ausgebildet sein. Die Funktionsschicht 27 kann insbesondere wie zu Fig. 8d ausgebildet sein. Die Funktionsschicht 27 des Beispiels der Fig. 8f ist insbesondere eine Diffusor-Schicht, welche bevorzugt vollflächig oder partiell, insbesondere musterförmig, vorliegt. Eine Diffusor-Schicht kann beispielsweise durch einen Diffusorlack gebildet sein oder werden. Anstelle der Diffusor-Schicht des zu Fig. 8f beschriebenen Labels, kann beispielsweise auch eine wie zu Fig. 8c beschriebene Schicht 26 vorgesehen sein. Die weitere Schicht kann insbesondere eine oder mehrere der Schichten 22, 27 und 29 umfassen, wobei die übrigen, nicht von der weiteren Schicht umfassten Schichten, optional sind.

Fig. 8g zeigt einen schematischen Querschnitt eines wie zu Fig. 8b beschriebenen Labels 2, bis auf, dass auf der der Schutzlack 24 abgewandten Seite des Primers 25 eine zweite Schutzschicht 241 vorgesehen ist sowie zwischen der Schutzschicht 24 und dem Primer 25 folgende Schichtfolge vorgesehen ist, insbesondere ausgehend von der Schutzschicht 25:
ein oder mehrere Farbschichten 29, insbesondere eine Schattenmaske,
eine Funktionsschicht 27, die vorzugsweise eine Diffusor-Schicht 27 ist,
eine Funktionsschicht 26, welche vorzugsweise ein oder mehrere Bauelemente umfasst, wie insbesondere zu Fig. 8c für die Funktionsschicht 26 beschrieben ist, eine Kontaktierungsschicht 31, insbesondere zur elektrischen Kontaktierung der ein oder mehreren Bauelemente 261 der Funktionsschicht 26 und/oder zur elektrischen Kontaktierung der Funktionsschicht 22,
ein oder mehrere erste Zwischenschichten 32, beispielsweise umfassend ein oder mehrere Isolatoren und/oder ein oder mehrere Dielektrika,
eine weitere Funktionsschicht 33, beispielsweise umfassend Sensoren,
ein oder mehrere zweite Zwischenschichten 34, beispielsweise umfassend ein oder mehrere Isolatoren und/oder ein oder mehrere Dielektrika,
die Funktionsschicht 22, welche hier bevorzugt eine Sensorschicht 22 mit ein oder mehreren elektrisch leitfähigen Schichten ist und insbesondere wie zu Fig. 8b beschrieben ausgebildet sein kann,
die Trägerschicht 23, die insbesondere wie zu Fig. 8b beschrieben ausgebildet sein kann,
ein oder mehrere dritte Zwischenschichten 35, beispielsweise umfassend ein oder mehrere Isolatoren und/oder ein oder mehrere Dielektrika,
eine weitere Diffusor-Schicht 271,
die ein oder mehrere Dekorschichten 28, die insbesondere wie zu Fig. 8d beschrieben ausgebildet sein können,
eine dritte Schutzschicht 242, welche insbesondere von einem Schutzlack oder einer Schutzfolie gebildet sein kann,
der Primer 25, der insbesondere wie zu Fig. 8b beschrieben ausgebildet sein kann.

Die Zwischenschichten 32, 33 und 34 können somit insbesondere als eine elektrisch isolierende Funktionsschicht dienen.

Die ein oder mehreren Dekorschichten 28 sind oder umfassen hierbei bevorzugt eine Schattenmaske.

Die Kontaktierungsschicht 31 erstreckt sich beispielsweise durch den Sensorbereich 201 sowie den optionalen Kontaktierungstail 21 bzw. Kontaktbereich 211. Es ist auch möglich, dass zwischen der Funktionsschicht 22 und der Kontaktierungsschicht 31 und/oder zwischen der Funktionsschicht 33 und der Kontaktierungsschicht 31 liegende Schichten Durchkontaktierungen aufweisen, insbesondere so, dass die Kontaktierungsschicht 31 und die Funktionsschicht 22 elektrisch leitfähig verbunden und/oder galvanisch verbunden sind.

Eine Schattenmaske ist insbesondere eine partiell vorgesehene opake Schicht.

Die weitere Schutzschicht 241 ist insbesondere eine Schutzfolie. Vorzugsweise ist die zweite Schutzschicht 241 von dem Label 2 ablösbar. Insbesondere wird die zweite Schutzschicht 241 vor dem Auftragen des Klebers 4 auf das Label 2 und/oder vor dem Aufeinanderlegen von Label 2 und Träger 3 abgelöst.

Die weitere Schicht kann insbesondere eine oder mehrere der Schichten 24, 29, 27, 26, 31, 31, 33, 34, 22, 23, 35, 271, 28, 242, 25, 241 umfassen, wobei die übrigen, nicht von der weiteren Schicht umfassten Schichten, optional sind.

Das Label 2 ist insbesondere so ausgestaltet, dass die in den Fig. 8a bis 8g gezeigten Querschnitte an ihrer Unterseite, also entlang der unteren sichtbaren Kante, eine Fläche bilden, die über den Klebstoff 4 und/oder die ein oder mehreren Kleberschichten 41 mit dem Träger 3 zu verbinden sind, verbunden werden und/oder verbindbar sind. Die einzelnen Dicken sind in Fig.8a bis 8g insbesondere nicht maßstabsgetreu und die Reihenfolgen der Schicht-Aufbauten können beliebig vertauscht werden. Insbesondere können beliebig Schichten weggelassen oder mehrfach vorhanden sein. Es können auch weitere Schichten vorgesehen sein. Jede einzelne Schicht kann ein Schichtpaket aus verschiedenen Schichten sein und/oder vollflächig oder teilflächig aufgebracht sein.

### Bezugszeichenliste:

- 1: Bauteil
- 1001 bis 1010: Schritte
- 2: Label
- 20: Label-Aufnehmer
- 21: Kontaktierungstail
- 211: Kontaktbereich
- 212: Teilbereich
- 213: Verstärkungselement (Stiffener)
- 214: Kleber (Stiffener glue)
- 22: Funktionsschicht(en)
- 221: Leiterbahnen
- 222: Touchbereiche
- 23: Trägerschicht
- 24, 241, 242: Schutzschichten
- 25: Primerschicht
- 26: Funktionsschicht mit Bauelementen
- 261: Bauelemente
- 27, 271: Diffusor-Schicht(en)
- 28: Dekorschicht(en)
- 29: Farbschicht(en)
- 3: Träger
- 30: Träger-Aufnehmer
- 301: Stufe
- 302: Vertiefung
- 303: Erhöhung
- 304: Störpartikel
- 31: Kontaktierungsschicht
- 32, 34, 35: Zwischenschicht(en)
- 4: Klebstoff
- 40: Klebstoffausgabe-Einheit
- 400: erster Bereich
- 401: Initialbereich
- 402: Zwischenbereich
- 403: Folgebereich
- 41: Kleberschicht(en)
- 52, 520, 53: Krümmungsbereiche
- 60: Vorhärtungs-Einheit
- 70: Härtungs-Einheit
- 80: Vorbehandlungs-Einheit

## Patentansprüche

1. Verfahren zur Herstellung eines Bauteils (1), insbesondere Verkleidungsbauteils oder Bedienelements oder Anzeigeelements, wobei das Verfahren mittels einer Vorrichtung mit einem Label-Aufnehmer (20), einem Träger-Aufnehmer (30) sowie einer Klebstoffausgabe-Einheit (40) durchgeführt wird und zumindest folgende Schritte aufweist:
a1) Bereitstellen eines Labels (2) mit einem flexiblen Schichtaufbau umfassend zumindest eine Trägerschicht (23) und
eine weitere Schicht (22, 24, 26, 27, 28, 29) oder ein oder mehrere elektrische oder elektronische oder optische oder optoelektronische Bauelemente (261) oder eine Kombination daraus;
a2) Aufnahme des Labels (2) mit dem Label-Aufnehmer (20),
wobei das Label (2) durch die Aufnahme mittels des Label-Aufnehmers (20) zumindest in einem Krümmungsbereich (52) des Labels (2) gekrümmt wird;
b1) Bereitstellen eines Trägers (3);
b2) Aufnahme des Trägers (3) mittels des Träger-Aufnehmers (30);
c) Aufbringen eines fließfähigen Klebstoffs (4) mittels der Klebstoffausgabe-Einheit (40) in ein oder mehreren ersten definierten Formen auf entweder das mittels des Label-Aufnehmers (20) gehaltene Label (2) oder den mittels des Träger-Aufnehmers gehaltenen Träger (3);
d) Aufeinanderlegen von Label (2) und Träger (3) mittels einer definierten Relativbewegung (45) von Label-Aufnehmer (20) und Träger-Aufnehmer (30), derart dass der Klebstoff (4) zwischen Label (2) und Träger (3) angeordnet wird und zwischen Label (2) und Träger (3) ein oder mehrere Kleberschichten (41) in ein oder mehreren zweiten definierten Formen erhalten werden, wobei das Aufeinanderlegen von Label und Träger durch eine rotatorische Bewegung des Labels in Relation zu dem Träger durchgeführt wird;
e) zumindest teilweises Härten und/oder zumindest teilweises Vernetzen der ein oder mehreren Kleberschichten (41).

2. Verfahren nach dem vorhergehenden Anspruch,
**dadurch gekennzeichnet,**
**dass** bei dem Aufeinanderlegen von Label (2) und Träger (3), das Label (2), der Klebstoff (4), die ein oder mehreren Kleberschichten (41) oder der Träger (3) mit einer Temperatur verarbeitet werden, die eine Glasübergangstemperatur des Trägers (3) oder des Labels (2) nicht überschreitet oder weniger als 80 °C beträgt.

3. Verfahren nach einem der vorhergehenden Ansprüche,
**dadurch gekennzeichnet,**
**dass** bei der definierten Relativbewegung oder einem Halten des Label-Aufnehmers und des Träger-Aufnehmers in einer definierten Relativposition von Label-Aufnehmer und Träger-Aufnehmer, auf das Label (2), den Klebstoff (4), die ein oder mehreren Kleberschichten (41) und den Träger (3) ein Druck wirkt, welcher 10 N/cm² nicht oder für maximal 10 s übersteigt.

4. Verfahren nach einem der vorhergehenden Ansprüche,
**dadurch gekennzeichnet,**
**dass** der Träger (3) zumindest in einem Krümmungsbereich (53) eine gekrümmte Träger-Oberfläche (53) aufweist, wobei bei dem Aufeinanderlegen von Label (2) und Träger (3) der Krümmungsbereich (52) des Labels (2) auf den Krümmungsbereich (53) des Trägers (3) aufgebracht wird.

5. Verfahren nach einem der vorhergehenden Ansprüche,
**dadurch gekennzeichnet,**
**dass** der Klebstoff (4) einen Kaltkleber odereinen optischen Kleber umfasst oder daraus besteht.

6. Verfahren nach einem der vorhergehenden Ansprüche,
**dadurch gekennzeichnet,**
**dass** das Aufbringen des Klebstoffs (4) durch Dispensen oder durch Drucken erfolgt, oder
**dass** der Klebstoff (4) beim Aufbringen newtonsche oder scherverdünnende Fluideigenschaften oder eine Viskosität in einem Bereich von 0,5 mPa·s bis 100000 mPa·s aufweist, derart, dass beim Aufeinanderlegen von Label (2) und Träger (3) ein Fließen des Klebstoffs (4) möglich ist und die ein oder mehreren ersten definierten Formen des Klebstoffs (4) bis zum Aufeinanderlegen von Label (2) und Träger (3) erhalten bleiben oder kontrolliert verformt werden.

7. Verfahren nach einem der vorhergehenden Ansprüche,
**dadurch gekennzeichnet,**
**dass** die ein oder mehreren ersten definierten Formen Querschnittsabmessungen, insbesondere Durchmesser, in einem Bereich von 50 µm bis 5000 µm, bevorzugt in einem Bereich von 500 µm bis 3000 µm, aufweisen, oder
**dass** das Aufeinanderlegen von Label (2) und Träger (3) derart erfolgt, dass die ein oder mehreren Kleberschichten (41) mit einer Mindestdicke von 2 µm, bevorzugt von 3 µm, weiter bevorzugt von 5 µm, zwischen dem Label (2) und dem Träger (3) angeordnet werden.

8. Verfahren nach einem der vorhergehenden Ansprüche,
**dadurch gekennzeichnet,**
**dass** der Klebstoff (4) innerhalb ein oder mehrerer erster Bereiche (400) des Labels (2) oder des Trägers (3) je Bereich der ein oder mehreren ersten Bereiche (400) in einem Initialbereich (401) und in einem Folgebereich (403) des Labels (2) oder des Trägers (3) aufgetragen wird, wobei beim Aufeinanderlegen von Label (2) und Träger (3) ein Kontakt von Label (2), Klebstoff (4) und Träger (3) zuerst in dem Initialbereich (401) und danach in dem Folgebereich (403) hergestellt wird, wobei der Klebstoff (4) mit den ein oder mehreren ersten definierten Formen in dem Initialbereich (401) eine höhere Flächendichte aufweist als in dem Folgebereich (403).

9. Verfahren nach einem der vorhergehenden Ansprüche,
**dadurch gekennzeichnet,**
**dass** der Klebstoff (4) mit den ein oder mehreren ersten definierten Formen aufgebracht wird mit einem Abstand von mindestens 1 mm, vorzugsweise mindestens 2 mm, von einem Rand oder einer Kante einer Oberfläche des Labels (2) oder des Trägers (3), auf welche der Klebstoff (4) aufgebracht wird, oder von einem Rand einer Aussparung des Labels (2) oder des Trägers (3).

10. Verfahren nach einem der vorhergehenden Ansprüche,
**dadurch gekennzeichnet,**
**dass** der Klebstoff (4) auf das Label (2) aufgebracht wird und auf dem Träger (3) ein Primer aufgebracht ist oder wird oder auf dem Label ein Primer (25) aufgebracht ist oder wird und der Klebstoff (4) auf den Träger (3) aufgebracht wird.

11. Verfahren nach einem der vorhergehenden Ansprüche,
**dadurch gekennzeichnet,**
**dass** das Aufeinanderlegen von Label und Träger durch eine translatorische und rotatorische Bewegung des Labels in Relation zu dem Träger durchgeführt wird, wobei die definierte Relativbewegung ein Wippen oder Abrollen umfasst oder ist.

12. Verfahren nach einem der vorhergehenden Ansprüche,
**dadurch gekennzeichnet,**
**dass** das Label (2) passgenau in dem Label-Aufnehmer (20) gehalten wird oder dass das Label (2) oder der Label-Aufnehmer (20) Markierungen als Passermarken aufweist.

13. Verfahren nach einem der vorhergehenden Ansprüche,
**dadurch gekennzeichnet,**
**dass** das zumindest teilweise Härten und/oder zumindest teilweise Vernetzen mittels Bestrahlung mit sichtbarem Licht erfolgt, oder
**dass** die ein oder mehreren Kleberschichten (41) mittels Bestrahlung mit sichtbarem Licht nach einem Abnehmen des Label-Aufnehmers ausgehärtet und/oder vollständig vernetzt werden.

14. Verfahren nach einem der vorhergehenden Ansprüche,
**dadurch gekennzeichnet,**
**dass** das zumindest teilweise Härten und/oder zumindest teilweise Vernetzen mittels UV-Bestrahlung erfolgt, oder
**dass** die ein oder mehreren Kleberschichten (41) mittels UV-Bestrahlung nach einem Abnehmen des Label-Aufnehmers ausgehärtet und/oder vollständig vernetzt werden.

15. Verfahren nach einem der vorhergehenden Ansprüche,
**dadurch gekennzeichnet,**
**dass** das Label (2) eine Dicke in einem Bereich von 25 µm bis 350 µm, vorzugsweise in einem Bereich von 50 µm bis 150 µm aufweist.

16. Verfahren nach einem der vorhergehenden Ansprüche,
**dadurch gekennzeichnet,**
**dass** der Träger (3) bei dem Schritt d) oder im fertigen Bauteil eine dreidimensionale Form aufweist.

17. Verfahren nach einem der vorhergehenden Ansprüche,
**dadurch gekennzeichnet,**
**dass** das Label (2) derart ausgestaltet ist, dass es eine elektrische Funktion bereitstellt, indem das Label (2) eine flexible Leiterplatte mit LEDs und Leiterbahnen bildet.

18. Vorrichtung zur Durchführung des Verfahrens nach einem der vorhergehenden Ansprüche zur Herstellung eines Bauteils (1) wobei die Vorrichtung umfasst:
- einen Label-Aufnehmer (20) zur Aufnahme eines Labels (2) mit einem flexiblen Schichtaufbau umfassend zumindest eine Trägerschicht (23) und eine weitere Schicht (22, 24, 26, 27, 28, 29) oder ein oder mehrere elektrische oder elektronische oder optische oder optoelektronische Bauelemente (261) oder eine Kombination daraus;
- einen Träger-Aufnehmer (30) zur Aufnahme eines Trägers (3);
- eine Klebstoffausgabe-Einheit (40) zum Aufbringen eines fließfähigen Klebstoffs (4) mittels der Klebstoffausgabe-Einheit (40) in ein oder mehreren ersten definierten Formen auf entweder das Label (2) oder den Träger (3); wobei die Vorrichtung derart konfiguriert ist, dass ein Aufeinanderlegen von Label (2) und Träger (3) mittels einer definierten Relativbewegung (45) von Label-Aufnehmer (20) und Träger-Aufnehmer (30) zur Anordnung des Klebstoffs (4) zwischen Label (2) und Träger (3) durchführbar ist, derart dass zwischen Label (2) und Träger (3) ein oder mehrere Kleberschichten (41) in ein oder mehreren zweiten definierten Formen erhältlich sind und wobei die Vorrichtung derart konfiguriert ist, dass das Aufeinanderlegen von Label und Träger durch eine rotatorische Bewegung des Labels in Relation zu dem Träger durchführbar ist und dass zumindest ein Krümmungsbereich des Label-Aufnehmers, welcher nach Aufnahme des Labels in Kontakt mit dem Label steht, eine gekrümmte Oberfläche aufweist.

19. Vorrichtung nach dem vorhergehenden Anspruch,
**dadurch gekennzeichnet,**
**dass** die Vorrichtung eine Vorhärtungs-Einheit (60) zum partiellen oder vollflächigen Vorhärten der ein oder mehreren Kleberschichten (41), während der Label-Aufnehmer (20) in Kontakt mit dem Label (2) steht, aufweist, oder dass der Label-Aufnehmer (20) ein oder mehrere transparente, vorzugsweise UV-transparente, Bereiche aufweist oder ein oder mehrere Löcher aufweist, derart, dass die ein oder mehreren Kleberschichten (41) mittels der Vorhärtungs-Einheit (60) durch die ein oder mehreren transparenten Bereiche oder Löcher hindurch bestrahlbar sind.

20. Vorrichtung nach Anspruch 18 oder 19,
**dadurch gekennzeichnet,**
**dass** der Label-Aufnehmer (20), der Träger-Aufnehmer (30) und die Klebstoffausgabe-Einheit (40) untereinander einen maximalen Abstand von 2 m aufweisen.

## Claims

1. Method for producing a component (1), in particular a trim component or operating element or display element, the method being carried out by means of a device having a label receptacle (20), a carrier receptacle (30) and an adhesive dispensing unit (40) and having at least the following steps:
a1) providing a label (2) with a flexible layer structure comprising at least one carrier layer (23) and
a further layer (22, 24, 26, 27, 28, 29) or one or more electrical or electronic or optical or
optoelectronic components (261) or any combination thereof;
a2) accommodating the label (2) with the label receptacle (20),
wherein the label (2) is curved by means of the label receptacle (20) at least in a curvature region (52) of the label (2);
b1) providing a carrier (3);
b2) accommodating the carrier (3) by means of the carrier receptacle (30);
c) applying a fluid adhesive (4) by means of the adhesive dispensing unit (40) in one or more first defined shapes to either the label (2) held by means of the label receptacle (20) or the carrier (3) held by means of the carrier receptacle;
d) placing label (2) and carrier (3) one on top of the other by means of a defined relative movement (45) of label receptacle (20) and carrier receptacle (30), such that the adhesive (4) is arranged between label (2) and carrier (3) and one or more adhesive layers (41) are obtained between label (2) and carrier (3) in one or more second defined shapes, wherein the placing of label and carrier one on top of the other is carried out by a rotational movement of the label in relation to the carrier;
e) at least partial curing and/or at least partial cross-linking of the one or more adhesive layers (41).

2. Method according to the preceding claim,
**characterised in that**,
when the label (2) and carrier (3) are placed one on top of the other, the label (2), the adhesive (4), the one or more adhesive layers (41) or the carrier (3) are processed at a temperature that does not exceed a glass transition temperature of the carrier (3) or the label (2), or that is less than 80°C.

3. Method according to one of the preceding claims,
**characterised in that**,
during the defined relative movement or while the label receptacle and the carrier receptacle are held in a defined relative position of the label receptacle and carrier receptacle, a pressure acts on the label (2), the adhesive (4), the one or more adhesive layers (41) and the carrier (3), which does not exceed 10 N/cm, or does so for a maximum of 10 seconds.

4. Method according to one of the preceding claims,
**characterised in that**,
the carrier (3) has a curved carrier surface (53) at least in one curvature region (53), wherein the curvature region (52) of the label (2) is applied to the curvature region (53) of the carrier (3) when the label (2) and carrier (3) are placed one on top of the other.

5. Method according to one of the preceding claims,
**characterised in that**,
the adhesive (4) comprises or consists of a cold adhesive or an optical adhesive.

6. Method according to one of the preceding claims,
**characterised in that**,
the adhesive (4) is applied by dispensing or by printing, or
during application, the adhesive (4) has Newtonian or shear-thinning fluid properties or a viscosity in a range of from 0.5 mPa.s to 100,000 mPa.s, in such a way that the adhesive (4) can flow when the label (2) and carrier (3) are placed one on top of the other, and the one or more first defined shapes of the adhesive (4) are retained or deformed in a controlled manner until the label (2) and carrier (3) are placed one on top of the other.

7. Method according to one of the preceding claims,
**characterised in that**,
the one or more first defined shapes have cross-sectional dimensions, in particular diameters, in a range of from 50 µm to 5000 µm, preferably in a range of from 500 µm to 3000 µm, or **in that** the label (2) and carrier (3) are placed one on top of the other in such a way that the one or more adhesive layers (41) are arranged with a minimum thickness of 2 µm, preferably of 3 µm, more preferably of 5 µm, between the label (2) and the carrier (3).

8. Method according to one of the preceding claims,
**characterised in that**,
the adhesive (4) is applied within one or more first regions (400) of the label (2) or of the carrier (3), for each region of the one or more first regions (400) in an initial region (401) and in a subsequent region (403) of the label (2) or of the carrier (3), wherein, when the label (2) and carrier (3) are placed one on top of the other, contact of the label (2), adhesive (4) and carrier (3) is created first in the initial region (401) and then in the subsequent region (403), wherein the adhesive (4) having the one or more first defined shapes has a higher surface density in the initial region (401) than in the subsequent region (403).

9. Method according to one of the preceding claims,
**characterised in that**,
the adhesive (4) is applied with the one or more first defined shapes at a distance of at least 1 mm, preferably at least 2 mm, from a border or an edge of a surface of the label (2) or of the carrier (3) to which the adhesive (4) is applied, or from a border of a gap of the label (2) or of the carrier (3).

10. Method according to one of the preceding claims,
**characterised in that**,
the adhesive (4) is applied to the label (2) and a primer is or becomes applied to the carrier (3), or a primer (25) is or becomes applied to the label and the adhesive (4) is applied to the carrier (3).

11. Method according to one of the preceding claims,
**characterised in that**,
the label and carrier are placed one on top of the other by a translational and rotational movement of the label in relation to the carrier, wherein the defined relative movement comprises or is a rocking or rolling.

12. Method according to one of the preceding claims,
**characterised in that**,
the label (2) is held in place with a precise fit in the label receptacle (20), or the label (2) or the label receptacle (20) has markings as registration marks.

13. Method according to one of the preceding claims,
**characterised in that**,
the at least partial curing and/or at least partial cross-linking takes place by means of irradiation with visible light, or
the one or more adhesive layers (41) are cured and/or completely cross-linked by means of irradiation with visible light after removal of the label receptacle.

14. Method according to one of the preceding claims,
**characterised in that**,
the at least partial curing and/or at least partial cross-linking takes place by means of UV irradiation, or
the one or more adhesive layers (41) are cured and/or completely cross-linked by means of UV irradiation after removal of the label receptacle.

15. Method according to one of the preceding claims,
**characterised in that**,
the label (2) has a thickness in a range of from 25 µm to 350 µm, preferably in a range of from 50 µm to 150 µm.

16. Method according to one of the preceding claims,
**characterised in that**,
the carrier (3) has a three-dimensional shape in step d) or in the finished component.

17. Method according to one of the preceding claims,
**characterised in that**,
the label (2) is designed in such a way that it provides an electrical function **in that** the label (2) forms a flexible printed circuit board with LEDs and conductor tracks.

18. Device for carrying out the method according to one of the preceding claims for producing a component (1), wherein the device comprises:
- a label receptacle (20) for accommodating a label (2) having a flexible layer structure comprising at least one carrier layer (23) and a further layer (22, 24, 26, 27, 28, 29) or one or more electrical or electronic or optical or optoelectronic components (261) or a combination thereof;
- a carrier receptacle (30) for accommodating a carrier (3);
- an adhesive dispensing unit (40) for applying a fluid adhesive (4) by means of the adhesive dispensing unit (40) in one or more first defined shapes to either the label (2) or the carrier (3); wherein the device is configured such that the label (2) and carrier (3) can be placed one on top of the other by means of a defined relative movement (45) of the label receptacle (20) and carrier receptacle (30) for arranging the adhesive (4) between the label (2) and carrier (3), such that one or more adhesive layers (41) in one or more second defined shapes are available between the label (2) and carrier (3), and wherein the device is configured such that the label and carrier can be placed one on top of the other by a rotational movement of the label in relation to the carrier, and at least one curvature region of the label receptacle, which is in contact with the label after the label has been accommodated, has a curved surface.

19. Device according to the preceding claim,
**characterised in that**,
the device has a pre-curing unit (60) for partial or full-surface pre-curing of the one or more adhesive layers (41) while the label receptacle (20) is in contact with the label (2), or the label receptacle (20) has one or more transparent, preferably UV-transparent, regions or has one or more holes, such that the one or more adhesive layers (41) can be irradiated through the one or more transparent regions or holes by means of the pre-curing unit (60).

20. Device according to claim 18 or 19,
**characterised in that**,
the label receptacle (20), the carrier receptacle (30) and the adhesive dispensing unit (40) have a maximum distance of 2 m from one another.

## Revendications

1. Procédé de fabrication d'un composant (1), en particulier d'un composant d'habillage ou d'un élément de commande ou d'un élément d'affichage, dans lequel le procédé est réalisé au moyen d'un dispositif avec un récepteur d'étiquette (20), un récepteur de support (30) ainsi qu'une unité de distribution de colle (40) et présente au moins des étapes suivantes :
a1) la mise à disposition d'une étiquette (2) avec une structure de couche flexible comprenant au moins une couche support (23) et
une autre couche (22, 24, 26, 27, 28, 29) ou un ou plusieurs composants électriques ou électroniques ou optiques ou optoélectroniques (261) ou une combinaison de ceux-ci ;
a2) la réception de l'étiquette (2) avec le récepteur d'étiquette (20),
dans lequel l'étiquette (2) est courbée par la réception au moyen du récepteur d'étiquette (20) au moins dans une zone de courbure (52) de l'étiquette (2) ;
b1) la fourniture d'un support (3) ;
b2) la réception du support (3) au moyen du récepteur de support (30) ;
c) l'application d'une colle fluide (4) au moyen de l'unité de distribution de colle (40) dans une ou plusieurs premières formes définies soit sur l'étiquette (2) maintenue au moyen du récepteur d'étiquette (20), soit sur le support (3) maintenu au moyen du récepteur de support ;
d) l'empilement de l'étiquette (2) et du support (3) au moyen d'un mouvement relatif défini (45) du récepteur d'étiquette (20) et du récepteur de support (30), de telle manière que la colle (4) est disposée entre l'étiquette (2) et le support (3) et qu'une ou plusieurs couches de colle (41) sont obtenues entre l'étiquette (2) et le support (3) dans une ou plusieurs deuxièmes formes définies, dans lequel l'empilement de l'étiquette et du support est réalisé par un mouvement de rotation de l'étiquette par rapport au support ;
e) le durcissement au moins partiel et/ou la réticulation au moins partielle des une ou plusieurs couches de colle (41).

2. Procédé selon la revendication précédente,
**caractérisé en ce**
**que** lors de l'empilement de l'étiquette (2) et du support (3), l'étiquette (2), la colle (4), une ou plusieurs couches de colle (41) ou le support (3) sont traités à une température, qui ne dépasse pas une température de transition vitreuse du support (3) ou de l'étiquette (2) ou est inférieure à 80 °C.

3. Procédé selon l'une quelconque des revendications précédentes,
**caractérisé en ce**
**que** lors du mouvement de rotation défini ou d'un maintien du récepteur d'étiquette et du récepteur de support dans une position relative définie du récepteur d'étiquette et du récepteur de support, une pression n'excédant pas 10 N/cm² ou pendant 10 s au maximum agit sur l'étiquette (2), la colle (4), les une ou plusieurs couches de colle (41) et le support (3).

4. Procédé selon l'une quelconque des revendications précédentes,
**caractérisé en ce**
**que** le support (3) présente au moins dans une zone de courbure (53) une surface de support (53) courbée, dans lequel lors de l'empilement de l'étiquette (2) et du support (3), la zone de courbure (52) de l'étiquette (2) est appliquée sur la zone de courbure (53) du support (3).

5. Procédé selon l'une quelconque des revendications précédentes,
**caractérisé en ce**
**que** la colle (4) comprend une colle à froid ou une colle optique ou en est constituée.

6. Procédé selon l'une quelconque des revendications précédentes,
**caractérisé en ce**
**que** l'application de la colle (4) s'effectue par distribution ou par impression, ou
**que** la colle (4) présente, lors de l'application, des propriétés fluidiques newtoniennes ou de dilution par cisaillement ou une viscosité dans une plage de 0,5 mPa·s à 100000 mPa·s, de telle manière que lors de l'empilement de l'étiquette (2) et du support (3), un écoulement de la colle (4) est possible et que les une ou plusieurs premières formes définies de la colle (4) sont conservées ou déformées de manière contrôlée jusqu'à l'empilement de l'étiquette (2) et du support (3).

7. Procédé selon l'une quelconque des revendications précédentes,
**caractérisé en ce**
**que** les une ou plusieurs premières formes définies présentent des dimensions de section transversale, en particulier des diamètres, dans une plage de 50 µm à 5000 µm, de manière préférée dans une plage de 500 µm à 3000 µm, ou
**que** l'empilement de l'étiquette (2) et du support (3) s'effectue de telle manière que les une ou plusieurs couches de colle (41) d'une épaisseur minimale de 2 µm, de manière préférée de 3 µm, de manière davantage préférée de 5 µm, sont disposées entre l'étiquette (2) et le support (3).

8. Procédé selon l'une quelconque des revendications précédentes,
**caractérisé en ce**
**que** la colle (4) est appliquée à l'intérieur d'une ou de plusieurs premières zones (400) de l'étiquette (2) ou du support (3) par zone des une ou plusieurs premières zones (400) dans une zone initiale (401) et dans une zone consécutive (403) de l'étiquette (2) ou du support (3), dans lequel lors de l'empilement de l'étiquette (2) et du support (3), un contact de l'étiquette (2), de la colle (4) et du support (3) est d'abord réalisé dans la zone initiale (401) puis dans la zone consécutive (403), dans lequel la colle (4) avec les une ou plusieurs premières formes définies dans la zone initiale (401) présente une densité de surface plus élevée que dans la zone consécutive (403).

9. Procédé selon l'une quelconque des revendications précédentes,
**caractérisé en ce**
**que** la colle (4) est appliquée avec les une ou plusieurs premières formes définies à une distance d'au moins 1 mm, de préférence d'au moins 2 mm, d'un bord ou d'une arête d'une surface de l'étiquette (2) ou du support (3), sur laquelle la colle (4) est appliquée, ou d'un bord d'un évidement de l'étiquette (2) ou du support (3).

10. Procédé selon l'une quelconque des revendications précédentes,
**caractérisé en ce**
**que** la colle (4) est appliquée sur l'étiquette (2) et un apprêt est appliqué sur le support (3) ou un apprêt (25) est appliqué sur l'étiquette et la colle (4) est appliquée sur le support (3).

11. Procédé selon l'une quelconque des revendications précédentes,
**caractérisé en ce**
**que** l'empilement de l'étiquette et du support est effectué par un mouvement de translation et de rotation de l'étiquette par rapport au support, dans lequel le mouvement relatif défini comprend ou est un basculement ou un déroulement.

12. Procédé selon l'une quelconque des revendications précédentes,
**caractérisé en ce**
**que** l'étiquette (2) est maintenue avec précision dans le récepteur d'étiquette (20) ou
**que** l'étiquette (2) ou le récepteur d'étiquette (20) présente des marquages en tant que repères.

13. Procédé selon l'une quelconque des revendications précédentes,
**caractérisé en ce**
**que** le durcissement au moins partiel et/ou le réticulation au moins partielle s'effectuent par irradiation avec de la lumière visible, ou
**que** les une ou plusieurs couches de colle (41) sont durcies et/ou entièrement réticulées par irradiation avec de la lumière visible après un retrait du récepteur d'étiquette.

14. Procédé selon l'une quelconque des revendications précédentes,
**caractérisé en ce**
**que** le durcissement au moins partiel et/ou le réticulation au moins partielle s'effectuent par rayonnement UV, ou
**que** les une ou plusieurs couches de colle (41) sont durcies et/ou entièrement réticulées par rayonnement UV après un retrait du récepteur d'étiquette.

15. Procédé selon l'une quelconque des revendications précédentes,
**caractérisé en ce**
**que** l'étiquette (2) présente une épaisseur dans une plage de 25 µm à 350 µm, de préférence dans une plage de 50 µm à 150 µm.

16. Procédé selon l'une quelconque des revendications précédentes,
**caractérisé en ce**
**que** le support (3) présente une forme tridimensionnelle à l'étape d) ou dans le composant fini.

17. Procédé selon l'une quelconque des revendications précédentes,
**caractérisé en ce**
**que** l'étiquette (2) est conçue pour fournir une fonction électrique **en ce que** l'étiquette (2) forme une carte de circuits imprimés flexible avec des LED et des pistes conductrices.

18. Dispositif de réalisation du procédé selon l'une quelconque des revendications précédentes pour la fabrication d'un composant (1), dans lequel le dispositif comprend :
- un récepteur d'étiquette (20) pour recevoir une étiquette (2) avec une structure de couches flexible, comprenant au moins une couche de support (23) et une autre couche (22, 24, 26, 27, 28, 29) ou un ou plusieurs composants électriques ou électroniques ou optiques ou optoélectroniques (261) ou une combinaison de ceux-ci ;
- un récepteur de support (30) pour recevoir un support (3) ;
- une unité de distribution de colle (40) pour appliquer une colle fluide (4) au moyen de l'unité de distribution de colle (40) dans une ou plusieurs premières formes définies sur l'étiquette (2) ou le support (3) ;
dans lequel le dispositif est configuré de telle manière qu'un empilement de l'étiquette (2) et du support (3) peut être réalisé au moyen d'un mouvement relatif défini (45) du récepteur d'étiquette (20) et du récepteur de support (30) pour disposer la colle (4) entre l'étiquette (2) et le support (3), de telle manière qu'une ou plusieurs couches de colle (41) peuvent être obtenues dans une ou plusieurs deuxièmes formes définies entre l'étiquette (2) et le support (3) et dans lequel le dispositif est configuré de telle manière, que l'empilement de l'étiquette et du support peut être réalisé par un mouvement de rotation de l'étiquette par rapport au support et qu'au moins une zone de courbure du récepteur d'étiquette qui est en contact avec l'étiquette après réception de l'étiquette présente une surface courbée.

19. Dispositif selon la revendication précédente,
**caractérisé en ce**
**que** le dispositif présente une unité de prédurcissement (60) pour le prédurcissement partiel ou sur toute la surface des une ou plusieurs couches de colle (41), pendant que le récepteur d'étiquette (20) est en contact avec l'étiquette (2), ou que le récepteur d'étiquette (20) présente une ou plusieurs zones transparentes, de préférence des zones transparentes aux UV ou présente un ou plusieurs trous, de telle manière que les une ou plusieurs couches de colle (41) peuvent être irradiées au moyen de l'unité de prédurcissement (60) à travers les une ou plusieurs transparentes ou les un ou plusieurs trous.

20. Dispositif selon la revendication 18 ou 19,
**caractérisé en ce**
**que** le récepteur d'étiquette (20), le récepteur de support (30) et l'unité de distribution de colle (40) présentent entre eux une distance maximale de 2 m.
